# EUROPEAN PATENT SPECIFICATION

(11) **EP 3 125 274 B1**
(45) Date of publication and mention of the grant of the patent: **12.09.2018**
(21) Application number: 15769513.1
(22) Date of filing: 18.03.2015
(51) Int. Cl.: G03F 7/42, H01L 21/027, G03F 7/023, G03F 7/075, H01L 21/304, H01L 21/306, G03F 7/40

(54) **METHOD FOR MANUFACTURING SEMICONDUCTOR DEVICE**
VERFAHREN ZUR HERSTELLUNG EINES HALBLEITERBAUELEMENTS
PROCÉDÉ DE FABRICATION DE DISPOSITIF À SEMI-CONDUCTEUR

(30) Priority: 26.03.2014 JP 2014063390; 26.03.2014 JP 2014063391
(43) Date of publication of application: 01.02.2017
(73) Proprietor: Toray Industries, Inc., Tokyo 103-8666 (JP)
(72) Inventor: TANIGAKI, Yugo, Otsu-shi Shiga 520-8558 (JP); FUJIWARA, Takenori, Otsu-shi Shiga 520-8558 (JP)
(74) Representative: Hoefer & Partner Patentanwälte mbB
(86) International application number: PCT/JP2015/058089
(87) International publication number: WO 2015/146749

(56) References cited:
- WO-A1-2013/099785
- WO-A1-2013/099785
- JP-A- S61 216 429
- JP-A- 2006 041 166
- JP-A- 2008 107 529
- US-A- 3 928 082
- US-A1- 2004 072 431
- US-A1- 2005 287 811
- US-B1- 6 670 276

## Description

### TECHNICAL FIELD

The present invention relates to a method for manufacturing a semiconductor device. The invention relates more specifically to a method for removing a resist or cured film used preferably in a process for manufacturing a semiconductor device, and a method for manufacturing a semiconductor device using this method.

### BACKGROUND ART

In a process for manufacturing a semiconductor device, a resist, such as a photoresist, is generally used to form an ion impurity region in a semiconductor substrate. For example, a resist film formed on a semiconductor substrate is irradiated with an active chemical ray through a mask or rectile having a desired pattern, and then the resultant workpiece is developed with a developer, and heated to be cured (hereinafter, referred to as "thermal curing) . In this manner, a cured pattern of the resist film is formed. The formed cured pattern is used as an ion implantation mask or ion doping mask to ionize, from a compound containing an element which constitutes an ion impurity region, this element to be caused to collide with the semiconductor substrate (hereinafter, referred to as "ion implantation"), or to expose to the semiconductor substrate a compound containing an element which constitutes an ion impurity region (hereinafter, referred to as "ion doping") . In this manner, the ion impurity region is formed with a desired pattern.

When the ion impurity region is formed in the semiconductor substrate, the resist film may be denatured by reaction of the resist film with a liquid or gas used in the ion doping, or by the ion implantation or the ion doping to the resist film. Furthermore, in accordance with the composition of the resist film, an organic substance in the resist film may be denatured to produce a slightly soluble compound. Such denaturation of the resist film in the formation of the ion impurity region deteriorates the solubility of the resist film into a resist peeling liquid to produce a cause for residuals after the resist film is removed. Accordingly, there has been desired a method for removing a resist film or cured film denatured in the formation of an ion impurity region without leaving any residual.

Examples of a method for removing a thermally cured resist film or cured film, or a resist film or cured film denatured in the formation of an ion impurity region include a method of removing a cured film of a photosensitive polysiloxane with, for example, hydrofluoric acid after implanting ions into the film (see, for example, Patent Document 1) ; a method of heating a cured film of a novolak type positive photoresist at 200 to 260°C for about 1 minute after implanting ions into the film, and then ion-etching this film to be removed (see, for example, Patent Document 2) ; and a method of subjecting a cured film of polysiloxane that is formed by heating at 350°C for 60 minutes to treatment with hydrofluoric acid and treatment with another chemical liquid, so as to be removed (see, for example, Patent Document 3). About polysiloxanes, a non-photosensitive polysiloxane is heated at 200 to 700°C for 1 to 60 minutes to convert the polysiloxane to SiO₂ (silicon dioxide) (see, for example, Patent Document 4).

### PRIOR ART DOCUMENT

### PATENT DOCUMENTS

Patent Document 1: WO 2013/99785
Patent Document 2: JP S61-216429 A
Patent Document 3: JP H08-250400 A
Patent Document 4: JP 2000-119595 A

### SUMMARY OF THE INVENTION

### PROBLEMS TO BE SOLVED BY THE INVENTION

However, according to conventionally known methods, a cured film of a composition containing a polysiloxane cannot be frequently removed with ease in some cases.

Thus, an object of the present invention is to provide a method making it possible that, after an ion impurity region is formed in a semiconductor substrate, a cured film of a polysiloxane-containing composition is easily removed without leaving any residual; and a method for manufacturing a semiconductor device using this method.

### SOLUTIONS TO THE PROBLEMS

The present invention is a method for manufacturing a semiconductor device, the method comprising a step of yielding a pattern of a polysiloxane-containing composition over a substrate; and a step of forming an ion impurity region in the substrate, wherein, after the step of forming an ion impurity region, the method further comprises a step of firing the pattern at a temperature of 300 to 1,500°C and wherein after the step of firing the pattern, the method further comprises a step of removing the pattern.

### EFFECTS OF THE INVENTION

The method for manufacturing a semiconductor device of the present invention makes it possible that, after an ion impurity region is formed in a semiconductor substrate, a cured film of a polysiloxane-containing composition is easily removed without leaving any residual. Consequently, in the manufacture of semiconductor devices, the yield is improved, and further the tact time can be shortened.

### BRIEF DESCRIPTION OF THE DRAWINGS

Fig. 1 shows a process chart illustrating an ion implantation process in the case of using a pattern of a polysiloxane-containing composition as an ion implantation mask.
Fig. 2 shows a schematic view of an etching process and an ion implantation process in the present invention.
Fig. 3 shows Raman spectra of a pattern of a polysiloxane-containing composition before and after ion implantation.
Fig. 4 shows infrared ray spectroscopic (IR) spectra of a pattern of a polysiloxane-containing composition before and after firing of the pattern.
Fig. 5 is an observed image of a line-and-space pattern in which the dimension width of lines is 2 µm, the pattern having been obtained from a polysiloxane-containing composition 1.

### MODE FOR CARRYING OUT THE INVENTION

The method for manufacturing a semiconductor device of the present invention includes a step of yielding a pattern of a polysiloxane-containing composition over a substrate and a step of forming an ion impurity region in the substrate; and this method further includes, after the step of forming the ion impurity region, a step of firing the pattern at a temperature of 300 to 1,400°C.

### <Polysiloxane-containing Composition>

The method for manufacturing a semiconductor device of the present invention includes the step of yielding a pattern of a polysiloxane-containing composition over a substrate. The use of this polysiloxane-containing composition improves a cured film obtained from this composition in heat resistance and chemical resistance. Thus, this method is preferred for, for example, a case where a pattern of the composition or a cured product thereof is used as a resist.

The polysiloxane-containing composition may contain other resin, or a precursor thereof. Examples of the resin or the precursor include polyimide, acrylic resin, epoxy resin, novolak resin, urea resin, polyamic acid, polyamideimide, polyamide, polybenzoxazole, and polyurethane; and respective precursors of these resins.

In general, the use of the polysiloxane-containing composition makes an improvement of a cured film of the composition in film density and adhesiveness onto a substrate as an underlying member. Thus, a chemical liquid may be hindered from penetrating the cured film, so that the removal of the cured film may become difficult, or after the removal of the cured film, residuals may be generated.

The method for manufacturing a semiconductor device of the present invention makes it possible to remove the cured film of the polysiloxane-containing composition easily without leaving any residual.

### (Polysiloxane)

A polysiloxane is a thermosetting resin. When this resin is thermally cured at a high temperature to be subjected to dehydration condensation, siloxane bonds (Si-O), which are high in heat resistance, are formed. Accordingly, when a composition contains a polysiloxane, a cured film obtained by the composition is improved in heat resistance and cracking resistance. A polysiloxane is therefore preferred for a case where a cured film is used as a mask for ion implantation or a mask for ion doping, and other cases.

The polysiloxane is preferably a polysiloxane containing an organosilane unit represented by the following general formula (1), (2) or (3):

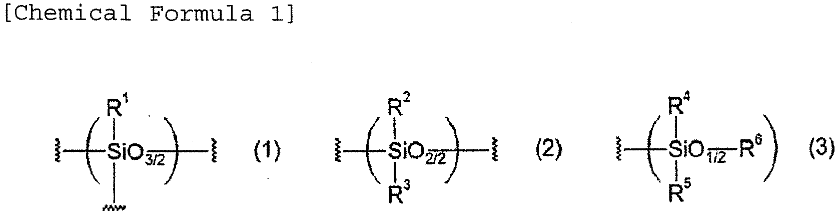

In the general formula (1), R¹ each independently represents hydrogen, or an alkyl, cycloalkyl, alkenyl or aryl group; in the general formula (2), R² and R³ each independently represent hydrogen, or an alkyl, cycloalkyl, alkenyl or aryl group; and in the general formula (3), R⁴ to R⁶ each independently represent hydrogen, or an alkyl, cycloalkyl, alkenyl or aryl group.

In the general formulae (1), (2) and (3), R¹ to R⁶ are each independently preferably hydrogen, or an alkyl group having 1 to 10 carbon atoms, a cycloalkyl group having 4 to 10 carbon atoms, an alkenyl group having 2 to 10 carbon atoms or an aryl group having 6 to 15 carbon atoms, more preferably hydrogen, or an alkyl group having 1 to 6 carbon atoms, a cycloalkyl group having 4 to 7 carbon atoms, an alkenyl group having 2 to 8 carbon atoms or an aryl group having 6 to 10 carbon atoms.

The above-mentioned alky, cycloalkyl, alkenyl and aryl groups may each be either an unsubstituted group or a substituted group.

Examples of the alkyl group as each of R¹ to R⁶ in the general formulae (1), (2) and (3) include methyl, ethyl, n-propyl, isopropyl, n-butyl, t-butyl, n-hexyl, and n-decyl groups. Examples of a substituent of the alkyl group include halogen; epoxy, glycidyl, oxetanyl, carboxyl, amino, mercapto, and isocyanate groups; and succinic anhydrate residues. When the alkyl group is a substituted group, examples of R¹ to R⁶ include trifluoromethyl, 3,3,3-trifluoropropyl, 3-glycidoxypropyl, 2-(3,4-epoxycyclohexyl)ethyl, 3-[(3-ethyl-3-oxetanyl)methoxy]propyl, 1-carboxy-2-carboxypentyl, 3-aminopropyl, 3-mercaptopropyl, and 3-isocyanatopropyl groups; and a group having the following structure.

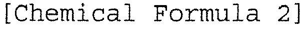

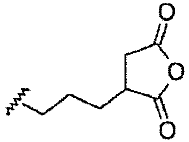

Examples of the cycloalkyl group as each of R¹ to R⁶ in the general formulae (1), (2) and (3) include cyclopentyl and cyclohexyl groups. Examples of a substituent of these group include halogen; epoxy, glycidyl, oxetanyl, carboxyl, amino, mercapto, and isocyanate groups; and succinic anhydrate residues.

Examples of the alkenyl group as each of R¹ to R⁶ in the general formulae (1), (2) and (3) and a substituted group of this group include vinyl, allyl, 3-(meth)acryloxypropyl, and 2-(meth)acryloxyethyl groups.

Examples of the aryl group as each of R¹ to R⁶ in the general formulae (1), (2) and (3) and a substituted group of this group include phenyl, 4-tolyl, 4-hydroxyphenyl, 4-methoxyphenyl, 4-t-butylphenyl, 1-naphthyl, 2-naphthyl, 4-styryl, 2-phenylethyl, 1-(4-hydroxyphenyl)ethyl, 2-(4-hydroxyphenyl)ethyl, and 4-hydroxy-5-(4-hydroxyphenylcarbonyloxy)pentyl groups.

When the organosilane unit represented by the general formula (1) is contained in the polysiloxane, the cured film can be improved in hardness without being damaged in heat resistance and transparency.

When the organosilane unit represented by the general formula (2) is contained in the polysiloxane, the cured film obtained from the polysiloxane-containing composition can be improved in cracking resistance at the thermal curing time and the ion implantation time.

When the organosilane unit represented by the general formula (3) is contained in the polysiloxane, the cured film obtained from the polysiloxane-containing composition can be improved in cracking resistance at the thermal curing time and the ion implantation time.

Examples of the organosilane having the organosilane unit represented by the general formula (1) include trifunctional silanes such as methyltrimethoxysilane, methyltriethoxysilane, methyltri-n-propoxysilane, methyltriisopropoxysilane, methyltri-n-butoxysilane, ethyltrimethoxysilane, ethyltriethoxysilane, ethyltri-n-propoxysilane, ethyltriisopropoxysilane, ethyltri-n-butoxysilane, n-propyltrimethoxysilane, n-propyltriethoxysilane, isopropyltrimethoxysilane, isopropyltriethoxysilane, n-butyltrimethoxysilane, n-butyltriethoxysilane, n-hexyltrimethoxysilane, n-hexyltriethoxysilane, n-octyltrimethoxysilane, n-decyltrimethoxysilane, cyclopentyltrimethoxysilane, cyclohexyltrimethoxysilane, vinyltrimethoxysilane, vinyltriethoxysilane, 3-methacryloxypropyltrimethoxysilane, 3-methacryloxypropyltriethoxysilane, 3-acryloxypropyltrimethoxysilane, 3-acryloxypropyltriethoxysilane, phenyltrimethoxysilane, phenyltriethoxysilane, 4-tolyltrimethoxysilane, 4-hydroxyphenyltrimethoxysilane, 4-methoxyphenyltrimethoxysilane, 4-t-butylphenyltrimethoxysilane, 1-naphthyltrimethoxysilane, 2-naphthyltrimethoxysilane, 4-stylyltrimethoxysilane, 2-phenylethyltrimethoxysilane, 4-hydroxybenzyltrimethoxysilane, 1-(4-hydroxyphenyl)ethyltrimethoxysilane, 2-(4-hydroxyphenyl)ethyltrimethoxysilane, 4-hydroxy-5-(4-hydroxyphenylcarbonyloxy)pentyltrimethoxysil ane, 3-glycidoxypropyltrimethoxysilane, 3-glycidoxypropyltriethoxysilane, 2-(3,4-epoxycyclohexyl)ethyltrimethoxysilane, 2-(3,4-epoxycyclohexyl)ethyltriethoxysilane, 2-(3-trimethoxysilylpropyl)-4-(N-t-butyl)amino-4-oxobutanoi c acid, 2-(3-triethoxysilylpropyl)-4-(N-t-butyl)amino-4-oxobutanoic acid, 3-(3-trimethoxysilylpropyl)-4-(N-t-butyl)amino-4-oxobutanoi c acid, 3-(3-triethoxysilylpropyl)-4-(N-t-butyl)amino-4-oxobutanoic acid, 3-trimethoxysilylpropylsuccinic acid, 3-triethoxysilylpropylsuccinic acid, 3-trimethoxysilylpropionic acid, 3-triethoxysilylpropionic acid, 4-trimethoxysilylbutyric acid, 4-triethoxysilylbutyric acid, 5-trimethoxysilylvaleric acid, 5-triethoxysilylvaleric acid, 3-trimethoxysilylpropylsuccinic acid anhydride, 3-triethoxysilylpropylsuccinic acid anhydride, 4-(3-trimethoxysilylpropyl)cyclohexane-1,2-dicarboxylic acid anhydride, 4-(3-triethoxysilylpropyl)cyclohexane-1,2-dicarboxylic acid anhydride, 4-(3-trimethoxysilylpropyl)phthalic acid anhydride, 4-(3-triethoxysilylpropyl)phthalic acid anhydride, trifluoromethyltrimethoxysilane, trifluoromethyltriethoxysilane, 3,3,3-trifluoropropyltrimethoxysilane, 3- [(3-ethyl-3-oxetanyl)methoxy]propyltrimethoxysilane, 3-[(3-ethyl-3-oxetanyl)methoxy]propyltriethoxysilane, 3-aminopropyltrimethoxysilane, 3-aminopropyltriethoxysilane, N-(2-aminoethyl)-3-aminopropyltrimethoxysilane, N-(2-aminoethyl)-3-aminopropyltriethoxysilane, N-phenyl-3-aminopropyltrimethoxysilane, N-(vinylbenzyl)-2-aminoethyl-3-aminopropyltrimethoxysilane hydrochloride, 3-(4-aminophenyl)propyltrimethoxysilane, 1-[4-(3-trimethoxysilylpropyl)phenyl]urea, 1-(3-trimethoxysilylpropyl)urea, 1-(3-triethoxysilylpropyl)urea, 3-trimethoxysilyl-N-(1,3-dimethylbutylidene)propylamine, 3-triethoxysilyl-N-(1,3-dimethylbutylidene)propylamine, 3-mercaptopropyltrimethoxysilane, 3-mercaptotriethoxysilane, 3-isocyanatepropyltrimethoxysilane, 3-isocyanatetriethoxysilane, 1,3,5-tris(3-trimethoxysilylpropyl)isocyanuric acid, 1,3,5-tris(3-triethoxysilylpropyl)isocyanuric acid, N-t-butyl-2-(3-trimethoxysilylpropyl)succinimide, and N-t-butyl-2-(3-triethoxysilylpropyl)succinimide.

Examples of the organosilane having the organosilane unit represented by the general formula (2) include bifunctional silanes such as dimethyldimethoxysilane, dimethyldiethoxysilane, dimethyldiacetoxysilane, diethyldimethoxysilane, diethyldiethoxysilane, di-n-propyldimethoxysilane, di-n-propyldiethoxysilane, diisopropyldimethoxysilane, diisopropyldiethoxysilane, di-n-butyldimethoxysilane, diisobutyldimethoxysilane, dicyclopentyldimethoxysilane, cyclohexylmethyldimethoxysilane, methylvinyldimethoxysilane, divinyldiethoxysilane, 3-methacryloxypropylmethyldimethoxysilane, 3-methacryloxypropylmethyldiethoxysilane, 3-acryloxypropylmethyldimethoxysilane, 3-acryloxypropylmethyldiethoxysilane, diphenyldimethoxysilane, diphenyldiethoxysilane, 3-glycidoxypropylmethyldimethoxysilane, 3-glycidoxypropylmethyldiethoxysilane, N-(2-aminoethyl)-3-aminopropylmethyldimethoxysilane, 3-mercaptopropyl methyldimethoxysilane, and 3-isocyanatepropyl methyldiethoxysilane; and bifunctional silane oligomers such as 1,1,3,3-teteramethyl-1,3-dimethoxydisiloxane, 1,1,3,3-teteramethyl-1,3-diethoxydisiloxane, 1,1,3,3-tetraethyl-1,3-dimethoxydisiloxane, 1,1,3,3-tetraethyl-1,3-diethoxydisiloxane, DMS-S12, DMS-S15, PDS-1615, and PDS-9931 (all manufactured by Gelest) . From the viewpoint of an improvement in crack resistance of the cured film obtained from the photosensitive resin composition of the present invention at the thermal curing time and the ion implantation time, preferred is dimethyldimethoxysilane, dimethyldiethoxysilane, dimethyldiacetoxysilane, diethyldimethoxysilane, diethyldiethoxysilane, di-n-propyldimethoxysilane, di-n-propyldiethoxysilane, diisopropyldimethoxysilane, diisopropyldiethoxysilane, di-n-butyldimethoxysilane, diisobutyldimethoxysilane, diphenyldimethoxysilane, diphenyldiethoxysilane, 1,1,3,3-teteramethyl-1,3-dimethoxydisiloxane, 1,1,3,3-teteramethyl-1,3-diethoxydisiloxane, 1,1,3,3-tetraethyl-1,3-dimethoxydisiloxane, or 1,1,3,3-tetraethyl-1,3-diethoxydisiloxane.

Examples of the organosilane having the organosilane unit represented by the general formula (3) include monofunctional silanes such as trimethylmethoxysilane, trimethylethoxysilane, triethylmethoxysilane, triethylethoxysilane, tri-n-propyltrimethoxysilane, tri-n-propyltriethoxysilane, tri-n-butyltrimethoxysilane, tri-n-butyltriethoxysilane, (3-glycidoxypropyl)dimethylmethoxysilane, (3-glycidoxypropyl)dimethylethoxysilane, 3-dimethylmethoxysilylpropionic acid, 3-dimethylethoxysilylpropionic acid, 4-dimethylmethoxysilylbutyric acid, 4-dimethylethoxysilylbutyric acid, 5-dimethylmethoxysilylvaleric acid, 5-dimethylethoxysilylvaleric acid, 3-dimethylmethoxysilylpropylsuccinic acid anhydride, 3-dimethylethoxysilylpropylsuccinic acid anhydride, 4-(3-dimethylmethoxysilylpropyl)cyclohexane-1,2-dicarboxyli c acid anhydride, 4-(3-dimethylethoxysilylpropyl)cyclohexane-1,2-dicarboxylic acid anhydride, 4-(3-dimethylmethoxysilylpropyl)phthalic acid anhydride, and 4-(3-dimethylethoxysilylpropyl)phthalic acid anhydride.

The content by percentage of the organosilane unit represented by the general formula (1) in the polysiloxane is preferably from 40 to 100 mol%, more preferably from 50 to 100 mol%, even more preferably from 60 to 100 mol% in terms of the content by mole of Si atoms. When the content by percentage is in the ranges, the cured film is improved in hardness.

The content by percentage of the organosilane unit represented by the general formula (2) in the polysiloxane is preferably from 0 to 75 mol%, more preferably from 0 to 60 mol%, even more preferably from 0 to 40 mol% in terms of the content by mole of Si atoms. When the content by percentage is in the ranges, the resolution is improved after thermal curing.

The content by percentage of the organosilane unit represented by the general formula (3) in the polysiloxane is preferably from 0 to 10 mol%, more preferably from 0 to 5 mol% in terms of the content by mole of Si atoms. When the content by percentage is in the ranges, the leveling property upon application becomes good, a pattern shape after the development becomes good.

The total content by percentage of the organosilane unit represented by the general formula (1), (2) or (3) in the polysiloxane is preferably from 60 to 100 mol%, more preferably from 70 to 100 mol%, even more preferably from 80 to 100 mol% in terms of the content by mole of Si atoms. When the content by percentage is the ranges, the cured film obtained from the polysiloxane-containing composition is improved in cracking resistance at the thermal curing time and the ion implantation time.

The polysiloxane may be a polysiloxane further containing an organosilane unit represented by the following general formula (4).

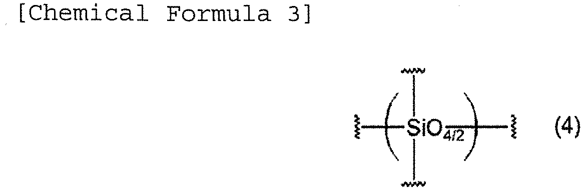

When the organosilane unit represented by the general formula (4) is contained in the polysiloxane-containing composition, the generation of residuals can be restrained after the development and the resolution can be improved after the development without damaging the heat resistance nor transparency of the cured film obtained from the polysiloxane-containing composition.

Examples of the organosilane having the organosilane unit represented by the general formula (4) include tetrafunctional silanes such as tetramethoxysilane, tetraethoxysilane, tetra-n-propoxysilane, tetraisopropoxysilane, tetra-n-butoxysilane and tetramethoxysilane; and silicate compounds such as METHYL SILICATE 51 (manufactured by Fuso Chemical Co., Ltd.), M SILICATE 51, SILICATE 40 and SILICATE 45 (all manufactured by Tama Chemicals Co., Ltd.), and METHYL SILICATE 51, METHYL SILICATE 53A, ETHYL SILICATE 40 and ETHYL SILICATE 48 (all manufactured by Colcoat Co., Ltd.) . From the viewpoint of an improvement in the resolution after the development and the restraint of the generation of residuals after the development, preferred is tetramethoxysilane, tetraethoxysilane, tetra-n-propoxysilane, METHYL SILICATE 51 (manufactured by Fuso Chemical Co., Ltd.), M SILICATE 51 (manufactured by Tama Chemicals Co., Ltd.) or METHYL SILICATE 51 (manufactured by Colcoat Co., Ltd.).

The content by percentage of the organosilane unit represented by the general formula (4) in the polysiloxane is preferably from 0 to 40 mol%, more preferably from 0 to 30 mol%, even more preferably from 0 to 20 mol% in terms of the content by mole of Si atoms. When the content by percentage is in the ranges, the cured film obtained from the polysiloxane-containing composition is improved in cracking resistance at the thermal curing time and the ion implantation time.

In the polysiloxane, the organosilane units represented by the general formulae (1), (2), (3) and (4) may be either a regular sequence or an irregular sequence. Examples of the regular sequence include alternating copolymerization, periodic copolymerization, block copolymerization, and graft copolymerization. Examples of the irregular sequence include random copolymerization.

In the polysiloxane, the organosilane units represented by the general formulae (1), (2), (3) and (4) may be either a two-dimensional sequence or a three-dimensional sequence. An example of the two-dimensional sequence includes a linear form. Examples of the three-dimensional sequence include a ladder form, a hamper form and a network form.

In order to restrain the crystal structure of the substrate from being damaged at the ion implantation time, it may be necessary to perform the ion implantation while the substrate is heated. Furthermore, at the ion implantation time, ions accelerated by a high energy collide with the substrate, so that extra heat may be generated by the energy of the collision. If the cracking resistance of the cured film is insufficient at the ion implantation time, the cured film may be cracked at at the ion implantation time. The generation of a crack in the cured film at the ion implantation time causes broken pieces of the cured film to be scattered inside an ion implantation apparatus, so that the apparatus is contaminated by particles, and additionally the particles may unfavorably adhere onto another wafer that has passed through the contaminated apparatus. Thus, in connection with the polysiloxane-containing composition, which is used as an ion implantation mask resist, it is preferred that the cured film obtained from this composition has cracking resistance at the ion implantation time. In order to obstruct ions accelerated by a higher energy at the ion implantation time, it is preferred that the cured film has a larger thickness to show cracking resistance at the ion implantation time.

The polysiloxane preferably contains an organosilane unit having an aromatic group. Such a polysiloxane is preferably a polysiloxane obtained using an organosilane having an aromatic group as the organosilane having the organosilane unit represented by the general formula (1), (2), (3) or (4) . When the polysiloxane has the organosilane unit having an aromatic group, the pattern shape after the development is made good by the steric hindrance and hydrophobicity of the aromatic group, so that the cured film obtained from the polysiloxane-containing composition can be improved in cracking resistance at the thermal curing time and the ion implantation time.

Examples of the organosilane having the organosilane unit which is represented by the general formula (1), (2), (3) or (4) and has an aromatic group include trifunctional silanes such as phenyltrimethoxysilane, phenyltriethoxysilane, 4-tolyltrimethoxysilane, 4-hydroxyphenyltrimethoxysilane, 4-methoxyphenyltrimethoxysilane, 4-t-butylphenyltrimethoxysilane, 1-naphthyltrimethoxysilane, 2-naphthyltrimethoxysilane, 4-styryltrimethoxysilane, 2-phenylethyltrimethoxysilane, 4-hydroxybenzyltrimethoxysilane, 1-(4-hydroxyphenyl)ethyltrimethoxysilane, 2-(4-hydroxyphenyl)ethyltrimethoxysilane, and 4-hydroxy-5-(4-hydroxyphenylcarbonyloxy)pentyltrimethoxysil ane; and bifunctional silanes such as diphenyldimethoxysilane, and diphenyldiethoxysilane. From the viewpoints of making the pattern shape after the development good and improving the cracking resistance of the cured film obtained from the polysiloxane-containing composition at the thermal curing time and the ion implantation time, preferred is phenyltrimethoxysilane, 4-tolyltrimethoxysilane, 4-hydroxyphenyltrimethoxysilane, 4-methoxyphenyltrimethoxysilane, 1-naphthyltrimethoxysilane, 2-naphthyltrimethoxysilane, 4-styryltrimethoxysilane, 2-phenylethyltrimethoxysilane, 4-hydroxybenzyltrimethoxysilane, diphenyldimethoxysilane, or diphenyldiethoxysilane. More preferred is phenyltrimethoxysilane, 1-naphthyltrimethoxysilane, 2-naphthyltrimethoxysilane, diphenyldimethoxysilane, or diphenyldiethoxysilane.

The content by percentage of the organosilane unit which is represented by the general formula (1), (2), (3) or (4) and has an aromatic group in the polysiloxane is preferably from 5 to 80 mol%, more preferably from 10 to 70 mol%, even more preferably from 15 to 70 mol% in terms of the content by mole of Si atoms. When the content by percentage is in the ranges, the pattern processability with an alkaline developer in improved and further the cracking resistance of the cured film obtained from the polysiloxane-containing composition can be improved at the thermal curing time and the ion implantation time.

When positive photosensitivity is given to the polysiloxane-containing composition, the organosilane having the organosilane unit represented by the general formula (1), (2), (3) or (4) is in particular preferably an organosilane having an aromatic group. When the polysiloxane has an organosilane unit having an aromatic group, the compatibility with a compound having a naphthoquinonediazide structure that will be later described can be improved, so that a uniform cured film can be formed without undergoing phase separation nor being damaged in transparency.

When positive photosensitivity is given to the polysiloxane-containing composition, the organosilane having the organosilane unit represented by the general formula (1), (2), (3) or (4) may be an organosilane having an epoxy group and/or vinyl group. When the polysiloxane has an organosilane unit having an epoxy group and/or vinyl group, the cured film can be improved in adhesiveness.

Examples of the organosilane having the organosilane unit which is represented by the general formula (1), (2), (3) or (4) and has an epoxy group and/or vinyl group include trifunctional silanes such as 3-glycidoxypropyltrimethoxysilane, 3-glycidoxypropyltriethoxysilane, 2-(3,4-epoxycyclohexyl)ethyltrimethoxysilane, 2-(3,4-epoxycyclohexyl)ethyltriethoxysilane, vinyltrimethoxysilane and vinyltriethoxysilane; bifunctional silanes such as (3-glycidoxypropyl)methyldimethoxysilane, (3-glycidoxypropyl)methyldiethoxysilane, methylvinyldimethoxysilane, and divinyldiethoxysilane; and monofunctional silanes such as (3-glycidoxypropyl)dimethylmethoxysilane, and (3-glycidoxypropyl)dimethylethoxysilane. From the viewpoint of an improvement of the cured film in adhesiveness, preferred is 3-glycidoxypropyltrimethoxysilane, 3-glycidoxypropyltriethoxysilane, 2-(3,4-epoxycyclohexyl)ethyltrimethoxysilane, 2-(3,4-epoxycyclohexyl)ethyltriethoxysilane, vinyltrimethoxysilane, or vinyltriethoxysilane.

The content by percentage of the organosilane unit which is represented by the general formula (1), (2), (3) or (4) and has an epoxy group and/or vinyl group in the polysiloxane is preferably from 1 to 70 mol%, more preferably from 3 to 60 mol%, even more preferably from 5 to 50 mol%, in particular preferably from 10 to 50 mol% in terms of the content by mole of Si atoms. When the content by percentage is in the ranges, the cured film can be improved in adhesiveness.

When negative photosensitivity is given to the polysiloxane-containing composition, the organosilane having the organosilane unit represented by the general formula (1), (2), (3) or (4) may be an organosilane having an ethylenically unsaturated double bond group. When the polysiloxane has an organosilane unit having an ethylenically unsaturated double bond group, the UV curing is promoted at light-exposure time, so that the sensitivity can be improved. Additionally, the crosslinkage density after the thermal curing is improved, so that the cured film can be improved in hardness. The wording "light-exposure" herein denotes irradiation with an active chemical ray (radial ray). An example thereof includes irradiation with visible rays, ultraviolet rays, an electron beam, or an X-ray. For example, an ultrahigh pressure mercury lamp light source is preferred which can irradiate visible rays or ultraviolet rays, since this light source is an ordinarily used light source. More preferred is irradiation with a j-line (wavelength: 313 nm), an i-line (wavelength: 365 nm), an h-line (wavelength: 405 nm), or a g-line (wavelength: 436 nm). Hereinafter, the light-exposure denotes irradiation with an active chemical ray (radial ray).

Examples of the organosilane having the organosilane unit which is represented by the general formula (1), (2), (3) or (4) and has an ethylenically unsaturated double bond group include trifunctional silanes such as vinyltrimethoxysilane, vinyltriethoxysilane, 3-methacryloxypropyltrimethoxysilane, 3-methacryloxypropyltriethoxysilane, 3-methacryloxypropylmethyldimethoxysilane, 3-methacryloxypropylmethyldiethoxysilane, 3-acryloxypropyltrimethoxysilane, 3-acryloxypropyltriethoxysilane, 3-acryloxypropylmethyldimethoxysilane, 3-acryloxypropylmethyldiethoxysilane, and 4-styryltrimethoxysilane; and bifunctional silanes such as methylvinyldimethoxysilane, and divinyldiethoxysilane. From the viewpoint of respective improvements in sensitivity at the light-exposure time and in hardness of the cured film, preferred is vinyltrimethoxysilane, 3-methacryloxypropyltrimethoxysilane, 3-methacryloxypropylmethyldimethoxysilane, 3-acryloxypropyltrimethoxysilane, 3-acryloxypropylmethyldiethoxysilane, or 4-styryltrimethoxysilane.

When negative photosensitivity is given to the polysiloxane-containing composition and the organosilane having an ethylenically unsaturated double bond group is used as the organosilane having the organosilane organosilane unit represented by the general formula (1), (2), (3) or (4), the double bond equivalent of the polysiloxane is preferably from 150 to 10,000 g/mole, more preferably from 200 to 5,000 g/mole, even more preferably from 250 to 2,000 g/mole. The double bond equivalent herein denotes the weight of the resin per mole of its ethylenically unsaturated double bond groups. The unit thereof is g/mole . The double bond equivalent can be calculated by measuring the iodine value . When the double bond equivalent is in the above-mentioned range, the sensitivity at the light-exposure time and the hardness of the cured film can be improved.

The organosilane having the organosilane unit represented by the general formula (1), (2), (3) or (4) is also preferably an organosilane having an acidic group. When the polysiloxane has an acidic group originating from an organosilane silane unit, the generation of residuals can be restrained after the development, and the resolution can be improved after the development. The acidic group is preferably a group showing an acidity of pH less than 6. Examples of the group having an acidity of pH less than 6 include carboxy, carboxylic anhydride, sulfonate, phenolic hydroxyl, hydroxyimide, and silanol groups. From the viewpoint of respective improvements in pattern processability with an alkaline developer and in resolution after the development, a carboxy or carboxylic anhydride group is preferred.

Examples of the organosilane having the organosilane unit which is represented by the general formula (1), (2), (3) or (4) and has an acidic group include trifunctional silanes such as 2-(3-trimethoxysilylpropyl)-4-(N-t-butyl)amino-4-oxobutanoi c acid, 2-(3-triethoxysilylpropyl)-4-(N-t-butyl)amino-4-oxobutanoic acid, 3-(3-trimethoxysilylpropyl)-4-(N-t-butyl)amino-4-oxobutanoi c acid, 3-(3-triethoxysilylpropyl)-4-(N-t-butyl)amino-4-oxobutanoic acid, 3-trimethoxysilylpropylsuccinic acid, 3-triethoxysilylpropylsuccinic acid, 3-trimethoxysilylpropionic acid, 3-triethoxysilylpropionic acid, 4-trimethoxysilylbutyric acid, 4-triethoxysilylbutyric acid, 5-trimethoxysilylvaleric acid, 5-triethoxysilylvaleric acid, 3-trimethoxysilylpropylsuccinic acid anhydride, 3-triethoxysilylpropylsuccinic acid anhydride, 4-(3-trimethoxysilylpropyl)cyclohexane-1,2-dicarboxylic acid anhydride, 4-(3-triethoxysilylpropyl)cyclohexane-1,2-dicarboxylic acid anhydride, 4-(3-trimethoxysilylpropyl)phthalic acid anhydride, 4-(3-triethoxysilylpropyl)phthalic acid anhydride, 3-mercaptopropyltrimethoxysilane, 4-hydroxyphenyltrimethoxysilane, 4-methoxyphenyltrimethoxysilane, 4-hydroxybenzyltrimethoxysilane, 1-(4-hydroxyphenyl)ethyltrimethoxysilane, 2-(4-hydroxyphenyl)ethyltrimethoxysilane, and 4-hydroxy-5-(4-hydroxyphenylcarbonyloxy)pentyltrimethoxysil ane; and monofunctional silanes such as 3-dimethylmethoxysilylpropionic acid, 3-dimethylethoxysilylpropionic acid, 4-dimethylmethoxysilylbutyric acid, 4-dimethylethoxysilylbutyric acid, 5-dimethylmethoxysilylvaleric acid, 5-dimethylethoxysilylvaleric acid, 3-dimethylmethoxysilylpropylsuccinic acid anhydride, 3-dimethylethoxysilylpropylsuccinic acid anhydride, 4-(3-dimethylmethoxysilylpropyl)cyclohexane-1,2-dicarboxyli c acid anhydride, 4-(3-dimethylethoxysilylpropyl)cyclohexane-1,2-dicarboxylic acid anhydride, 4-(3-dimethylmethoxysilylpropyl)phthalic acid anhydride, and 4-(3-dimethylethoxysilylpropyl)phthalic acid anhydride.

From the viewpoint of an improvement in pattern processability with an alkaline developer, restraint of the generation of residuals after the development, and an improvement in resolution after the development, preferred is a trifunctional silane such as 2-(3-trimethoxysilylpropyl)-4-(N-t-butyl)amino-4-oxobutanoi c acid, 2-(3-triethoxysilylpropyl)-4-(N-t-butyl)amino-4-oxobutanoic acid, 3-(3-trimethoxysilylpropyl)-4-(N-t-butyl)amino-4-oxobutanoi c acid, 3-(3-triethoxysilylpropyl)-4-(N-t-butyl)amino-4-oxobutanoic acid, 3-trimethoxysilylpropylsuccinic acid, 3-triethoxysilylpropylsuccinic acid, 3-trimethoxysilylpropionic acid, 3-triethoxysilylpropionic acid, 4-trimethoxysilylbutyric acid, 4-triethoxysilylbutyric acid, 5-trimethoxysilylvaleric acid, 5-triethoxysilylvaleric acid, 3-trimethoxysilylpropylsuccinic acid anhydride, 3-triethoxysilylpropylsuccinic acid anhydride, 4-(3-trimethoxysilylpropyl)cyclohexane-1,2-dicarboxylic acid anhydride, 4-(3-triethoxysilylpropyl)cyclohexane-1,2-dicarboxylic acid anhydride, 4-(3-trimethoxysilylpropyl)phthalic acid anhydride, or 4-(3-triethoxysilylpropyl)phthalic acid anhydride; or a monofunctional silane such as 3-dimethylmethoxysilylpropionic acid, 3-dimethylethoxysilylpropionic acid, 4-dimethylmethoxysilylbutyric acid, 4-dimethylethoxysilylbutyric acid, 5-dimethylmethoxysilylvaleric acid, 5-dimethylethoxysilylvaleric acid, 3-dimethylmethoxysilylpropylsuccinic acid anhydride, 3-dimethylethoxysilylpropylsuccinic acid anhydride, 4-(3-dimethylmethoxysilylpropyl)cyclohexane-1,2-dicarboxyli c acid anhydride, 4-(3-dimethylethoxysilylpropyl)cyclohexane-1,2-dicarboxylic acid anhydride, 4-(3-dimethylmethoxysilylpropyl)phthalic acid anhydride, or 4-(3-dimethylethoxysilylpropyl)phthalic acid anhydride; and
more preferred is 2-(3-trimethoxysilylpropyl)-4-(N-t-butyl)amino-4-oxobutanoi c acid, 2-(3-triethoxysilylpropyl)-4-(N-t-butyl)amino-4-oxobutanoic acid, 3-(3-trimethoxysilylpropyl)-4-(N-t-butyl)amino-4-oxobutanoi c acid, 3-(3-triethoxysilylpropyl)-4-(N-t-butyl)amino-4-oxobutanoic acid, 3-trimethoxysilylpropylsuccinic acid, 3-triethoxysilylpropylsuccinic acid, 3-trimethoxysilylpropionic acid, 3-triethoxysilylpropionic acid, 4-trimethoxysilylbutyric acid, 4-triethoxysilylbutyric acid, 3-trimethoxysilylpropylsuccinic acid anhydride, 3-triethoxysilylpropylsuccinic acid anhydride, 4-(3-trimethoxysilylpropyl)cyclohexane-1,2-dicarboxylic acid anhydride, or 4-(3-triethoxysilylpropyl)cyclohexane-1,2-dicarboxylic acid anhydride.

When positive sensitivity is given to the polysiloxane-containing composition, the content by percentage of the organosilane unit which is represented by the general formula (1), (2), (3) or (4) and has an acidic group in the polysiloxane is preferably from 0.01 to 20 mol%, more preferably from 0.02 to 15 mol%, even more preferably from 0.03 to 10 mol% in terms of the content by mole of Si atoms. When the content is in the ranges, the generation of residuals can be restrained after the development, and the resolution can be improved after the development.

When negative photosensitivity is given to the polysiloxane-containing composition, the carboxylic acid equivalent of the polysiloxane is preferably from 280 to 1,400 g/mole, more preferably from 300 to 1,100 g/mole, even more preferably from 400 to 950 g/mole. The carboxylic acid equivalent herein denotes the weight of the resin per mole of its carboxy groups . The unit thereof is g/mole . From the value of the carboxylic acid equivalent, the number of the carboxy groups in the resin can be gained. When the carboxylic acid equivalent is in the ranges, the generation of residuals can be restrained after the development, and the resolution can be improved after the development.

The content by percentage of each of the organosilane units in the polysiloxane can be gained by a combination of ¹H-NMR, ¹³C-NMR, ²⁹Si-NMR, IR, TOF-MS, elementary analysis, ash content measurement, and others.

The weight-average molecular weight (hereinafter abbreviated to "Mw") of the polysiloxane is preferably from 500 to 100,000, more preferably from 500 to 50,000, even more preferably from 500 to 20,000 in terms of polystyrene according to measurement by gel permeation chromatography (hereinafter abbreviated to "GPC") . When the Mw is in the ranges, respective improvements can be made in the leveling property at the application time, the pattern processability with an alkaline developer, and the storage stability of the coating liquid.

A method for hydrolyzing the organosilane to be subjected to dehydration condensation is, for example, a method of adding a solvent, water, and a catalyst if necessary to a mixture containing the organosilane, and then stirring the resultant under heat at 50 to 150°C, preferably at 90 to 130°C for about 0.5 to 100 hours. During the stirring under heat, the reaction system may be optionally distilled to distill off hydrolysis byproducts (alcohols such as methanol), and a condensation byproduct (water) by the distillation.

Examples of the solvent used in the hydrolysis and dehydration condensation of the organosilane include solvents similar to the solvents that will be described later. When the total amount of the organosilane and inorganic particles caused to react with the organosilane is regarded as 100 parts by weight, the addition amount of the solvent is preferably from 10 to 1,000 parts by weight. The addition amount of water is preferably from 0.5 to 2 moles per mole of hydrolyzable groups of the organosilane.

The catalyst added if necessary is preferably an acid catalyst or a base catalyst. Examples of the acid catalyst include hydrochloric acid, nitric acid, sulfuric acid, hydrofluoric acid, phosphoric acid, acetic acid, trifluoroacetic acid, formic acid and polyvalent carboxylic acid, anhydrides of these acids, and ion exchange resin. Examples of the base catalyst include triethylamine, tri-n-propylamine, tri-n-butylamine, tri-n-pentylamine, tri-n-hexylamine, tri-n-heptylamine, tri-n-octylamine, diethylamine, triethanolamine, diethanolamine, sodium hydroxide, potassium hydroxide, alkoxysilanes having an amino group, and ion exchange resin. When the total amount of the organosilane and inorganic particles caused to react with the organosilane is regarded as 100 parts by weight, the addition amount of the catalyst is preferably from 0.01 to 10 parts by weight.

From the viewpoint of the storage stability of the polysiloxane-containing composition, it is preferred that the polysiloxane does not contain the catalyst. Thus, the catalyst may be removed after the reaction. The method for removing the catalyst is preferably washing with water or treatment with ion exchange resin from the viewpoint of easiness of the operation, and removability. The washing with water herein denotes a method of diluting the resultant polysiloxane solution with an appropriate hydrophobic solvent, washing the diluted solution with water several times, and then concentrating the resultant organic phase through, for example, an evaporator. The treatment with ion exchange resin denotes a method of bringing the resultant polysiloxane solution into contact with an appropriate ion exchange resin.

### (Inorganic Particle-Containing Polysiloxane)

The polysiloxane-containing composition may contain inorganic particles. The matter that the polysiloxane-containing composition may contain inorganic particles herein denotes a form in which the polysiloxane and the inorganic particles are separately contained in the composition, a form in which the polysiloxane is bonded to the inorganic particles, or a form including the two forms.

The polysiloxane is preferably a polysiloxane having an organosilane unit to which inorganic particles are bonded (hereinafter, referred to as "inorganic particle-containing polysiloxane"). The inorganic particle-containing polysiloxane to be used is preferably a polysiloxane obtained by hydrolyzing the organosilane having the organosilane unit represented by the general formula (1), (2), (3) or (4) in the presence of inorganic particles to be subjected to dehydration condensation. The use of the thus obtained inorganic particle-containing polysiloxane makes an improvement of the inorganic particles in alkali-solubility, so that the pattern processability with an alkaline developer can be restrained from being lowered. Moreover, the hydrophobicity of the inorganic particles not only makes an improvement of an exposed part and an unexposed part in contrast therebetween, but also makes the glass transition temperature of the polysiloxane high. Thus, at the thermal curing time, the reflow of the pattern can be restrained. Furthermore, the inorganic particles are small in shrinkage ratio at the thermal curing time, so that the generation of shrinkage stress therein can be restrained. Thus, at the thermal curing time and the ion implantation time, the cured film obtained from the polysiloxane-containing composition can be further improved in cracking resistance.

Whether or not the inorganic particles are bonded to the polysiloxane can be checked by a combination of ¹³C-NMR, ²⁹Si-NMR, IR, and others. In, for example, ²⁹Si-NMR, the spectrum of the inorganic particles, that of the polysiloxane, and that of the inorganic particle-containing polysiloxane are compared with one another. A peak originating from Si atoms bonded to the inorganic particles in the inorganic particle-containing polysiloxane is a peak having a chemical shift not present in the spectrum of the polysiloxane. Accordingly, it can be checked whether or not the inorganic particles are bonded to the polysiloxane.

Similarly, also in IR, a peak originating from the Si atoms in the inorganic particle-containing polysiloxane is a peak having a wavenumber different from that in the spectrum of the polysiloxane. Accordingly, it can be checked whether or not the inorganic particles are bonded to the polysiloxane.

This matter can be checked also by observing a boundary between the inorganic particles and the polysiloxane through a scanning electron microscope (hereinafter abbreviated to an "SEM"), or a transmission electron microscope (hereinafter abbreviated to a "TEM"). When the inorganic particles are bonded to the polysiloxane, a state that these are integrated with each other is observed and unclear is a boundary between the inorganic particles or the boundary between the inorganic particles and the polysiloxane. In the meantime, when the inorganic particles are not bonded to the polysiloxane, a state that these are not integrated with each other is observed and clear is the boundary between the inorganic particles or the boundary between the inorganic particles and the polysiloxane. Thus, particles having a size corresponding to the number-average particle diameter of the inorganic particles are clearly observed.

### (Inorganic Particles)

A description that will be made hereinafter is common to both of the inorganic particles contained separately from the polysiloxane, and the inorganic particles bonded to the polysiloxane.

The inorganic particles denote particles made of a compound of a metal or a compound of a semiconductor. The metal or the semiconductor is, for example, an element selected from the group consisting of silicon, lithium, sodium, magnesium, potassium, calcium, strontium, barium, lanthanum, tin, titanium, zirconium, niobium, and aluminum. Examples of the metal compound or the semiconductor compound are halides, oxides, nitrides, hydroxides, carbonates, sulfates, nitrates or metasilicates of the above-mentioned metals or semiconductors.

The number-average particle diameter of the inorganic particles is preferably from 1 to 200 nm, more preferably from 5 to 70 nm. When the number-average particle diameter of the inorganic particles is in the ranges, the cured film obtained from the polysiloxane-containing composition can be improved in cracking resistance at the thermal curing time and the ion implantation time without damaging the pattern processability with an alkaline liquid.

The number-average particle diameter of the inorganic particles herein can be gained by measuring laser scattering based on Brownian movement of the inorganic particles in a solution, using a submicron particle size distribution measuring instrument (N4-PLUS; manufactured by Beckman Coulter Inc.) (dynamic light scattering method). Moreover, the number-average particle diameter of the inorganic particles in the cured film obtained from the polysiloxane-containing composition can be gained by measurement using an SEM and a TEM. The number-average particle diameter of the inorganic particles is directly measured at a magnifying power of 150,000. When the inorganic particles are in the form of complete spheres, the diameter of the complete sphere is measured, and the measured value is defined as the number-average particle diameter of the particles. When the inorganic particles are not in the form of complete spheres, measurements are made to the longest diameter (hereinafter referred to as "major axis diameter"), and the longest diameter in a direction orthogonal to the major axis diameter (hereinafter referred to as "minor axis diameter"), and then the average diameter of the two axes, which is obtained by averaging the major axis diameter and the minor axis diameter, is defined as the number-average particle diameter.

Examples of the inorganic particles include silica particles, lithium fluoride particles, lithium chloride particles, lithium bromide particles, lithium oxide particles, lithium carbonate particles, lithium sulfate particles, lithium nitrate particles, lithium metasilicate particles, lithium hydroxide particles, sodium fluoride particles, sodium chloride particles, sodium bromide particles, sodium carbonate particles, sodium hydrogen carbonate particles, sodium sulfate particles, sodium nitrate particles, sodium metasilicate particles, sodium hydroxide particles, magnesium fluoride particles, magnesium chloride particles, magnesium bromide particles, magnesium oxide particles, magnesium carbonate particles, magnesium sulfate particles, magnesium nitrate particles, magnesium hydroxide particles, potassium fluoride particles, potassium chloride particles, potassium bromide particles, potassium carbonate particles, potassium sulfate particles, potassium nitrate particles, calcium fluoride particles, calcium chloride particles, calcium bromide particles, calcium oxide particles, calcium carbonate particles, calcium sulfate particles, calcium nitrate particles, calcium hydroxide particles, strontium fluoride particles, barium fluoride particles, lanthanum fluoride particles, tin oxide-titanium dioxide composite particles, silicon oxide-titanium dioxide composite particles, titanium oxide particles, zirconium oxide particles, tin oxide particles, niobium oxide particles, tin oxide-zirconium oxide composite particles, aluminum oxide particles, and barium titanate particles. From the viewpoint of compatibility with the polysiloxane, preferred is silica particles, tin oxide-titanium dioxide composite particles, silicon oxide-titanium dioxide composite particles, titanium oxide particles, zirconium oxide particles, tin oxide particles, niobium oxide particles, tin oxide-zirconium oxide composite particles, aluminum oxide particles, or barium titanate particles.

In order to cause the inorganic particles to react easily with the matrix resin, it is preferred that the inorganic particles have, on surfaces thereof, a functional group reactive with the resin, such as a hydroxyl group. When the reactivity between the inorganic particles and the matrix resin is good, the inorganic particles are incorporated into the resin at the thermal curing time to restrain the generation of shrinkage stress at the thermal curing time. Thus, the cured film obtained from the polysiloxane-containing composition can be improved in cracking resistance at the thermal curing time and the ion implantation time.

Examples of the silica particles include methanol silica sol having a number-average particle diameter (hereinafter referred to as "particle diameter") of 10 to 20 nm in which methanol (MA) is used as a dispersing medium, IPA-ST having a particle diameter of 10 to 20 nm in which isopropyl alcohol (IPA) is used as a dispersing medium, EG-ST having a particle diameter of 10 to 20 nm in which ethylene glycol (EG) is used as a dispersing medium, NPC-ST-30 having a particle diameter of 10 to 20 nm in which n-propylcellosolve (NPC) is used as a dispersing medium, DMAC-ST having a particle diameter of 10 to 20 nm in which dimethylacetoamide (DMAC) is used as a dispersing medium, MEK-ST having a particle diameter of 10 to 20 nm in which methyl ethyl ketone (MEK) is used as a dispersing medium, MIBK-ST having a particle diameter of 10 to 20 nm in which methyl isobutyl ketone (MIBK) is used as a dispersing medium, XBA-ST having a particle diameter of 10 to 20 nm in which a mixed solvent of xylene (Xy) and n-butyl alcohol (nBA) is used as a dispersing medium, PMA-ST having a particle diameter of 10 to 20 nm in which propylene glycol monomethyl ether acetate (PGMEA) is used as a dispersing medium, PGM-ST having a particle diameter of 10 to 20 nm in which propylene glycol monomethyl ether (PGME) is used as a dispersing medium, IPA-ST-L having a particle diameter of 40 to 50 nm in which IPA is used as a dispersing medium, IPA-ST-ZL having a particle diameter of 70 to 100 nm in which IPA is used as a dispersing medium; "SNOWTEX" (registered trademark) OXS having a particle diameter of 4 to 6 nm in which water is used as a dispersing solution, "SNOWTEX" (registered trademark) OS having a particle diameter of 8 to 11 nm in which water is used as a dispersing solution, "SNOWTEX" (registered trademark) O having a particle diameter of 10 to 20 nm in which water is used as a dispersing solution, "SNOWTEX" (registered trademark) O-40 having a particle diameter of 20 to 30 nm in which water is used as a dispersing solution, "SNOWTEX" (registered trademark) OL having a particle diameter of 40 to 50 nm in which water is used as a dispersing solution, "SNOWTEX" (registered trademark) XL having a particle diameter of 40 to 60 nm in which water is used as a dispersing solution, "SNOWTEX" (registered trademark) YL having a particle diameter of 50 to 80 nm in which water is used as a dispersing solution, "SNOWTEX" (registered trademark) ZL having a particle diameter of 70 to 100 nm in which water is used as a dispersing solution, "SNOWTEX" (registered trademark) MP-1040 having a particle diameter of about 100 nm in which water is used as a dispersing solution, and "SNOWTEX" (registered trademark) MP-2040 having a particle diameter of about 200 nm in which water is used as a dispersing solution (all manufactured by Nissan Chemical Industries, Ltd.); "OSCAL" (registered trademark)-1421 having a particle diameter of 5 to 10 nm in which IPA is used as a dispersing medium, "OSCAL" (registered trademark) -1432 having a particle diameter of 10 to 20 nm in which IPA is used as a dispersing medium, "OSCAL" (registered trademark)-1132 having a particle diameter of 10 to 20 nm in which MA is used as a dispersing medium, "OSCAL" (registered trademark)-1632 having a particle diameter of 10 to 20 nm in which ethylene glycol monomethyl ether (EGME) is used as a dispersing medium, "OSCAL" (registered trademark)-1842 having a particle diameter of 10 to 20 nm in which MIBK is used as a dispersing medium, "OSCAL" (registered trademark) -101 having a particle diameter of 10 to 20 nm in which γ-butyrolactone (GBL) is used as a dispersing medium, "OSCAL" (registered trademark) -1727BM having a particle diameter of 110 to 130 nm in which EG is used as a dispersing medium, "OSCAL" (registered trademark) -1727TH having a particle diameter of 150 to 170 nm in which EG is used as a dispersing medium, and "CATALOID" (registered trademark) -S having a particle diameter of 5 to 80 nm in which water is used as a dispersing solution (all manufactured by JGC Catalysts and Chemicals Ltd.); "QUOTRON" (registered trademark) PL-06L having a particle diameter of 5 to 10 nm in which water is used as a dispersing solution, "QUOTRON" (registered trademark) PL-1 having a particle diameter of 10 to 15 nm in which water is used as a dispersing solution, "QUOTRON" (registered trademark) PL-2L having a particle diameter of 15 to 20 nm in which water is used as a dispersing solution, "QUOTRON" (registered trademark) PL-3 having a particle diameter of 30 to 40 nm in which water is used as a dispersing solution, "QUOTRON" (registered trademark) PL-7 having a particle diameter of 70 to 85 nm in which water is used as a dispersing solution, "QUOTRON" (registered trademark) PL-10H having a particle diameter of 80 to 100 nm in which water is used as a dispersing solution, "QUOTRON" (registered trademark) PL-1-IPA having a particle diameter of 10 to 15 nm in which IPA is used as a dispersing medium, "QUOTRON" (registered trademark) PL-2L-IPA having a particle diameter of 15 to 20 nm in which IPA is used as a dispersing medium, "QUOTRON" (registered trademark) PL-2L-MA having a particle diameter of 15 to 20 nm in which MA is used as a dispersing medium, "QUOTRON" (registered trademark) PL-2L-PGME having a particle diameter of 15 to 20 nm in which PGME is used as a dispersing medium, "QUOTRON" (registered trademark) PL-2L-DAA having a particle diameter of 15 to 20 nm in which diacetone alcohol (DAA) is used as a dispersing medium, "QUOTRON" (registered trademark) PL-2L-BL having a particle diameter of 15 to 20 nm in which GBL is used as a dispersing medium, and "QUOTRON" (registered trademark) PL-2L-TOL having a particle diameter of 15 to 20 nm in which toluene (TOL) is used as a dispersing medium (all manufactured by Fuso Chemical Co. , Ltd.); silica (SiO₂) SG-SO100 in which the particle diameter is 100 nm (manufactured by KCM Corporation Co., Ltd.); and "RHEOLOSEAL" (registered trademark) in which the particle diameter is from 5 to 50 nm (manufactured by Takuyama Corp.). In order to improve the cracking resistance of the cured film obtained from the polysiloxane-containing composition at the thermal curing time and the ion implantation time without damaging the pattern processability with an alkaline developer, preferred is methanol silica sol, IPA-ST, EG-ST, NPC-ST-30, MEK-ST, PMA-ST, PGM-ST; "SNOWTEX" (registered trademark) OXS, "SNOWTEX" (registered trademark) OS, "SNOWTEX" (registered trademark) O, "SNOWTEX" (registered trademark) O-40 (all manufactured by Nissan Chemical Industries, Ltd.); "OSCAL" (registered trademark)-1421, "OSCAL" (registered trademark) -1432, "OSCAL" (registered trademark)-1132, "OSCAL" (registered trademark)-1632 (all manufactured by JGC Catalysts and Chemicals Ltd.); "QUOTRON" (registered trademark) PL-06L, "QUOTRON" (registered trademark) PL-1, "QUOTRON" (registered trademark) PL-2L, "QUOTRON" (registered trademark) PL-3, "QUOTRON" (registered trademark) PL-1-IPA, "QUOTRON" (registered trademark) PL-2L-IPA, "QUOTRON" (registered trademark) PL-2L-MA, "QUOTRON" (registered trademark) PL-2L-PGME, or "QUOTRON" (registered trademark) PL-2L-DAA (all manufactured by Fuso Chemical Co., Ltd.).

An example of the silica-lithium oxide composite particles includes LITHIUM SILICATE 45 (manufactured by Nissan Chemical Industries, Ltd.).

Examples of the tin oxide-titanium oxide composite particles include "OPTOLAKE" (registered trademark) TR-502 and "OPTOLAKE" (registered trademark) TR-504 (all manufactured by JGC Catalysts and Chemicals Ltd.).

Examples of the silicon oxide-titanium oxide composite particles include "OPTOLAKE" (registered trademark) TR-503, "OPTOLAKE" (registered trademark) TR-513, "OPTOLAKE" (registered trademark) TR-520, "OPTOLAKE" (registered trademark) TR-521, "OPTOLAKE" (registered trademark) TR-527, "OPTOLAKE" (registered trademark) TR-528, "OPTOLAKE" (registered trademark) TR-529, "OPTOLAKE" (registered trademark) TR-543 and "OPTOLAKE" (registered trademark) TR-544 (all manufactured by JGC Catalysts and Chemicals Ltd.).

Examples of the titanium oxide particles include "OPTOLAKE" (registered trademark) TR-505 (manufactured by JGC Catalysts and Chemicals Ltd.); "TAINOCK" (registered trademark) A-6, "TAINOCK" (registered trademark) M-6 and "TAINOCK" (registered trademark) AM-15 (all manufactured by Taki Chemical Co., Ltd.); "n Sol" (registered trademark) 101-20I, "n Sol" (registered trademark) 101-20L, "n Sol" (registered trademark) 101-20BL and "n Sol" (registered trademark) 107-20I (all manufactured by Nanogram Corp.); TTO-51(A), TTO-51(B), TTO-55(A), TTO-55(B), TTO-55(C), TTO-55(D), TTO-V-4 and TTO-W-5 (all manufactured by Ishihara Sangyo Kaisha, Ltd.); RTTAP15WT%-E10, RTTDNB15WT%-E11, RTTDNB15WT%-E12, RTTDNB15WT%-E13, RTTIBA15WT%-E6, RTIPA15WT%-NO8, RTIPA15WT%-NO9, RTIPA20WT%-N11, RTIPA20WT%-N13, RTIPA20WT%-N14 and RTIPA20WT%-N16 (all manufactured by C.I. Kasei Co., Ltd.); and HT331B, HT431B, HT631B, HT731B and HT830X (all manufactured by Toho Titanium Co., Ltd.).

Examples of the zirconium oxide particles include "NANOUSE" (registered trademark) ZR-30BL, "NANOUSE" (registered trademark) ZR-30BS, "NANOUSE" (registered trademark) ZR-30BH, "NANOUSE" (registered trademark) ZR-30AL, "NANOUSE" (registered trademark) ZR-30AH, and "NANOUSE" (registered trademark) ZR-30M (all manufactured by Nissan Chemical Industries, Ltd.); and ZSL-M20, ZSL-10T, ZSL-10A, and ZSL-20N (all manufactured by Daiichi Kigenso Kagaku Kogyo Co. , Ltd.) .

Examples of the tin oxide particles include "SERAMACE" (registered trademark) S-8 and "SERAMACE" (registered trademark) S-10 (all manufactured by Taki Chemical Co., Ltd.).

An example of the niobium oxide particles includes "BAILAR" (registered trademark) Nb-X10 (manufactured by Taki Chemical Co., Ltd.).

Examples of the other inorganic particles include tin oxide-zirconium oxide composite particles (manufactured by Catalysts & Chemicals Industries Co., Ltd.), and tin oxide particles and zirconium oxide particles (all manufactured by Kojundo Chemical Lab. Co., Ltd.).

The content of the inorganic particles in a solid of the polysiloxane-containing composition, excluding the solvent, is preferably from 5 to 80% by weight, more preferably from 7 to 70% by weight, even more preferably from 10 to 60% by weight, in particular preferably from 15 to 50% by weight. When the content of the inorganic particles is in the ranges, the cracking resistance of the cured film obtained from the polysiloxane-containing composition can be improved at the thermal curing time and the ion implantation time without damaging the pattern processability with an alkaline developer. The content of the inorganic particles denotes the total content of the inorganic particles constituting the inorganic particle-containing polysiloxane, and other inorganic particles.

### (Photosensitivity)

In the method for manufacturing a semiconductor device of the present invention, the polysiloxane-containing composition may be a photosensitive composition. The composition of the photosensitive composition is not particularly limited. In general, when a photosensitive organic compound giving positive or negative photosensitivity and/or an organic compound having at least one aromatic ring is/are contained in the composition, the cured film obtained from the composition is improved in hydrophobicity to be hindered from undergoing the penetration of a chemical liquid, so that the cured film may not be easily removed or residuals may be generated after the removal of the cured film.

The method for manufacturing a semiconductor device of the present invention makes it possible to remove easily the cured film of the composition containing the photosensitive organic compound giving positive or negative photosensitivity and/or the organic compound having at least one aromatic ring.

### (Positive Photosensitivity)

The polysiloxane-containing composition may be a photosensitive composition having positive or negative photosensitivity. The composition preferably has positive photosensitivity. When the composition has positive photosensitivity, a pattern excellent in resolution after the development can be obtained.

### (Positive Photosensitivity; Compound Having Naphthoquinonediazide Structure)

When positive photosensitivity is given to the polysiloxane-containing composition, it is preferred to contain a compound having a naphthoquinonediazide structure in the composition. The compound having a naphthoquinonediazide structure denotes a compound in which photoreaction is caused by light-exposure so that the structure thereof is changed to generate an indenecarboxylic acid having alkali-solubility. By the generation of this indenecarboxylic acid, only an exposed part of the composition is dissolved with an alkaline developer.

Meanwhile, in an unexposed part of the composition, the quinonediazide moiety of the compound having a naphthoquinonediazide structure acts in the polysiloxane-containing composition. The quinonediazide moiety is coordinated with a silanol group remaining in the polysiloxane so that the compound and the polysiloxane interact with each other to restrain the solubility of the composition into an alkaline developer, the solubility being based on silanols remaining in the polysiloxane.

Accordingly, when the polysiloxane-containing composition contains the compound having a naphthoquinonediazide structure, a difference in solubility becomes large between the exposed part and the unexposed part to improve solubility-contrast therebetween.

Example of the compound having a naphthoquinonediazide structure include compounds in which naphthoquinonediazide sulfonic acid is esterification-bonded to a compound having a phenolic hydroxyl group. In the compound having a naphthoquinonediazide structure, the ortho position and the para position relative to the phenolic hydroxyl group each independently preferably have hydrogen, or a hydroxy group or a substituent represented by any one of the following general formulas (5) to (7):

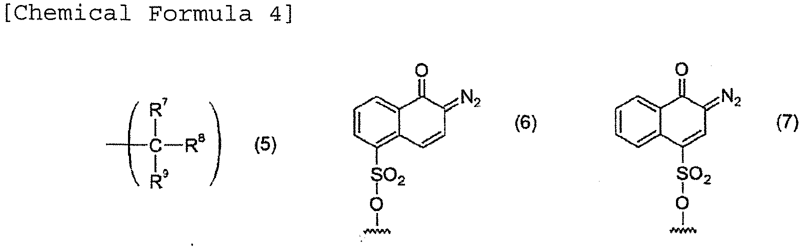

R⁷ to R⁹ each independently represent hydrogen, or an alkyl group having 1 to 10 carbon atoms, a cycloalkyl group having 4 to 10 carbon atoms, an aryl group or carboxy group having 6 to 15 carbon atoms, and at least two of R7 to R9 may form a ring.

R⁷ to R⁹ are each independently preferably an alkyl group having 1 to 6 carbon atoms, a cycloalkyl group having 4 to 7 carbon atoms, an aryl group or carboxy group having 6 to 10 carbon atoms.

The alkyl, cycloalkyl, aryl and carboxy groups may each be either an unsubstituted group or a substituted group.

Examples of the ring, which is formed by at least two of R⁷ to R⁹, include cyclopentane, cyclohexane, norbornene, adamantane, and fluorene ring.

When the ortho position and the para position relative to the phenolic hydroxyl group each independently have the substituent represented by any one of the general formulas (5) to (7), the oxidation decomposition hardly occurs at the thermal curing time, so that a compound with a conjugated system, a typical example thereof being a quinoid structure, is not easily produced. Thus, the cured film is not easily colored to be improved in transparency. The compound having a naphthoquinonediazide structure can be synthesized by subjecting a compound having a phenolic hydroxyl group and naphthoquinonediazide sulfonic chloride to a known esterification reaction.

Examples of the naphthoquinonediazide sulfonic chloride include 4-naphthoquinonediazide sulfonic chloride and 5-naphthoquinonediazide sulfonic chloride. A 4-naphthoquinonediazide sulfonic acid ester compound has an absorption in a region of the i-line (wavelength: 365 nm) so that it is suitable for being subjected to i-line light-exposure. A 5-naphthoquinonediazide sulfonic acid ester compound has an absorption in a wide wavelength range so that it is suitable for being subjected to exposure to light rays having wavelengths in a broad range.

An example of the compound having a naphthoquinonediazide structure a compound represented by the general formula (8) . The use of the compound having a naphthoquinonediazide structure represented by the general formula (8) makes it possible to improve the sensitivity at the light-exposure time and the resolution after the development.

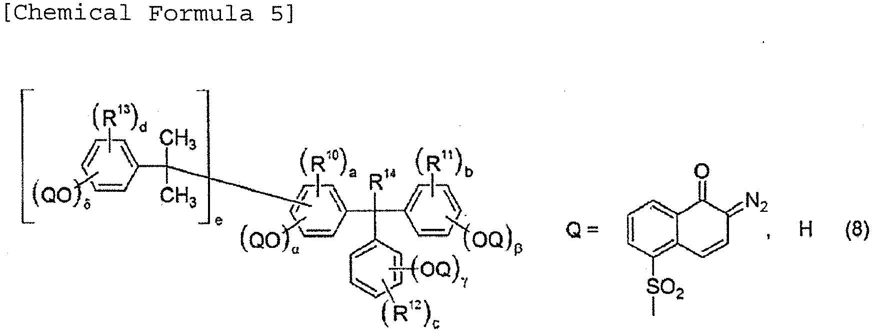

R¹⁰(s) to R¹³(s) each independently represent hydrogen, or an alkyl group having 1 to 10 carbon atoms, a cycloalkyl group having 4 to 10 carbon atoms, an alkoxy group having 1 to 8 carbon atoms, an ester group having 1 to 8 carbon atoms, an aryl group or carboxy group having 6 to 15 carbon atoms. R¹⁴ represents hydrogen, or an alkyl group having 1 to 10 carbon atoms or an aryl group having 6 to 15 carbon atoms. Q(s) represent(s) a 5-naphthoquinonediazide sulfonyl group or hydrogen. At least one Q is a 5-naphthoquinonediazide sulfonyl group. The symbols a, b, c, d, e, α, β, γ, and δ each independently represent an integer from 0 to 4, and α + β + γ + δ ≥ 2.

R¹⁰(s) to R¹³(s) are each independently preferably hydrogen, or an alkyl group having 1 to 6 carbon atoms, a cycloalkyl group having 4 to 7 carbon atoms, an alkoxy group having 1 to 6 carbon atoms, an ester group having 1 to 6 carbon atoms, an aryl group or carboxy group having 6 to 10 carbon atoms . R¹⁴ is preferably hydrogen, or an alkyl group having 1 to 6 carbon atoms or an aryl group having 6 to 10 carbon atoms.

The alkyl, cycloalkyl, alkoxy, ester, aryl and carboxy groups may each be either an unsubstituted group or a substituted group.

When the amount of the polysiloxane is regarded as 100 parts by weight, the content of the compound having a naphthoquinonediazide structure in the polysiloxane-containing composition is preferably from 2 to 30 parts by weight, more preferably from 3 to 15 parts by weight. When the content of the compound having a naphthoquinonediazide structure is in the ranges, the solubility-contrast can be improved at the development time and further the generation of residuals can be restrained after the development. When the polysiloxane is the inorganic particle-containing polysiloxane, the total of the weight of the polysiloxane and that of the inorganic particles constituting the inorganic particle-containing polysiloxane is regarded as 100 parts by weight.

### (Negative Photosensitivity)

When negative photosensitivity is given to the polysiloxane-containing composition, it is preferred to contain, in the composition, at least one selected from the group consisting of a photopolymerization initiator, a photoacid generator, and a photobase generator. The photopolymerization initiator denotes a compound in which radicals are generated through bond cleavage and/or reaction by light-exposure. The photoacid generator denotes a compound in which bond cleavage is caused by light-exposure so that an acid is generated. The photobase generator denotes a compound in which bond cleavage is caused by light-exposure so that a base is generated.

### (Negative Photosensitivity; Photopolymerization Initiator)

When the polysiloxane-containing composition contains a photopolymerization initiator, the UV curing can be promoted at the light-exposure time to improve the sensitivity. Moreover, the crosslinkage density after the thermal curing is improved, so that the cured film can be improved in hardness.

As the photopolymerization initiator, for example, a publicly known photopolymerization initiator can be used such as an α-aminoalkylphenone compound such as 2-methyl-1-[4-(methylthio)phenyl]-2-morpholinopropan-1-on or 2-dimethylamino-2-(4-methylbenzyl)-1-(4-molpholinophenyl)-b utan-1-on; an acylphosphine oxide compound such as 2,4,6-trimethylbenzoyl-diphenyl phosphine oxide or bis(2,4,6-trimethylbenzoyl)-phenylphosphine oxide; an oxime ester compound such as 1-[4-(phenylthio)phenyl]octane-1,2-dione-2-(O-benzoyl)oxime, 1-[9-ethyl-6-(2-methylbenzoyl)-9H-carbazol-3-yl]ethanone-1-(O-acetyl)oxime, or 1-[9-ethyl-6-[2-methyl-4-[1-(2,2-dimethyl-1,3-dioxolan-4-yl )methyloxy]benzoyl]-9H-carbazole-3-yl]ethanone 1-(O-acetyl)oxime; a benzophenone derivative such as 4,4'-bis(dimethylamino)benzophenone or 4,4'-bis (diethylamino)benzophenone; or a benzoic acid ester compound such as 4-dimethylamino ethyl benzoate or 4-dimethylaminobenzoic acid (2-ethyl)hexyl ester.

### (Negative Photosensitivity; Photoacid Generator)

When the polysiloxane-containing composition contains the photoacid generator, the UV curing can be promoted at the light-exposure time to improve the sensitivity. Moreover, the crosslinkage density after the thermal curing is improved, so that the cured film can be improved in hardness.

The photoacid generator is classified into an ionic compound and a nonionic compound.

As the ionic photoacid generator, for example, a publicly known ionic photoacid generator can be used such as methanesulfonate, trifluoromethanesulfonate, camphorsulfonate or 4-toluenesulfonic acid salt of triphenylsulfonium; or methanesulfonate, trifluoromethanesulfonate, camphorsulfonate or 4-toluenesulfonic acid salt of dimethyl-1-naphthylsulfonium.

As the nonionic photoacid generator, for example, a publicly known nonionic photoacid generator can be used such as a diazomethane compound such as bis(trifluoromethylsulfonyl)diazomethane, bis(cyclohexylsulfonyl)diazomethane, or bis(phenylsulfonyl)diazomethane; or benzylmonooxime-4-tolylsulfonate, 4,4'-dimethylbenzylmonooxime-4-tolylsulfonate, α-(4-tolylsulfonyloxy)imino-4-methoxybenzyl cyanide, α-(10-camphorsulfonyloxy)imino-4-methoxybenzyl cyanide, or some other iminosulfonic acid ester compound.

### (Negative Sensitivity; Photobase Generator)

When the polysiloxane-containing composition contains the photobase generator, the UV curing can be promoted at the light-exposure time to improve the sensitivity. Moreover, the crosslinkage density after the thermal curing is improved, so that the cured film can be improved in hardness.

The photobase generator is classified into a generator that is subjected to light-exposure to generate an organic base, and a generator that is subjected to light-exposure to generate an inorganic base. A photobase generator that generates amines is preferred from the viewpoint of the efficiency of the base generation based on light-exposure, and the solubility of the generator.

As the photobase generator that generates amines by light-exposure, for example, a publicly known photobase generator can be used such as an ortho nitrobenzyl carbamate compound such as N-(2-nitrobenzyl oxy)carbonyl-N-methylamine or N, N'-bis[(2-nitrobenzyloxy)carbonyl]-4,4'-diaminodiphenyl methane; an α,α-dimethyl-3,5-dimethoxybenzyl carbamate compound such as N-(α,α-dimethyl-3,5-dimethoxybenzyloxy)carbonyl-N-methylam ine, N-(α,α-dimethyl-3,5-dimethoxybenzyloxy)carbonyl piperidine or N, N'-bis [(α,α-dimethyl-3,5-dimethoxybenzyloxy)carbonyl]-4,4'-diami nodiphenyl methane; or an acyloxyimino compounds such as acetophenone-O-propanoyl oxime, benzophenone-O-propanoyl oxime, or bis(benzophenone)-O,O'-hexane-1,6-dioyl oxime.

### (Positive Photosensitivity; Photoacid Generator and Photobase Generator)

In the meantime, even when the polysiloxane-containing composition has positive photosensitivity, the composition may further contain an photoacid generator and/or an photobase generator. When the composition contains the photoacid generator and/or the photobase generator, the pattern shape after the thermal curing becomes good, so that a pattern having a shape close to a rectangle is obtained. In this case, an acid and/or a base is/are generated in a large quantity from the compound, for example, after the composition is developed to be pattern-processed and then subjected to bleaching light-exposure. Thus, at the thermal curing time, dehydration condensation of silanols remaining in the polysiloxane is promoted so that the shape of the pattern becomes good after the thermal curing time. Consequently, the pattern can be obtained with a shape closer to a rectangle.

### (Thermal Acid Generator and Thermal Base Generator)

The polysiloxane-containing composition may further contain a thermal acid generator and/or a thermal base generator. The thermal acid generator denotes a compound in which bond cleavage is caused by heat to generate an acid. The thermal base generator is a compound in which bond cleavage is caused by heat to generate a base.

When the polysiloxane-containing composition contains the thermal acid generator and/or the thermal base generator, the cured film obtained from this composition can be improved in cracking resistance at the thermal curing time and the ion implantation time. This is presumed as follows: at the thermal curing time, the crosslinkage of the siloxane is sufficiently advanced by the acid and/or base generated from the compound before the temperature of the composition is raised to a high temperature; thus, at the time of the temperature raise, a rapid advance of the crosslinkage of the siloxane is not caused to restrain the generation of shrinkage stress, so that the resultant cured film is improved in cracking resistance.

As the thermal acid generator, for example, a publicly known thermal acid generator can be used such as "Sun-Aid" (registered trademark) SI-60, "Sun-Aid" (registered trademark) SI-200, "Sun-Aid" (registered trademark) SI-100L or "Sun-Aid" (registered trademark) SI-180L (all manufactured by Sanshin Chemical Industry Co., Ltd.); 4-hydroxyphenyldimethylsulfonium trifluoromethanesulfonate, or benzyl-4-hydroxyphenylmethylsulfonium trifluoromethanesulfonate.

As the thermal base generator, for example, a publicly known thermal base generator can be used such as "U-CAT" (registered trademark) SA1, "U-CAT" (registered trademark) SA102, "POLYCAT" (registered trademark) 8, or "POLYCAT" (registered trademark) 9 (all manufactured by San-Apro Ltd.) .

### (Negative Photosensitivity; Radical Polymerizable Compound)

When the polysiloxane-containing composition has negative photosensitivity, the composition may further contain a radical polymerizable compound. The radical polymerizable compound denotes a compound having, in its molecule, a plurality of ethylenically unsaturated double bonds. The polymerization of the radical polymerizable compound is advanced by effect of radicals generated from the above-mentioned photopolymerization initiator by light-exposure, so that an exposed part of the polysiloxane-containing composition becomes insoluble into an alkaline developer. Consequently, a negative pattern can be formed.

When the polysiloxane-containing composition contains the radical polymerizable compound, the UV curing can be promoted at the light-exposure time to improve the sensitivity. Moreover, the crosslinkage density after the thermal curing is improved, so that the cured film can be improved in hardness.

As the radical polymerizable compound, for example, a publicly known radical polymerizable compound can be used such as diethylene glycol di(meth)acrylate, trimethylolpropane tri (meth) acrylate, ditrimethylolpropane tetra (meth) acrylate, dimethylol-tricyclodecane di(meth)acrylate, pentaerythritol tri(meth)acrylate, pentaerythritol tetra(meth)acrylate, ethoxylated pentaerythritol tetra(meth)acrylate, dipentaerythritol penta(meth)acrylate, dipentaerythritol hexa(meth)acrylate, tripentaerythritol hepta(meth)acrylate, tripentaerythritol octa (meth) acrylate, ethoxylated bisphenol A di(meth)acrylate, or 1,3,5-tris((meth)acryloxyethyl)isocyanuric acid.

### (Silane Coupling Agent)

The polysiloxane-containing composition may further contain a silane coupling agent. When the composition contains the silane coupling agent, interaction between the cured film and a substrate is increased at the interface therebetween so that the cured film is improved in adhesiveness and chemical resistance.

As the silane coupling agent, for example, a publicly known silane coupling agent can be used such as a trifunctional silane such as methyltrimethoxysilane, vinyltrimethoxysilane, 3-methacryloxypropyltrimethoxysilane, 3-acryloxypropyltrimethoxysilane, phenyltrimethoxysilane, 1-naphthyltrimethoxysilane, 2-(3,4-epoxycyclohexyl)ethyltrimethoxysilane, 3-trimethoxysilylpropylsuccinic acid, trifluoromethyltrimethoxysilane, 3-[(3-ethyl-3-oxetanyl)methoxy]propyltrimethoxysilane, 3-aminopropyltrimethoxysilane, 1-(3-trimethoxysilylpropyl)urea, 3-triethoxysilyl-N-(1,3-dimethylbutylidene)propylamine, 3-mercaptopropyltrimethoxysilane, 3-isocyanatepropyltrimethoxysilane, or 1,3,5-tris(3-trimethoxysilylpropyl)isocyanuric acid; a bifunctional silane such as dimethyldimethoxysilane or diphenyldimethoxysilane; or a monofunctional silane such as trimethylmethoxysilane, or organosilane represented by the general formula (9).

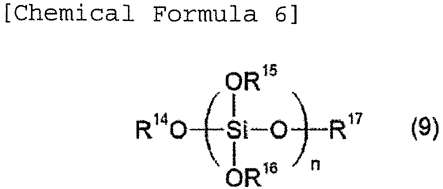

R¹⁴ to R¹⁷ each independently represent hydrogen, or an alkyl, acyl group or aryl group, and n represents an integer of 1 to 15.

R¹⁴ to R¹⁷ are each independently preferably hydrogen, or an alkyl group having 1 to 6 carbon atoms, an acyl group having 2 to 6 carbon atoms or an aryl group having 6 to 15 carbon atoms, more preferably hydrogen, or an alkyl group having 1 to 4 carbon atoms, an acyl group having 2 to 4 carbon atoms or an aryl group having 6 to 10 carbon atoms.

The above-mentioned alky, acyl and aryl groups may each be either an unsubstituted group or a substituted group.

As the organosilane represented by the general formula (9), for example, a publicly known organosilane can be used such as a tetrafunctional silane such as tetramethoxysilane or tetraethoxysilane, METHYL SILICATE 51 (manufactured by Fuso Chemical Co., Ltd.), M SILICATE 51, SILICATE 40 or SILICATE 45 (all manufactured by Tama Chemicals Co., Ltd.), METHYL SILICATE 51, METHYL SILICATE 53A, ETHYL SILICATE 40 or ETHYL SILICATE 48 (all manufactured by Colcoat Co., Ltd.), or other silica compounds.

### (Solvent)

The polysiloxane-containing composition may further contain a solvent. The solvent is preferably a compound having an alcoholic hydroxyl group, a compound having a carbonyl group, or a compound having three or more ether bonds, from the viewpoint of an improvement in the transparency of the resultant cured film by even dissolution of the individual components therein. The solvent is more preferably a compound having a boiling point of 110 to 250°C under the atmospheric pressure. When the boiling point is adjusted to 110°C or higher, the solvent volatilizes to an appropriate extent at the application time, so that the drying of the resultant coating film advances . Thus, the coating film can be satisfactorily obtained without having application unevenness. In the meantime, when the boiling point is adjusted to 250°C or lower, the solvent amount remaining in the coating film can be controlled to a small level so that the shrinkage quantity of the film can be decreased at the thermal curing time. Thus, a cured film good in flatness can be obtained.

Examples of the compound having an alcoholic hydroxyl group and a boiling point under the atmospheric pressure of 110 to 250°C include 4-hydroxy-2-pentanone, 4-hydroxy-4-methyl-2-pentanone (diacetone alcohol), methyl lactate, ethyl lactate, ethylene glycol monomethyl ether, ethylene glycol monoethyl ether, propylene glycol monomethyl ether, propylene glycol monoethyl ether, propylene glycol mono-n-butyl ether, propylene glycol mono-t-butyl ether, diethylene glycol monomethyl ether, dipropylene glycol monomethyl ether, 3-methoxy-1-butanol, 3-methoxy-3-methyl-1-butanol, tetrahydrofurfuryl alcohol, and n-butanol.

Examples of the compound having a carbonyl group and a boiling point under the atmospheric pressure of 110 to 250°C include 3-methoxy-n-butyl acetate, ethylene glycol monomethyl ether acetate, propylene glycol monomethyl ether acetate, methyl isobutyl ketone, 2-heptanone, acetyl acetone, cyclopentanone, cyclohexanone, γ-butyrolactone, N-methyl-2-pyrrolidone, N,N'-dimethylformamide, N,N'-dimethylacetamide, and 1,3-dimethyl-2-imidazolidinone.

Examples of the compound having three or more ether bonds and a boiling point under the atmospheric pressure of 110 to 250°C include diethylene glycol dimethyl ether, diethylene glycol diethyl ether, diethylene glycol ethyl methyl ether, and dipropylene glycol dimethyl ether.

The content of the solvent in the polysiloxane-containing composition is appropriately adjustable in accordance with the application method and others . When the coating film is formed by spin coating, the content is generally from 50 to 95% by weight of the whole of the composition.

### (Surfactant)

The polysiloxane-containing composition may further contain a surfactant. When the composition contains the surfactant in an appropriate amount, the leveling property is improved at the application time, so that the generation of application unevenness can be restrained. Thus, an even coating film can be obtained.

Examples of the surfactant include a fluorine-based surfactant, a silicone-based surfactant, a polyalkylene oxide-based surfactant, and a poly(meth)acrylate-based surfactant.

Examples of the fluorine-based surfactant include 1,1,2,2-tetrafluorooctyl(1,1,2,2-tetrafluoropropyl) ether and sodium perfluorododecylsulfonate. Another example thereof includes a compound in which a monoperfluoroalkylethyl phosphate or the like has, at a terminal thereof or in a main chain or side chain thereof, a fluoroalkyl group or a fluoroalkylene chain. Examples of such a compound include "MEGAFAC" (registered trademark) F-142D, "MEGAFAC" (registered trademark) F-172, "MEGAFAC" (registered trademark) F-173, "MEGAFAC" (registered trademark) F-183, "MEGAFAC" (registered trademark) F-444, "MEGAFAC" (registered trademark) F-445, "MEGAFAC" (registered trademark) F-470, "MEGAFAC" (registered trademark) F-475, "MEGAFAC" (registered trademark) F-477, "MEGAFAC" (registered trademark) F-555 and "MEGAFAC" (registered trademark) F-559 (all manufactured byDIC Corporation), and NBX-15, FTX-218, and DFX-218 (all manufactured by Neos Corp.).

Examples of the silicone surfactant include BYK-301, BYK-307, BYK-331, BYK-333, and BYK-345 (all manufactured by BYK-Chemie GmbH.).

The content of the surfactant in the polysiloxane-containing composition is preferably from 0.0001 to 1% by weight of the whole of the composition.

### (Other Additives)

The polysiloxane-containing composition may further contain at least one selected from the group consisting of a sensitizer for promoting photoreaction, such as a compound having a naphthoquinonediazide structure or a photopolymerization initiator, a curing agent for promoting the thermal curing of the composition, and a crosslinking agent for improving the crosslinkage density of the cured film of the composition.

Examples of the sensitizer include anthracene compounds, anthraquinone compounds, and coumarin compounds. Examples of the curing agent include nitrogen-containing organic compounds, silicone resin curing agents, metal alkoxides, methylol group-containing aromatic compounds, methylol group-containing melamine derivatives, and methylol group-containing urea derivatives. Examples of the crosslinking agent include methylol group-containing aromatic compounds, methylol group-containing melamine derivatives, methylol group-containing urea derivatives, epoxy group-containing compounds, and oxetanyl group-containing compounds.

### <Process Using Method for Manufacturing Semiconductor Device of Invention>

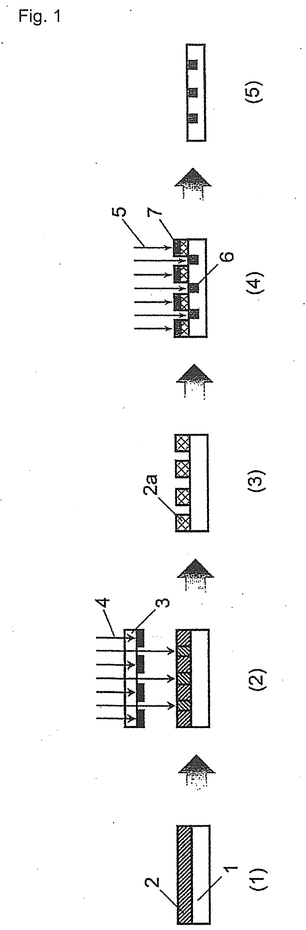

The following describes a process using the method for manufacturing a semiconductor device of the present invention, giving an ion implantation process as an example, referring to Fig. 1. Fig. 1 illustrates a single example to which the invention is applicable. The method for manufacturing a semiconductor device of the invention is not limited to this example.

Initially, (1) a polysiloxane-containing composition is applied onto a silicon semiconductor substrate 1, and then prebaked to form a polysiloxane film 2.

Next, (2) the workpiece is irradiated with an active chemical ray 4 through a mask 3 having a desired pattern.

Thereafter, (3) the workpiece is developed to be patternwise processed. Thereafter, if necessary, the workpiece is subjected to bleaching light-exposure and middle-baking to be thermally cured. In this manner, a polysiloxane pattern 2a is formed which has a desired pattern.

Next, (4) the polysiloxane pattern 2a is used as an ion implantation mask to implant ions 5 into the workpiece to form impurity regions 6 in the silicon semiconductor substrate 1, and further produce a denatured layer 7 in the polysiloxane pattern 2a.

Thereafter, (5) in accordance with the method for manufacturing a semiconductor device of the present invention, the polysiloxane pattern 2a in which the denatured layer 7 is produced is removed from above the silicon semiconductor substrate 1.

### <Step of Yielding Pattern>

The method for manufacturing a semiconductor device of the present invention has a step of yielding a pattern of a polysiloxane-containing composition on a substrate (hereinafter referred to as "step of forming pattern"). Examples of the step of forming pattern include a step of applying the composition onto the substrate to be formed into a film, and then patternwise processing the film, and a step of applying the composition patternwise onto the substrate to form a film.

The substrate is, for example, a substrate having at least one selected from the group consisting of silicon, silicon dioxide (SiO₂), silicon nitride (Si₃N₄), silicon carbide (SiC), gallium nitride (GaN), gallium phosphide (GaP), gallium arsenide (GaAs), gallium aluminum arsenide (GaAlAs), gallium indium nitride arsenide (GaInNAs), indium nitride (InN), indium phosphide (InP), indium tin oxide (ITO), indium zinc oxide (IZO), indium gallium arsenide (InGaAs), indium gallium aluminum phosphide (InGaAlP) , indium gallium zinc oxide (IGZO), diamond, sapphire (Al₂O₃), aluminum zinc oxide (AZO), aluminum nitride (AlN), zinc oxide (ZnO), zinc selenide (ZnSe), cadmium sulfide (CdS), and calcium telluride (CdTe); or a substrate in which ITO, a metal (such as molybdenum, silver, copper or aluminum) or CNT (carbon nanotube) is formed as an electrode or wiring onto a glass piece.

### [Step of Applying Composition onto Substrate to Be Formed into Film, and Then Patternwise Processing Film]

Examples of the method for applying the polysiloxane-containing composition include micro gravure coating, spin coating, dip coating, curtain flow coating, roll coating, spray coating and slit coating. The coating film thickness is varied in accordance with the applying method, the solid concentration in the polysiloxane-containing composition, the viscosity of the composition, and others. The application is attained to set the film thickness usually into the range of 0.1 to 30 µm after the application and pre-baking.

After the polysiloxane-containing composition is applied onto the substrate, the workpiece is preferably prebaked. For the prebaking, for example, an oven, a hot plate or infrared rays are usable. The prebaking temperature is preferably from 50 to 150°C. The prebaking time is preferably from 30 seconds to several hours. The workpiece may be prebaked at two or more stages, for example, the workpiece is prebaked at 80°C for 2 minutes and then prebaked at 120°C for 2 minutes.

Examples of the method for patternwise processing the workpiece include photolithography and etching.

### (Method for Patternwise Processing by Photolithography)

After the polysiloxane-containing composition is applied onto the substrate and the resultant is prebaked, the workpiece is subjected to light-exposure using an exposure apparatus, such as a stepper, a mirror projection mask aligner (MPA), or a parallel light mask aligner (PLA). Examples of an active chemical ray irradiated at the light-exposure time include ultraviolet rays, visible rays, an electron beam, an X ray, a KrF (wavelength: 248 nm) laser, and an ArF (wavelength: 193 nm) laser. It is preferred to use the j-line (wavelength: 313 nm), the i-line (wavelength: 365 nm), the h-line (wavelength: 405 nm), or the g-line (wavelength: 436 nm) of a mercury lamp. The exposure amount is usually from about 100 to 40,000 J/m² (10 to 4,000 mJ/cm²) (value according to an i-line illuminometer). If necessary, the workpiece may be subjected to light-exposure through a mask having a desired pattern.

After the light-exposure, the workpiece may be subjected to post light-exposure baking. The post light-exposure baking makes it possible that it is expected to produce advantageous effects of an improvement in the resolution after the development, an increase in the tolerance of conditions for the development, and others. The post light-exposure baking temperature is preferably from 50 to 180°C, more preferably from 60 to 150°C. The post light-exposure baking time is preferably from 10 seconds to several hours. When the post light-exposure baking time is in the ranges, the reaction may advance satisfactorily to shorten the developing time.

After the light-exposure, the workpiece is developed using, for example, an automatic developing apparatus. When the polysiloxane-containing composition has positive photosensitivity, the exposed part is removed with a developer after the development, so that a relief pattern can be gained. When the polysiloxane-containing composition has negative photosensitivity, the unexposed part is removed with a developer after the development, so that a relief pattern can be gained.

The developer is generally an alkaline developer. The alkaline developer is preferably an organic alkaline solution or an aqueous solution of a compound showing alkalinity. From the viewpoint of the environment, more preferred is the aqueous solution of a compound showing alkalinity, which is an aqueous alkaline solution.

Examples of the organic alkaline solution or the compound showing alkalinity include 2-aminoethanol, 2-(dimethylamino)ethanol, 2-(diethylamino)ethanol, diethanolamine, methylamine, ethylamine, dimethylamine, diethylamine, triethylamine, (2-dimethylamino)ethyl acetate, (2-dimethylamino)ethyl (meth)acrylate, cyclohexylamine, ethylenediamine, hexamethylenediamine, ammonia, tetramethylammonium hydroxide, tetraethylammonium hydroxide, sodium hydroxide, potassium hydroxide, magnesium hydroxide, calcium hydroxide, barium hydroxide, sodium carbonate, and potassium carbonate.

For the developer, an organic solvent may also be used. Examples of the organic solvent include the above-mentioned solvents, ethyl acetate, ethyl pyruvate, ethyl 3-methoxypropionate, ethyl 3-ethoxypropionate, N-acetyl-2-pyrrolidone, dimethylsulfoxide, and hexamethylphosphoric triamide.

The developer may be a mixed solution containing both of the organic solvent, and a poor solvent for the polysiloxane-containing composition. Examples of the poor solvent for the polysiloxane-containing composition include water, methanol, ethanol, isopropyl alcohol, toluene, and xylene.

Examples of the method for the development include a method of applying the developer as it is onto the light-exposed film; a method of spraying the developer into a mist form onto the light-exposed film; a method of immersing the light-exposed film into the developer; or a method of immersing the light-exposed film into the developer, and then applying ultrasonic waves thereto. It is preferred to bring the light-exposed film into contact with the developer for 5 seconds to 10 minutes.

After the development, the resultant relief pattern is preferably washed with a rinsing liquid. When an aqueous alkaline solution is used as the developer, the rinsing liquid is preferably water.

The rising liquid may be, for example, an aqueous solution of an alcohol such as ethanol or isopropyl alcohol, an aqueous solution of an ester such as propylene glycol monomethyl ether acetate, or an aqueous solution of a compound showing acidity, such as carbon dioxide gas, hydrochloric acid or acetic acid.

The rinsing liquid may be an organic solvent. The organic solvent is preferably methanol, ethanol, isopropyl alcohol, ethyl acetate, ethyl lactate, ethyl pyruvate, propylene glycol monomethyl ether, propylene glycol monomethyl ether acetate, methyl 3-methoxypropionate, ethyl 3-ethoxypropionate, or 2-heptanone from the viewpoint of the affinity of the rinsing liquid with the developer.

### (Method for Patternwise Processing by Etching)

After the polysiloxane-containing composition is applied onto the substrate and the resultant is prebaked, the workpiece may be, if necessary, subjected to a thermally curing step treatment that will be detailed later. Thereafter, in the same manner as described above, a photoresist is applied onto the coating film of the composition to form a film. After the application, in the same manner as described above, the workpiece is preferably prebaked.

After the photoresist is applied onto the coating film of the polysiloxane-containing composition and the resultant is prebaked, in the same manner as described above, the workpiece is subjected to light-exposure and then developed. Through the photolithography, a pattern of the photoresist can be formed onto the coating film of the composition.

After the development, it is preferred to cure the resultant pattern thermally. The thermal curing makes it possible to improve the cured film of the photoresist in chemical resistance and dry etching resistance, so that the pattern of the photoresist is favorably usable as an etching mask. For the thermal curing, for example, an oven, a hot plate or infrared rays are usable. The thermally curing temperature is preferably from 70 to 200°C. The thermally curing time is preferably from 30 seconds to several hours.

After the development and the thermal curing, the pattern of the photoresist is used as an etching mask to etch the coating film of the polysiloxane-containing composition, which is a layer below the pattern, to be pattern-processed.

Examples of the method for the etching include wet etching using an etchant and dry etching using an etching gas. The etchant is preferably an acidic or alkaline etchant, or an organic solvent.

Examples of the acidic etchant include solutions of compounds showing acidity such as hydrofluoric acid, hydrochloric acid, hydrobromic acid, hydroiodic acid, perchloric acid, chloric acid, chlorous acid, hypochlorous acid, perbromic acid, bromic acid, bromous acid, hypobromous acid, periodic acid, iodic acid, iodous acid, hypoiodous acid, sulfuric acid, sulfurous acid, hyposulfurous acid, nitric acid, nitrous acid, phosphoric acid, phosphorous acid, hypophosphorous acid, phosphonic acid, phosphinic acid, hexafluorophosphoric acid, hexafluoroantimonic acid, boric acid, tetrafluoroboric acid, formic acid, acetic acid, propionic acid, butanoic acid, trifluoroacetic acid, oxalic acid, lactic acid, methanesulfonic acid, p-toluene sulfonic acid, trifluoromethane sulfonic acid, and fluorosulfonic acid.

The alkaline etchant is preferably an organic alkaline solution or an aqueous solution of a compound showing alkalinity.

Examples of the organic alkaline solution or the compound showing alkalinity include 2-aminoethanol, 2-(dimethylamino)ethanol, 2-(diethylamino)ethanol, diethanolamine, methylamine, ethylamine, dimethylamine, diethylamine, triethylamine, (2-dimethylamino)ethyl acetate, (2-dimethylamino)ethyl (meth)acrylate, cyclohexylamine, ethylenediamine, hexamethylenediamine, ammonia, tetramethylammonium hydroxide, tetraethylammonium hydroxide, sodium hydroxide, potassium hydroxide, magnesium hydroxide, calcium hydroxide, barium hydroxide, sodium carbonate, and potassium carbonate.

Examples of the organic solvent include the above-mentioned solvents, diethylene glycol mono-n-butyl ether, ethyl acetate, ethyl pyruvate, ethyl 3-methoxypropionate, ethyl 3-ethoxypropionate, N-acetyl-2-pyrrolidone, dimethylsulfoxide, hexamethylphosphoric triamide, methanol, ethanol, isopropyl alcohol, toluene, and xylene.

The etchant may be a mixed solution containing both of an alkaline etchant and an organic solvent.

Examples of the method for the wet etching include a method of applying the etchant as it is, or spraying the etchant into a mist form, onto the substrate in which the pattern of the photoresist is formed on the coating film of the polysiloxane-containing composition; a method of immersing, into the etchant, the substrate in which the pattern of the photoresist is formed on the coating film of the polysiloxane-containing composition; or a method of immersing, into the etchant, the substrate in which the pattern of the photoresist is formed on the coating film of the polysiloxane-containing composition, and then applying ultrasonic waves thereto.

The etching temperature at which the substrate in which the pattern of the photoresist is formed on the coating film of the polysiloxane-containing composition is brought into contact with the etchant is preferably from 10 to 180°C, more preferably from 20 to 160°C, even more preferably from 30 to 140°C, in particular preferably from 40 to 120°C. When the boiling point of a component in the etchant is lower than 180°C, the etching temperature is preferably a temperature lower than the boiling point of the component.

The etching time when the substrate in which the pattern of the photoresist is formed on the coating film of the polysiloxane-containing composition is brought into contact with the etchant is preferably 10 seconds or longer, more preferably 30 seconds or longer, even more preferably 1 minute or longer, in particular preferably 3 minutes or longer, most preferably 5 minutes or longer. In the meantime, from the viewpoint of the tact time, the etching time is preferably 60 minutes or shorter, more preferably 45 minutes or shorter, even more preferably 30 minutes or shorter, in particular preferably 15 minutes or shorter.

After the wet etching, it is preferred to wash with a rising liquid the coating film of the polysiloxane-containing composition, which has been pattern-processed by the wet etching.

Examples of the rinsing liquid include water, methanol, ethanol, isopropyl alcohol, ethyl acetate, ethyl lactate, ethyl pyruvate, propylene glycol monomethyl ether, propylene glycol monomethyl ether acetate, methyl 3-methoxypropionate, ethyl 3-ethoxypropionate, and 2-heptanone. In the case of using, as the etchant, an acidic etchant or an aqueous solution of a compound showing alkalinity, the rinsing liquid is preferably a liquid containing water.

Examples of the etching gas include fluoromethane, difluoromethane, trifluoromethane, tetrafluoromethane, chlorofluoromethane, chlorodifluoromethane, chlorotrifluoromethane, dichlorofluoromethane, dichlorodifluoromethane, trichlorofluoromethane, tetrafluorosulfur, difluoroxenone, oxygen, ozone, argon, and fluorine.

Examples of the method for the dry etching include reactive gas etching of exposing, to the etching gas, the substrate in which the pattern of the photoresist is formed on the coating film of the polysiloxane-containing composition; plasma etching of exposing, to the etching gas converted to ions or radicals by electromagnetic waves, the substrate in which the pattern of the photoresist is formed on the coating film of the polysiloxane-containing composition; and reactive ion etching of applying a bias to the etching gas converted to ions or radicals by electromagnetic waves, thereby accelerating this gas to be caused to collide with the substrate in which the pattern of the photoresist is formed on the coating film of the polysiloxane-containing composition.

The etching temperature at which the substrate in which the pattern of the photoresist is formed on the coating film of the polysiloxane-containing composition is brought into contact with the etching gas is preferably from 10 to 180°C, more preferably from 20 to 160°C, even more preferably from 30 to 140°C, in particular preferably from 40 to 120°C.

The etching time when the substrate in which the pattern of the photoresist is formed on the coating film of the polysiloxane-containing composition is brought into contact with the etching gas is preferably 10 seconds or longer, more preferably 30 seconds or longer, even more preferably 1 minute or longer, in particular preferably 3 minutes or longer, most preferably 5 minutes or longer. In the meantime, from the viewpoint of the tact time, the etching time is preferably 60 minutes or shorter, more preferably 45 minutes or shorter, even more preferably 30 minutes or shorter, in particular preferably 15 minutes or shorter.

After the etching, the photoresist remaining on the coating film of the polysiloxane-containing composition is removed to yield a pattern of the polysiloxane-containing composition.

Examples of the method for removing the photoresist include removal using a resist peeling liquid, and removal by ashing. The resist peeling liquid is preferably an acidic or alkaline resist peeling liquid or an organic solvent.

Examples of the acidic resist peeling liquid include an acidic solution, and a mixed solution of an acidic solution and an oxidant. From the viewpoint of photoresist removability, the mixed solution of an acidic solution and an oxidant is preferred.

Examples of the acidic solution include solutions of compounds showing acidity, such as hydrofluoric acid, hydrochloric acid, hydrobromic acid, hydroiodic acid, perchloric acid, chloric acid, chlorous acid, hypochlorous acid, perbromic acid, bromic acid, bromous acid, hypobromous acid, periodic acid, iodic acid, iodous acid, hypoiodous acid, sulfuric acid, sulfurous acid, hyposulfurous acid, nitric acid, nitrous acid, phosphoric acid, phosphorous acid, hypophosphorous acid, phosphonic acid, phosphinic acid, hexafluorophosphoric acid, hexafluoroantimonic acid, boric acid, tetrafluoroboric acid, formic acid, acetic acid, propionic acid, butanoic acid, trifluoroacetic acid, oxalic acid, lactic acid, methanesulfonic acid, p-toluenesulfonic acid, trifluoromethanesulfonic acid, and fluorosulfonic acid. From the viewpoint of photoresist removability, preferred is hydrofluoric acid, hydrochloric acid, hydrobromic acid, sulfuric acid, nitric acid, formic acid, acetic acid or propionic acid. More preferred is sulfuric acid.

Examples of the oxidant include hydrogen peroxide, peracetic acid, m-chloroperbenzoic acid, benzoyl peroxide, di-t-butyl peroxide, t-butyl hydroperoxide, 1,4-benzoquinone, 1,2-benzoquinone, 2,3,5,6-tetrachloro-1,4-benzoquinone, 2,3,5,6-tetrabromo-1,4-benzoquinone, 3,4,5,6-tetrachloro-1,2-benzoquinone, potassium peroxysulfate, 2,2,6,6 -tetramethylpiperidine-1-oxyl free radicals, 2,6-dichloropyridine-N-oxide, [bis(trifluoroacetoxy)iodo]benzene, (diacetoxyiodo)benzene, 2-iodosobenzoic acid, sodium peroxide, potassium peroxide, sodium superoxide, and potassium superoxide. From the viewpoint of photoresist removability, preferred is hydrogen peroxide, peracetic acid or m-chloroperbenzoic acid, and more preferred is hydrogen peroxide.

The alkaline resist peeling liquid is preferably an organic alkaline solution, or an aqueous solution of a compound showing alkalinity.

Examples of the organic alkaline solution or the compound showing alkalinity include 2-aminoethanol, 2-(dimethylamino)ethanol, 2-(diethylamino)ethanol, diethanolamine, methylamine, ethylamine, dimethylamine, diethylamine, triethylamine, (2-dimethylamino)ethyl acetate, (2-dimethylamino)ethyl (meth)acrylate, cyclohexylamine, ethylenediamine, hexamethylenediamine, ammonia, tetramethylammonium hydroxide, tetraethylammonium hydroxide, sodium hydroxide, potassium hydroxide, magnesium hydroxide, calcium hydroxide, barium hydroxide, sodium carbonate, and potassium carbonate.

Examples of the organic solvent include the above-mentioned solvents, diethylene glycol mono-n-butyl ether, ethyl acetate, ethyl pyruvate, ethyl 3-methoxypropionate, ethyl 3-ethoxypropionate, N-acetyl-2-pyrrolidone, dimethylsulfoxide, hexamethylphosphoric triamide, methanol, ethanol, isopropyl alcohol, toluene, and xylene.

A mixed solution containing both of the alkaline resist peeling liquid and the organic solvent may be used as the resist peeling liquid.

Examples of the removing method using the resist peeling liquid include a method of applying the resist peeling liquid as it is, or spraying the resist peeling liquid into a mist form, onto the substrate in which the photoresist remains on the coating film of the polysiloxane-containing composition; a method of immersing, into the resist peeling liquid, the substrate in which the photoresist remains on the coating film of the polysiloxane-containing composition; and a method of immersing, into the resist peeling liquid, the substrate in which the photoresist remains on the coating film of the polysiloxane-containing composition, and then applying ultrasonic waves thereto.

The temperature at which the substrate in which the photoresist remains on the coating film of the polysiloxane-containing composition is brought into contact with the resist peeling liquid is preferably from 10 to 180°C, more preferably from 20 to 160°C, even more preferably from 3.0 to 140°C, in particular preferably from 40 to 120°C. When the boiling point of a component in the resist peeling liquid is lower than 180°C, the immersion temperature is preferably a temperature lower than the boiling point of the component.

The time when the substrate in which the photoresist remains on the coating film of the polysiloxane-containing composition is brought into contact with the resist peeling liquid is preferably 10 seconds or longer, more preferably 30 seconds or longer, even more preferably 1 minute or longer, in particular preferably 3 minutes or longer, most preferably 5 minutes or longer. In the meantime, from the viewpoint of the tact time, the etching time is preferably 60 minutes or shorter, more preferably 45 minutes or shorter, even more preferably 30 minutes or shorter, in particular preferably 15 minutes or shorter.

After the removal using the resist peeling liquid, it is preferred to wash the resultant pattern of the polysiloxane-containing composition with a rinsing liquid.

Examples of the rinsing liquid include water, methanol, ethanol, isopropyl alcohol, ethyl acetate, ethyl lactate, ethyl pyruvate, propylene glycol monomethyl ether, propylene glycol monomethyl ether acetate, methyl 3-methoxypropionate, ethyl 3-ethoxypropionate, and 2-heptanone. In the case of using, as the resist peeling liquid, an acidic resist peeling liquid or an aqueous solution of a compound showing alkalinity, the rinsing liquid is preferably a liquid containing water.

Examples of the gas used for the removal by ashing include gases containing, as a component, at least one selected from the group consisting of oxygen, ozone, argon, fluorine and chlorine. From the viewpoint of photoresist removability, preferred is a gas containing oxygen or ozone as a component.

Examples of the method for the removal by ashing include photo-exciting ashing of exposing the substrate in which the photoresist remains on the coating film of the polysiloxane-containing composition to the above-mentioned gas; and plasma ashing of exposing the substrate in which the photoresist remains on the coating film of the polysiloxane-containing composition to the gas converted into ions or radicals by electromagnetic waves.

The ashing temperature at which the substrate in which the photoresist remains on the coating film of the polysiloxane-containing composition is brought into contact with the gas is preferably from 10 to 300°C, more preferably from 20 to 250°C, even more preferably from 30 to 220°C, in particular preferably from 40 to 200°C.

The ashing time when the substrate in which the photoresist remains on the coating film of the polysiloxane-containing composition is brought into contact with the gas is preferably 10 seconds or longer, more preferably 30 seconds or longer, even more preferably 1 minute or longer, in particular preferably 3 minutes or longer, most preferably 5 minutes or longer. In the meantime, from the viewpoint of the tact time, the etching time is preferably 60 minutes or shorter, more preferably 45 minutes or shorter, even more preferably 30 minutes or shorter, in particular preferably 15 minutes or shorter.

### [Step of Applying Composition Patternwise onto Substrate to Form Film]

Examples of the method for applying the polysiloxane-containing composition patternwise include letterpress printing, intaglio printing, stencil printing, planographic printing, screen printing, inkjet printing, offset printing and laser printing. The composition is applied to adjust the film thickness usually to the range of 0.1 to 30 µm after the application and the prebaking, the thickness being varied in accordance with the application method, the solid concentration in the polysiloxane-containing composition, the viscosity of the composition, and others.

After the polysiloxane-containing composition is patternwise applied onto the substrate, it is preferred to prebake the workpiece. For the prebaking, for example, an oven, a hot plate or infrared rays are usable. The prebaking temperature is preferably from 50 to 150°C. The prebaking time is preferably from 30 seconds to several hours. The workpiece may be prebaked at two or more stages, for example, the workpiece is prebaked at 80°C for 2 minutes and then prebaked at 120°C for 2 minutes.

By applying the composition patternwise onto the substrate and then prebaking the workpiece, a pattern of the polysiloxane-containing composition is yielded.

After the pattern of the polysiloxane-containing composition is yielded by at least one method selected from the group consisting of photolithography, etching, and the formation of a film by the application of the composition patternwise, the workpiece may be subjected to bleaching light-exposure. By the bleaching light-exposure, the shape of the pattern becomes good after the thermal curing time, so that the pattern is obtained with a shape close to a rectangle. Moreover, the cured film can be improved in transparency.

In the bleaching light-exposure, an exposure apparatus is usable, such as a stepper, a mirror projection mask aligner (MPA), and a parallel light mask aligner (PLA). Examples of an active chemical ray irradiated at the bleaching light-exposure time include ultraviolet rays, visible rays, an electron beam, an X ray, a KrF (wavelength: 248 nm) laser, and an ArF (wavelength: 193 nm) laser. It is preferred to use the j-line (wavelength: 313 nm), the i-line (wavelength: 365 nm), the h-line (wavelength: 405 nm), or the g-line (wavelength: 436 nm) of a mercury lamp. The exposure amount is usually from about 500 to 500,000 J/m² (50 to 50,000 mJ/cm²) (value according to an i-line illuminometer). If necessary, the workpiece may be subjected to light-exposure through a mask having a desired pattern.

After the pattern of the polysiloxane-containing composition is yielded, the workpiece may be middle-baked. The middle-baking makes it possible to improve the resolution after the thermal curing, and control the pattern shape after the thermal curing. For the middle-baking, for example, an oven, a hot plate or infrared rays are usable. The middle-baking temperature is preferably from 50 to 250°C, more preferably from 70 to 220°C. The middle-baking time is preferably from 10 seconds to several hours. The workpiece may be middle-baked at two or more stages, for example, the workpiece is middle-baked at 100°C for 5 minutes and then prebaked at 150°C for 5 minutes.

### (Step of Curing Pattern Thermally)

The method for manufacturing a semiconductor device of the present invention preferably has, as the step for forming pattern, a step of heating the pattern of the polysiloxane-containing composition to 150 to 1,000°C (hereinafter referred to as "step of thermally curing pattern") . By heating the coating film of the composition to 150 to 1,000°C to be thermally cured, the cured film can be improved in ion blocking performance.

In the step of thermally curing pattern, for example, the following is usable: an oven, a hot plate, a vertical furnace, a lateral furnace, an electrical furnace, a flash annealing apparatus, a laser annealing apparatus, or infrared rays.

In the method for manufacturing a semiconductor device of the present invention, the thermally curing temperature in the step of thermally curing pattern is preferably 200°C or higher, more preferably 250°C or higher, even more preferably 300°C or higher. When the thermally curing temperature is in the ranges, the cured film can be improved in ion blocking performance. In the meantime, from the viewpoint of restraining the generation of cracks at the thermal curing time, the thermally curing temperature is preferably 800°C or lower, more preferably 600°C or lower, even more preferably 500°C or lower.

In the method for manufacturing a semiconductor device of the present invention, the thermally curing time in the step of thermally curing pattern is preferably from 1 to 300 minutes, more preferably from 5 to 250 minutes, even more preferably from 10 to 200 minutes, in particular preferably from 30 to 150 minutes. When the thermally curing time is in the ranges, it is possible to restrain the generation of cracks at the thermal curing time, and further to improve the transparency and ion blocking performance of the resultant cured film. The workpiece may be thermally cured at two or more stages, for example, the workpiece is thermally cured at 250°C for 30 minutes and then thermally cured at 400°C for 30 minutes.

### <Step of Forming Ion Impurity Regions>

The method for manufacturing a semiconductor device of the present invention preferably has a step of forming ion impurity regions in the substrate on which the pattern of the polysiloxane-containing composition is formed (hereinafter referred to as "step of forming ion impurity regions"). The step of forming ion impurity regions preferably has a step of implanting ions into the substrate on which the pattern of the polysiloxane-containing composition is formed (hereinafter referred to as "ion implantation step"), or a step of doping the substrate on which the pattern of the polysiloxane-containing composition is formed with ions (hereinafter referred to as "ion doping step").

### (Ion implantation Step)

The pattern of the polysiloxane-containing composition is used as an ion implantation mask to implant ions into the pattern-formed substrate, so that ion impurity regions can be patternwise formed in the substrate.

In the method for manufacturing a semiconductor device of the present invention, the ion implantation step is a step of using the pattern of the polysiloxane-containing composition as an ion implantation mask to ionize an element which is to form ion impurity regions from a compound containing this element and then cause the ions to collide with the substrate below the pattern, thereby forming the ion impurity regions in the substrate.

In the method for manufacturing a semiconductor device of the present invention, examples of the ion species used in the ion implantation step include respective ions species of boron, aluminum, gallium, indium, nitrogen, phosphorus, arsenic, antimony, carbon, silicon, germanium, tin, oxygen, sulfur, selenium, tellurium, fluorine, chlorine, bromine, iodine, cadmium, zinc, titanium, tungsten, and iron. From the viewpoint of the formation of the ion impurity regions, more preferred are respective ion species of boron, aluminum, gallium, indium, nitrogen, phosphorus, arsenic, antimony, carbon, silicon, germanium, oxygen or fluorine, and more preferred are respective ion species of boron, aluminum, gallium, indium, nitrogen, phosphorus, arsenic or antimony.

Examples of the compound containing the element which is to form the ion impurity regions include boron trifluoride, boron trichloride, boron tribromide, trimethyl boronate, diborane, aluminum trichloride, gallium trichloride, indium trichloride, ammonia, nitrous oxide, nitrogen, phosphine, phosphorus trifluoride, phosphorus pentafluoride, phosphoryl chloride, diphosphorus pentaoxide, phosphoric acid, arsine, arsenic trifluoride, antimony pentachloride, carbon tetrachloride, monosilane, disilane, trisilane, dichlorosilane, trichlorosilane, silicon tetrafluoride, silicon tetrachloride, germane, tin tetrachloride, oxygen, hydrogen sulfide, hydrogen selenide, hydrogen telluride, hydrogen fluoride, fluorocarbon, fluorine, chlorine tetrafluoride, hydrogen chloride, chlorine, hydrogen bromide, bromine, hydrogen iodide, iodine, cadmium dichloride, zinc dichloride, titanium tetrachloride, tungsten hexafluoride, and iron trichloride.

In the method for manufacturing a semiconductor device of the present invention, ions are caused to collide with the substrate while the substrate is heated in the ion implantation step. In the ion implantation step, the ion implantation temperature is generally from 10 to 1,500°C, preferably 100°C or higher, more preferably 200°C or higher, even more preferably 300°C or higher, in particular preferably 400°C or higher, most preferably 500°C or higher. When the ion implantation temperature is in the ranges, the crystal structure of the substrate can be restrained from being damaged at the ion implantation time.

In the method for manufacturing a semiconductor device of the present invention, it is preferred in the ion implantation step to apply a bias to the ions, thereby accelerating the ions to be caused to collide with the substrate. In the ion implantation step, the energy for accelerating the ions is generally from 1 to 10,000 keV. From the viewpoint of the implantation depth of the ions into the substrate, the energy is preferably from 1 to 5,000 keV, more preferably from 5 to 1,000 keV, more preferably from 10 to 500 keV.

In the method for manufacturing a semiconductor device of the present invention, the ion dose amount in the ion implantation step is generally from 1 × 10¹⁰ to 1 × 10²⁰ cm⁻². From the viewpoint of the restraint of damage to the crystal structure of the substrate, and the implantation depth of the ions into the substrate, the amount is preferably from 1 × 10¹⁰ to 1 × 10¹⁷ cm⁻², more preferably from 1 × 10¹¹ to 1 × 10¹⁵ cm⁻².

### (Ion doping Step)

By using the pattern of the polysiloxane-containing composition as an ion doping mask to dope the pattern-formed substrate with ions, ion impurity regions can be patternwise formed in the substrate.

In the method for manufacturing a semiconductor device of the present invention, the ion doping step is a step of using the pattern of the polysiloxane-containing composition as an ion doping mask to expose the substrate below the pattern to a compound containing an element that is to form ion impurity regions, thereby forming the ion impurity regions in the substrate. The compound used in the ion doping step and containing the element which is to form the ion impurity regions is referred to as "dopant substance" hereinafter.

In the method for manufacturing a semiconductor device of the present invention, examples of the element which is used in the ion doping step and which is to form the ion impurity regions include boron, aluminum, gallium, indium, nitrogen, phosphorus, arsenic, antimony, carbon, silicon, germanium, tin, oxygen, sulfur, selenium, tellurium, fluorine, chlorine, bromine, iodine, cadmium, zinc, titanium, tungsten, and iron. From the viewpoint of the formation of the ion impurity regions, more preferred is boron, aluminum, gallium, indium, nitrogen, phosphorus, arsenic, antimony, carbon, silicon, germanium, oxygen or fluorine, and more preferred is boron, aluminum, gallium, indium, nitrogen, phosphorus, arsenic or antimony.

Examples of the dopant substance include boron trifluoride, boron trichloride, boron tribromide, trimethyl boronate, diborane, aluminum trichloride, gallium trichloride, indium trichloride, ammonia, nitrous oxide, nitrogen, phosphine, phosphorus trifluoride, phosphorus pentafluoride, phosphoryl chloride, diphosphorus pentaoxide, phosphoric acid, arsine, arsenic trifluoride, antimony pentachloride, carbon tetrachloride, monosilane, disilane, trisilane, dichlorosilane, trichlorosilane, silicon tetrafluoride, silicon tetrachloride, germane, tin tetrachloride, oxygen, hydrogen sulfide, hydrogen selenide, hydrogen telluride, hydrogen fluoride, fluorocarbon, fluorine, chlorine tetrafluoride, hydrogen chloride, chlorine, hydrogen bromide, bromine, hydrogen iodide, iodine, cadmium dichloride, zinc dichloride, titanium tetrachloride, tungsten hexafluoride, and iron trichloride.

In the method for manufacturing a semiconductor device of the present invention, it is preferred in the ion doping step to expose the substrate to the compound containing the element which is to form the ion impurity regions so as to heat the substrate. The ion doping temperature in the ion doping step is generally from 10 to 1,500°C, preferably 100°C or higher, more preferably 200°C or higher, even more preferably 300°C or higher, even more preferably 400°C or higher, in particular preferably 500°C or higher, most preferably 600°C or higher. When the ion doping temperature is in the ranges, the element which is to form the ion impurity regions diffuses easily into the substrate.

In the method for manufacturing a semiconductor device of the present invention, the ion doping time in the ion doping step is preferably 1 minute or longer, more preferably 5 minutes or longer, even more preferably 10 minutes or longer, in particular preferably 30 minutes or longer. When the ion doping time is in the ranges, the element which is to form the ion impurity regions diffuses easily into the substrate. In the meantime, from the viewpoint of the tact time, the ion doping time is preferably 300 minutes or shorter, more preferably 240 minutes or shorter, even more preferably 180 minutes or shorter, in particular preferably 120 minutes or shorter.

### <Step of Patternwise Processing Substrate>

The method for manufacturing a semiconductor device of the present invention may have a step of patternwise processing the substrate on which the pattern of the polysiloxane-containing composition is formed (hereinafter referred to as "step of patternwise processing the substrate") . Examples of the step of patternwise processing the substrate include a step of using dry etching to patternwise process the substrate on which the pattern of the polysiloxane-containing composition is formed (hereinafter referred to as "step of dry-etching the substrate"), and a step of using wet etching to patternwise process the substrate on which the pattern of the polysiloxane-containing composition is formed (hereinafter referred to as "step of wet-etching the substrate").

### (Step of Dry-Etching Substrate)

The pattern of the polysiloxane-containing composition is used as a dry etching mask to dry-etch the pattern-formed substrate, so that the substrate can be patternwise processed.

In the method for manufacturing a semiconductor device of the present invention, the step of dry-etching the substrate is a step of using the pattern of the polysiloxane-containing composition as a dry etching mask to patternwise process the substrate below the pattern using an etching gas.

Examples of the etching gas include fluoromethane, difluoromethane, trifluoromethane, tetrafluoromethane, chlorofluoromethane, chlorodifluoromethane, chlorotrifluoromethane, dichlorofluoromethane, dichlorodifluoromethane, trichlorofluoromethane, sulfur hexafluoride, xenon difluoride, oxygen, ozone, argon, fluorine, chlorine, and boron trichloride.

Examples of the method for the dry etching include reactive gas etching of exposing, to the etching gas, the substrate on which the pattern of the polysiloxane-containing composition is formed; plasma etching of exposing, to the etching gas converted to ions or radicals by electromagnetic waves, the substrate on which the pattern of the polysiloxane-containing composition is formed; and reactive ion etching of applying a bias to the etching gas converted to ions or radicals by electromagnetic waves, thereby accelerating this gas to be caused to collide with the substrate on which the pattern of the polysiloxane-containing composition is formed.

In the method for manufacturing a semiconductor device of the present invention, the etching temperature in the step of dry-etching the substrate is preferably from 10 to 180°C, more preferably from 20 to 160°C, even more preferably from 30 to 140°C, in particular preferably from 40 to 120°C. When the etching temperature is in the ranges, the etching rate can be improved.

In the method for manufacturing a semiconductor device of the present invention, the etching time in the step of dry-etching the substrate is preferably 10 seconds or longer, more preferably 30 seconds or longer, even more preferably 1 minute or longer, in particular preferably 3 minutes or longer, most preferably 5 minutes or longer. In the meantime, from the viewpoint of the tact time, the etching time is preferably 60 minutes or shorter, more preferably 45 minutes or shorter, even more preferably 30 minutes or shorter, in particular preferably 15 minutes or shorter.

### (Step of Wet-Etching Substrate)

The pattern of the polysiloxane-containing composition is used as a wet etching mask, and the pattern-formed substrate is wet-etched, so that the substrate can be patternwise processed.

In the method for manufacturing a semiconductor device of the present invention, the step of wet-etching the substrate is a step of using the pattern of the polysiloxane-containing composition as a wet etching mask to patternwise process the substrate below the pattern using an etchant. The etchant may be an acidic or alkaline chemical liquid.

Examples of the acidic etchant include solutions of compounds showing acidity such as hydrofluoric acid, hydrochloric acid, hydrobromic acid, hydroiodic acid, perchloric acid, chloric acid, chlorous acid, hypochlorous acid, perbromic acid, bromic acid, bromous acid, hypobromous acid, periodic acid, iodic acid, iodous acid, hypoiodous acid, sulfuric acid, sulfurous acid, hyposulfurous acid, nitric acid, nitrous acid, phosphoric acid, phosphorous acid, hypophosphorous acid, phosphonic acid, phosphinic acid, hexafluorophosphoric acid, hexafluoroantimonic acid, boric acid, tetrafluoroboric acid, formic acid, acetic acid, propionic acid, butanoic acid, trifluoroacetic acid, oxalic acid, lactic acid, methanesulfonic acid, p-toluene sulfonic acid, trifluoromethane sulfonic acid, and fluorosulfonic acid.

The alkaline etchant is preferably an organic alkaline solution or an aqueous solution of a compound showing alkalinity.

Examples of the organic alkaline solution or the compound showing alkalinity include 2-aminoethanol, 2-(dimethylamino)ethanol, 2-(diethylamino)ethanol, diethanolamine, methylamine, ethylamine, dimethylamine, diethylamine, triethylamine, (2-dimethylamino)ethyl acetate, (2-dimethylamino)ethyl (meth)acrylate, cyclohexylamine, ethylenediamine, hexamethylenediamine, ammonia, tetramethylammonium hydroxide, tetraethylammonium hydroxide, sodium hydroxide, potassium hydroxide, magnesium hydroxide, calcium hydroxide, barium hydroxide, sodium carbonate, and potassium carbonate.

The etchant may be a mixed solution containing both of an alkaline etchant and an organic solvent.

Examples of the organic solvent include the above-mentioned solvents, diethylene glycol mono-n-butyl ether, ethyl acetate, ethyl pyruvate, ethyl 3-methoxypropionate, ethyl 3-ethoxypropionate, N-acetyl-2-pyrrolidone, dimethylsulfoxide, hexamethylphosphoric triamide, methanol, ethanol, isopropyl alcohol, toluene, and xylene.

Examples of the method for the wet etching include a method of applying the etchant as it is, or spraying the etchant into a mist form, onto the substrate on which the pattern of the polysiloxane-containing composition is formed; a method of immersing, into the etchant, the substrate on which the pattern of the polysiloxane-containing composition is formed; and a method of immersing, into the etchant, the substrate on which the pattern of the polysiloxane-containing composition is formed, and then applying ultrasonic waves thereto.

In the method for manufacturing a semiconductor device of the present invention, the etching temperature in the step of wet-etching the substrate is preferably from 10 to 180°C, more preferably from 20 to 160°C, even more preferably from 30 to 140°C, in particular preferably from 40 to 120°C. When the etching temperature is in the ranges, the etching rate can be improved. When the boiling point of a component in the etchant is lower than 180°C, the etching temperature is preferably a temperature lower than the boiling point of the component in the etchant.

In the method for manufacturing a semiconductor device of the present invention, the etching time in the step of wet-etching the substrate is preferably 10 seconds or longer, more preferably 30 seconds or longer, even more preferably 1 minute or longer, in particular preferably 3 minutes or longer, most preferably 5 minutes or longer. In the meantime, from the viewpoint of the tact time, the etching time is preferably 60 minutes or shorter, more preferably 45 minutes or shorter, even more preferably 30 minutes or shorter, in particular preferably 15 minutes or shorter.

After the wet etching, it is preferred to wash the substrate processed patternwise by the wet etching with a rinsing liquid.

Examples of the rinsing liquid include water, methanol, ethanol, isopropyl alcohol, ethyl acetate, ethyl lactate, ethyl pyruvate, propylene glycol monomethyl ether, propylene glycol monomethyl ether acetate, methyl 3-methoxypropionate, ethyl 3-ethoxypropionate, and 2-heptanone. In the case of using, as the etchant, an acidic etchant or an aqueous solution of a compound showing alkalinity, the rinsing liquid is preferably a liquid containing water.

### <Step of Firing Pattern>

After the step of forming the ion impurity regions, the method for manufacturing a semiconductor device of the present invention has a step of firing the pattern of the polysiloxane-containing composition at 300 to 1,500°C (hereinafter referred to as "step of firing pattern"). This step is a step important for removing the cured film of the polysiloxane-containing composition easily without leaving any residual after the formation of the ion impurity regions in the semiconductor substrate.

In the method for manufacturing a semiconductor device of the present invention, after the step of forming the ion impurity regions, the pattern of the polysiloxane-containing composition may cause a large quantity of residuals after the treatment with the acidic or alkaline chemical liquid, or remaining the cured film. Thus, the pattern is not easily removed.

A reason therefor is that in the ion implantation step or the ion doping step, the pattern of the polysiloxane-containing composition is denatured by the ion implantation or the ion doping. The denaturation of the pattern makes the pattern low in solubility in the acidic or alkaline chemical liquid. Thus, the removal of the pattern becomes difficult. In particular, for giving positive or negative photosensitivity to the composition, the pattern of a photosensitive composition containing a photosensitive organic compound may cause, for example, a large quantity of residuals after the treatment with hydrofluoric acid, or remaining the cured film, after the step of forming the ion impurity regions.

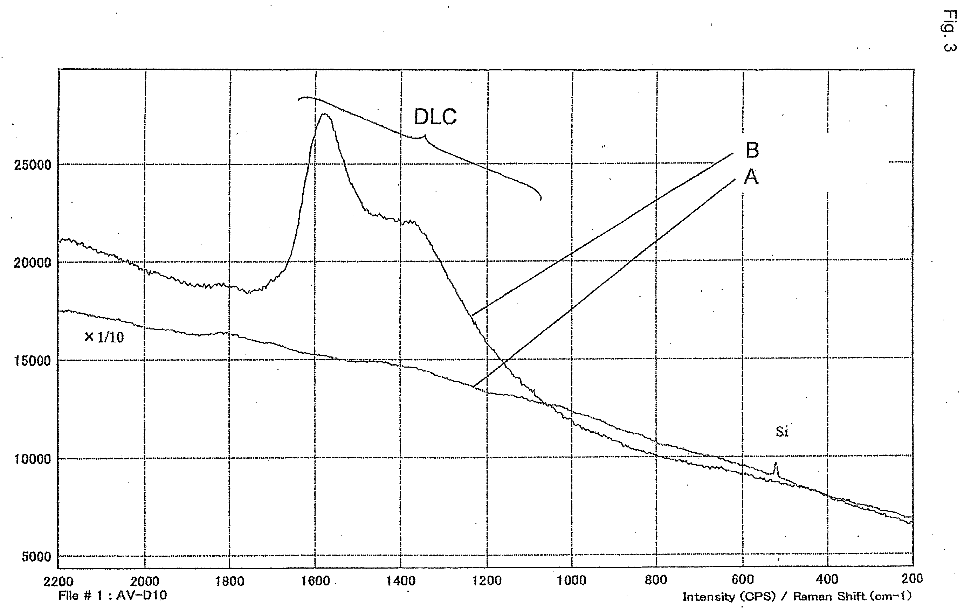

With reference to Fig. 3, the following will describe the denaturation of the pattern of the polysiloxane-containing composition before and after the ion implantation step. A pattern obtained by use of a composition having a polysiloxane including an alkyl group and an aryl group and a compound having a naphthoquinonediazide structure is subjected to slanting incision Raman spectroscopic measurement before and after the ion implantation step. As a result, spectra shown in Fig. 3 have been obtained. In Fig. 3, out of the spectra, a line A is a spectrum before the ion implantation; and a line B is a spectrum after the ion implantation.

As shown in Fig. 3, after the ion implantation step, peaks of diamond-like carbon (hereinafter abbreviated to "DLC") have been detected. The peaks of DLC are a main peak near 1580 cm⁻¹, and a peak positioned near 1390 cm⁻¹ and having a shoulder band. It can be therefore considered that in the ion implantation step, an organic substance present in the pattern is denatured to produce chemically stable DLC, so that the pattern is not easily removed with an acidic or alkaline chemical liquid.

Also in the ion doping step, the pattern is denatured by reaction between a gas or liquid of the compound having an element that is to form ion impurity regions and the pattern of the polysiloxane-containing composition, or the doping of the pattern with ions. After the ion doping step, the denaturation of the pattern makes the pattern low in solubility in an acidic or alkaline chemical liquid, so that the pattern is not easily removed.

Thus, after the step of forming ion impurity regions, the pattern is fired at 300 to 1,500°C, thereby cleaving bonds of the organic substance in the pattern so that the thermal decomposition and volatilization of the organic substance advance, and further DLC in the pattern is thermally decomposed and volatilized to covert the pattern to SiO₂. Accordingly, the pattern can easily be removed thereafter without leaving any residual.

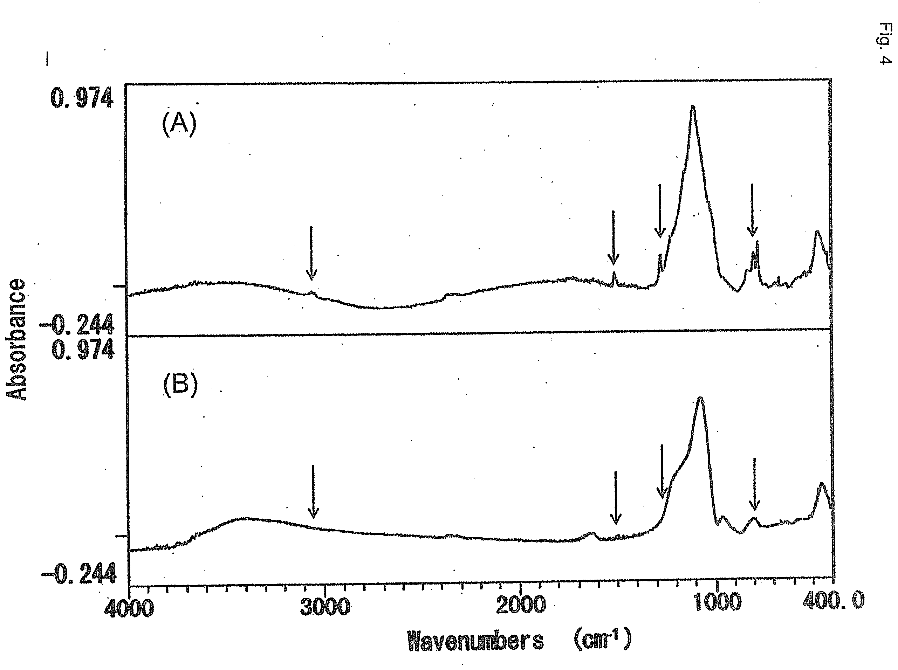

With reference to Fig. 4, the following will describe the conversion of the pattern of the polysiloxane-containing composition to SiO₂ before and after the step of firing pattern. A pattern obtained by use of a composition having a polysiloxane including an alkyl group and an aryl group and a compound having a naphthoquinonediazide structure is subjected to IR spectrum measurement before and after the step of firing pattern. As a result, spectra shown in Fig. 4 have been obtained. Out of the spectra, a line (A) is an IR spectrum of the polysiloxane-containing composition before the firing, and a line (B) is a spectrum of the pattern of the polysiloxane-containing composition before the firing.

Respective peaks near 3050 cm⁻¹, 1500 cm⁻¹ and 1290 cm⁻¹, and a peak positioned near 800 cm⁻¹ and having a shoulder band are peaks of organic substances. After the step of firing pattern, the peaks are disappeared. By such disappearance of the peaks of the organic substances after the step of firing pattern, it can be confirmed that the pattern is converted to SiO₂.

In the step of firing pattern, the pattern is preferably fired at 300 to 1,500°C in the air or oxygen atmosphere from the viewpoint of the removability of the pattern of the polysiloxane-containing composition, and the tact time.

Examples of the air or oxygen atmosphere include air under an ordinary pressure, a gas containing 10 to 100% by weight of oxygen at an ordinary pressure (hereinafter referred to as "oxygen-containing gas"), an air flow having a flow rate of 10 to 1,000 L/minute, and an oxygen-containing gas flow having a flow rate of 10 to 1,000 L/minute.

For the firing of the pattern, for example, the following is usable: an oven, a hot plate, a vertical furnace, a lateral furnace, an electrical furnace, a flash annealing apparatus, a laser annealing apparatus, or infrared rays.

In the method for manufacturing a semiconductor device of the present invention, from the viewpoint of the tact time, the firing temperature in the step of firing pattern is preferably 400°C or higher, more preferably 500°C or higher, even more preferably 600°C or higher, in particular preferably 800°C or higher. When the firing temperature is in the ranges, the decomposition of the organic substances is promoted so that the conversion to SiO₂ is easily advanced. Consequently, the removal of the pattern becomes easier. Moreover, the conversion to SiO₂ is advanced by the treatment for a short time, so that the tack time can be shortened.

In the method for manufacturing a semiconductor device of the present invention, the firing time in the step of firing pattern is preferably 1 minute or longer, more preferably 5 minutes or longer, even more preferably 10 minutes or longer, in particular preferably 30 minutes or longer from the viewpoint of the removability of the pattern of the polysiloxane-containing composition. In the meantime, from the viewpoint of the tact time, the firing time is preferably 300 minutes or shorter, more preferably 240 minutes or shorter, even more preferably 180 minutes or shorter, in particular preferably 120 minutes or shorter. The workpiece may be fired at two or more stages, for example, the workpiece is fired at 400°C for 30 minutes and then fired at 600°C for 30 minutes.

### <Step of Removing Pattern>

The method for manufacturing a semiconductor device of the present invention usually has, after the step of firing pattern, a step of removing the pattern of the polysiloxane-containing composition (hereinafter referred to as "step of removing pattern"). The step of removing pattern preferably has a step of removing the pattern of the polysiloxane-containing composition with a solution containing 10 to 99% by weight of hydrofluoric acid (hereinafter referred to as "hydrofluoric acid-based removing solution").

### (Step of Immersing Workpiece into Hydrofluoric Acid-based Removing Solution)

By immersing the pattern of the polysiloxane-containing composition into the hydrofluoric acid-based removing solution, the pattern can easily be removed without leaving any residual. When the solution contains hydrofluoric acid, any silicon-originating component in the pattern is effectively dissolved, examples of the component including silane coupling agent, silicone, siloxane, silica particles, and silicon dioxide. Consequently, the pattern can easily be removed without leaving any residual.

The hydrofluoric acid-based removing solution may contain a compound from which fluoride ions are generated. When the solution contains the compound from which fluoride ions are generated, the lifetime of the hydrofluoric acid-based removing solution is improved.

Examples of the compound from which fluoride ions are generated include ammonium fluoride, lithium fluoride, sodium fluoride, potassium fluoride, magnesium fluoride, calcium fluoride, strontium fluoride, barium fluoride, aluminum fluoride, and zinc fluoride.

The content of hydrofluoric acid in the hydrofluoric acid-based removing solution is 10% by weight or more, preferably 15% by weight or more, more preferably 20% by weight or more. When the content of hydrofluoric acid is in the ranges , the time necessary for removing the pattern of the polysiloxane-containing composition can be shortened.

The immersion temperature at which the workpiece is immersed in the hydrofluoric acid-based removing solution in the step of removing pattern is preferably from 10 to 40°C, more preferably from 12 to 35 °C, even more preferably from 15 to 30°C. When the immersion temperature is in the ranges, the time necessary for removing the pattern of the polysiloxane-containing composition can be shortened, and further the lifetime of the solution is improved.

The immersion time when the workpiece is immersed in the hydrofluoric acid-based removing solution in the step of removing pattern is preferably 10 seconds or longer, more preferably 30 seconds or longer, even more preferably 1 minute or longer, in particular preferably 3 minutes or longer, most preferably 5 minutes or longer from the viewpoint of the performance of removing the pattern of the polysiloxane-containing composition. In the meantime, from the viewpoint of the tact time, the immersion time is preferably 30 minutes or shorter, more preferably 20 minutes or shorter, even more preferably 10 minutes or shorter, in particular preferably 5 minutes or shorter.

Preferably, the hydrofluoric acid-based removing solution in the step of removing pattern further contains nitric acid. When the solution contains nitric acid which is a strong acid having oxidizing power, an improvement is made in the penetrability of the chemical liquid into the pattern of the polysiloxane-containing composition, and further the cleavage of the bonds in the pattern is promoted so that the generation of any residual can be restrained after the pattern removal.

The content of hydrofluoric acid in the solution containing hydrofluoric acid and nitric acid is preferably from 10 to 65% by weight, more preferably from 10 to 50% by weight, even more preferably from 10 to 45% by weight. When the content of hydrofluoric acid is in the ranges, the time necessary for removing the pattern of the polysiloxane-containing composition can be shortened.

The content of nitric acid in the solution containing hydrofluoric acid and nitric acid is preferably from 5 to 60% by weight, more preferably from 10 to 55% by weight, even more preferably from 15 to 50% by weight. When the content of nitric acid is in the ranges, the time necessary for removing the pattern of the polysiloxane-containing composition can be shortened.

Preferably, the hydrofluoric acid-based removing solution in the step of removing pattern further contains sulfuric acid. When the solution contains sulfuric acid which is a strong acid having oxidizing power, the decomposition of the organic substances in the pattern of the polysiloxane-containing composition is promoted so that the generation of any residual can be restrained after the pattern removal.

The content of hydrofluoric acid in the solution containing hydrofluoric acid and sulfuric acid is preferably 10% by weight or more, more preferably 15% by weight or more, even more preferably 20% by weight or more. When the content of hydrofluoric acid is in the ranges, the time necessary for removing the pattern of the polysiloxane-containing composition can be shortened.

The content of sulfuric acid in the solution containing hydrofluoric acid and sulfuric acid is preferably from 5 to 70% by weight, more preferably from 10 to 65% by weight, even more preferably from 15 to 60% by weight. When the content of sulfuric acid is in the ranges, the time necessary for removing the pattern of the polysiloxane-containing composition can be shortened.

In the method for manufacturing a semiconductor device of the present invention, preferably, the hydrofluoric acid-based removing solution in the step of removing pattern further contains nitric acid and sulfuric acid. When the solution contains nitric acid and sulfuric acid which are each a strong acid having oxidizing power, the generation of any residual can be restrained after the removal of the pattern of the polysiloxane-containing composition.

The content of hydrofluoric acid in the solution containing hydrofluoric acid, nitric acid and sulfuric acid is preferably from 10 to 65% by weight, more preferably from 10 to 50% by weight, even more preferably from 10 to 45% by weight. When the content of hydrofluoric acid is in the ranges, the time necessary for removing the pattern of the polysiloxane-containing composition can be shortened.

The content of nitric acid in the solution containing hydrofluoric acid, nitric acid and nitric acid is preferably from 5 to 60% by weight, more preferably from 10 to 55% by weight, even more preferably from 15 to 50% by weight. When the content of nitric acid is in the ranges, the time necessary for removing the pattern of the polysiloxane-containing composition can be shortened.

The content of sulfuric acid in the solution containing hydrofluoric acid, nitric acid and sulfuric acid is preferably from 5 to 70% by weight, more preferably from 10 to 65% by weight, even more preferably from 15 to 60% by weight. When the content of sulfuric acid is in the ranges, the time necessary for removing the pattern of the polysiloxane-containing composition can be shortened.

After the step of removing pattern, it is preferred to wash the substrate from which the pattern of the polysiloxane-containing composition has been removed with a rinsing liquid.

Examples of the rinsing liquid include water, methanol, ethanol, isopropyl alcohol, ethyl acetate, ethyl lactate, ethyl pyruvate, propylene glycol monomethyl ether, propylene glycol monomethyl ether acetate, methyl 3-methoxypropionate, ethyl 3-ethoxypropionate, and 2-heptanone. The rinsing liquid is preferably a liquid containing water.

### <Step of Cleaning Substrate>

The method for manufacturing a semiconductor device of the present invention preferably has, after the step of removing pattern, a step of cleaning the substrate from which the pattern of the polysiloxane-containing composition has been removed (hereinafter referred to as "step of cleaning the substrate") . The step of cleaning the substrate preferably has a least one step of the following: a step (A) of cleaning the substrate by ultraviolet treatment (hereinafter referred to as "ultraviolet treatment step") ; a step (B) of cleaning the substrate by plasma treatment (hereinafter referred to as "plasma treatment step") ; and a step (C) of cleaning the substrate with a chemical liquid containing at least one selected from the group consisting of an alkaline solution, an organic solvent, an acidic solution and an oxidant (hereinafter, the chemical liquid is referred to as "specific chemical liquid") (hereinafter referred to as "specific chemical liquid treatment step").

When the method has at least one step selected from the group consisting of the steps (A), (B) and (C), the immersion time in the step of removing pattern can be shortened so that the process time can be shortened as a whole. Moreover, it becomes possible to remove contamination with organic substances, metals and/or particles remaining on the substrate.

### (Ultraviolet Treatment Step)

When the substrate from which the pattern of the polysiloxane-containing composition has been removed is cleaned by ultraviolet treatment, the pattern can easily be removed without leaving any residual. Moreover, it becomes possible to remove contamination with organic substances remaining on the substrate.

Examples of the gas used in the ultraviolet treatment step include gases containing, as a component, at least one selected from the group consisting of oxygen, ozone, argon, fluorine and chlorine. A gas containing, as a component, oxygen or ozone is preferred from the viewpoint of the performance of removing the pattern of the polysiloxane-containing composition, and the cleaning of the substrate.

An example of the ultraviolet treatment step includes a step of exposing, to the above-mentioned gas, the substrate on which the pattern of the polysiloxane-containing composition is formed; and then radiating ultraviolet rays thereto. The wavelength of the ultraviolet rays used in the ultraviolet treatment step is generally from 10 to 450 nm. The wavelength is preferably from 20 to 400 nm, more preferably from 50 to 350 nm from the viewpoint of the removability of the pattern, and the cleaning of the substrate.

The treatment temperature in the ultraviolet treatment step is preferably from 10 to 300°C, more preferably from 20 to 250°C, even more preferably from 30 to 220°C, in particular preferably from 40 to 200°C from the viewpoint of the removability of the pattern of the polysiloxane-containing composition, and the cleaning of the substrate.

The treatment time in the ultraviolet treatment step is preferably 10 seconds or longer, more preferably 30 seconds or longer, even more preferably 1 minute or longer, in particular 3 minutes or longer, most preferably 5 minutes or longer from the viewpoint of the removability of the pattern of the polysiloxane-containing composition, and the cleaning of the substrate.

### (Plasma Treatment Step)

When the substrate from which the pattern of the polysiloxane-containing composition has been removed is cleaned by plasma treatment, the pattern can easily be removed without leaving any residual. Moreover, it becomes possible to remove contamination with organic substances remaining on the substrate.

Examples of the gas used in the plasma treatment step include gases containing, as a component, at least one selected from the group consisting of oxygen, ozone, argon, fluorine and chlorine. A gas containing, as a component, oxygen or ozone is preferred from the viewpoint of the removability of the pattern of the polysiloxane-containing composition, and the cleaning of the substrate.

An example of the plasma treatment step includes a step of exposing the substrate on which the pattern of the polysiloxane-containing composition is formed to the above-mentioned gas converted to ions or radicals by electromagnetic waves.

The treatment temperature in the plasma treatment step-is preferably from 10 to 300°C, more preferably from 20 to 250°C, even more preferably from 30 to 220°C, in particular preferably from 40 to 200°C from the viewpoint of the removability of the pattern of the polysiloxane-containing composition, and the cleaning of the substrate.

The treatment time in the plasma treatment step is preferably 10 seconds or longer, more preferably 30 seconds or longer, even more preferably 1 minute or longer, in particular 3 minutes or longer, most preferably 5 minutes or longer from the viewpoint of the removability of the pattern of the polysiloxane-containing composition, and the cleaning of the substrate.

### (Specific Chemical Liquid Treatment Step)

When the substrate from which the pattern of the polysiloxane-containing composition has been removed is immersed in a specific chemical liquid to be cleaned, the pattern can easily be removed without leaving any residual. Moreover, it becomes possible to remove contamination with organic substances, metals and/or particles remaining on the substrate.

The specific chemical liquid used in the specific chemical liquid treatment step is preferably selected from chemical liquids that can dissolve a component in the pattern of the polysiloxane-containing composition to be removed. This makes it possible to shorten the time necessary for removing the pattern.

The above-mentioned alkaline solution is preferably an organic alkaline solution, or an aqueous solution of a compound showing alkalinity.

Examples of the organic alkaline solution or the compound showing alkalinity include 2-aminoethanol, 2-(dimethylamino)ethanol, 2-(diethylamino)ethanol, diethanolamine, methylamine, ethylamine, dimethylamine, diethylamine, triethylamine, (2-dimethylamino)ethyl acetate, (2-dimethylamino)ethyl (meth)acrylate, cyclohexylamine, ethylenediamine, hexamethylenediamine, ammonia, tetramethylammonium hydroxide, tetraethylammonium hydroxide, sodium hydroxide, potassium hydroxide, magnesium hydroxide, calcium hydroxide, barium hydroxide, sodium carbonate, and potassium carbonate. From the viewpoint of the solubility of the pattern of the polysiloxane-containing composition, and the cleaning of the substrate, preferred is 2-aminoethanol, 2-(diethylamino)ethanol, diethanolamine, diethylamine, triethylamine, ethylenediamine, hexamethylenediamine, ammonia, tetramethylammonium hydroxide, sodium hydroxide, potassium hydroxide, sodium carbonate, or potassium carbonate.

The content of the organic alkali or the compound showing alkalinity in the alkaline solution is preferably 0.01% by weight or more, more preferably 0.1% by weight or more, even more preferably 1% by weight or more, in particular preferably 10% by weight or more. When the content of the organic alkali or the compound showing alkalinity is in the ranges, the time necessary for removing the pattern of the polysiloxane-containing composition can be shortened.

Examples of the organic solvent include hydroxyacetone, 4-hydroxy-2-butanone, 3-hydroxy-3-methyl-2-butanone, 4-hydroxy-3-methyl-2-butanone, 5-hydroxy-2-pentanone, 4-hydroxy-2-pentanone, 4-hydroxy-4-methyl-2-pentanone (diacetone alcohol), methyl lactate, ethyl lactate, n-propyl lactate, n-butyl lactate, ethylene glycol monomethyl ether, ethylene glycol monoethyl ether, ethylene glycol mono-n-propyl ether, ethylene glycol mono-n-butyl ether, propylene glycol monomethyl ether, propylene glycol monoethyl ether, propylene glycol mono-n-propyl ether, propylene glycol mono-n-butyl ether, propylene glycol mono-t-butyl ether, diethylene glycol monomethyl ether, diethylene glycol monoethyl ether, diethylene glycol mono-n-propyl ether, diethylene glycol n-butyl ether, dipropylene glycol monomethyl ether, dipropylene glycol monoethyl ether, dipropylene glycol mono-n-propyl ether, 3-methoxy-1-butanol, 3-methoxy-3-methyl-1-butanol, tetrahydrofurfuryl alcohol, n-butanol, n-pentanol, methyl acetate, ethyl acetate, n-propyl acetate, n-butyl acetate, isobutyl acetate, 3-methoxy-n-butyl acetate, 3-methyl-3-methoxy-n-butyl acetate, ethylene glycol monomethyl ether acetate, propylene glycol monomethyl ether acetate, acetone, methyl ethyl ketone, methyl n-propyl ketone, methyl n-butyl ketone, methyl isobutyl ketone, diisobutyl ketone, 2-heptanone, acetyl acetone, cyclopentanone, cyclohexanone, cycloheptanone, γ-butyrolactone, γ-valerolactone, δ-valerolactone, propylene carbonate, N-methyl-pyrrolidone, N,N'-dimethylformamide, N,N'-dimethylacetamide, 1,3-dimethyl-2-imidazolidinone. N,N'-dimethyl propylene urea, N,N,N',N'-tetramethyl urea, dimethyl sulfoxide, hexamethylphosphoric triamide, diethylene glycol dimethyl ether, diethylene glycol diethyl ether, diethylene glycol ethyl methyl ether, diethylene glycol di-n-propyl ether, dipropylene glycol dimethyl ether, dipropylene glycol diethyl ether, dipropylene glycol ethyl methyl ether, and dipropylene glycol di-n-propyl ether. From the viewpoint of the solubility of the pattern film of the polysiloxane-containing composition, and the cleaning of the substrate, preferred is hydroxyacetone, 5-hydroxy-2-pentanone, 4-hydroxy-2-pentanone, diacetone alcohol, ethyl lactate, n-propyl lactate, n-butyl lactate, ethylene glycol monomethyl ether, ethylene glycol monoethyl ether, propylene glycol monomethyl ether, propylene glycol monoethyl ether, diethylene glycol monomethyl ether, diethylene glycol monoethyl ether, diethylene glycol mono-n-propyl ether, diethylene glycol n-butyl ether, dipropylene glycol monomethyl ether, dipropylene glycol monoethyl ether, ethyl acetate, n-propyl acetate, n-butyl acetate, isobutyl acetate, ethylene glycol monomethyl ether acetate, propylene glycol monomethyl ether acetate, acetone, methyl ethyl ketone, methyl n-propyl ketone, methyl n-butyl ketone, methyl isobutyl ketone, 2-heptanone, acetyl acetone, cyclohexanone, γ-butyrolactone, γ-valerolactone, propylene carbonate, N-methyl-pyrrolidone, N,N'-dimethylformamide, N,N'-dimethylacetamide, 1,3-dimethyl-2-imidazolidinone, N,N'-dimethyl propylene urea, N,N,N',N'-tetramethyl urea, dimethyl sulfoxide, hexamethylphosphoric triamide, diethylene glycol dimethyl ether, diethylene glycol diethyl ether, diethylene glycol ethyl methyl ether, diethylene glycol di-n-propyl ether, dipropylene glycol dimethyl ether, dipropylene glycol diethyl ether, dipropylene glycol ethyl methyl ether, or dipropylene glycol di-n-propyl ether.

The content of the organic alkali or the compound showing alkalinity in the mixed solution of the alkaline solution and the organic solvent is preferably 0.01% by weight or more, more preferably 0. 1% by weight or more, even more preferably 1% by weight or more, in particular preferably 10% by weight or more . When the content of the organic alkali or the compound showing alkalinity is in the ranges, the time necessary for removing the pattern of the polysiloxane-containing composition can be shortened.

The content of the organic solvent in the mixed solution of the alkaline solution and the organic solvent is preferably 1% by weight or more, more preferably 3% by weight or more, even more preferably 5% by weight or more, in particular preferably 10% by weight or more. When the content of the organic solvent is in the ranges, the time necessary for removing the pattern of the polysiloxane-containing composition can be shortened. If the content is less than 1% by weight, the remaining cured film may not be completely removed, or a long time may be required for removing the cured film.

Examples of the acidic solution include solutions of compounds showing acidity, such as hydrofluoric acid, hydrochloric acid, hydrobromic acid, hydroiodic acid, perchloric acid, chloric acid, chlorous acid, hypochlorous acid, perbromic acid, bromic acid, bromous acid, hypobromous acid, periodic acid, iodic acid, iodous acid, hypoiodous acid, sulfuric acid, sulfurous acid, hyposulfurous acid, nitric acid, nitrous acid, phosphoric acid, phosphorous acid, hypophosphorous acid, phosphonic acid, phosphinic acid, hexafluorophosphoric acid, hexafluoroantimonic acid, boric acid, tetrafluoroboric acid, formic acid, acetic acid, propionic acid, butanoic acid, trifluoroacetic acid, oxalic acid, lactic acid, methanesulfonic acid, p-toluenesulfonic acid, trifluoromethanesulfonic acid, and fluorosulfonic acid. From the viewpoint of the solubility of the pattern of the polysiloxane-containing composition, and the cleaning of the substrate, preferred is hydrofluoric acid, hydrochloric acid, hydrobromic acid, perchloric acid, chloric acid, chlorous acid, hypochlorous acid, sulfuric acid, nitric acid, hexafluorophosphoric acid, hexafluoroantimonic acid, tetrafluoroboric acid, formic acid, acetic acid, propionic acid, trifluoroacetic acid, oxalic acid, lactic acid, trifluoromethanesulfonic acid, or fluorosulfonic acid.

The content of the compound showing acidity in the acidic solution is preferably 0.01% by weight or more, more preferably 0.1% by weight or more, even more preferably 1% by weight or more, in particular preferably 10% by weight or more. When the content of the compound showing acidity is in the ranges, the time necessary for removing the pattern of the polysiloxane-containing composition can be shortened.

Examples of the oxidant include hydrogen peroxide, peracetic acid, m-chloroperbenzoic acid, benzoyl peroxide, di-t-butyl peroxide, t-butyl hydroperoxide, 1,4-benzoquinone, 1,2-benzoquinone, 2,3,5,6-tetrachloro-1,4-benzoquinone, 2,3,5,6-tetrabromo-1,4-benzoquinone, 3,4,5,6-tetrachloro-1,2-benzoquinone, potassium peroxysulfate, 2,2,6,6-tetramethylpiperidine-1-oxyl free radicals, 2,6-dichloropyridine-N-oxide, [bis(trifluoroacetoxy)iodo]benzene, (diacetoxyiodo)benzene, 2-iodosobenzoic acid, sodium peroxide, potassium peroxide, sodium superoxide, and potassium superoxide. From the viewpoint of the solubility of the pattern film of the polysiloxane-containing composition, and the cleaning of the substrate, preferred is hydrogen peroxide, peracetic acid, m-chloroperbenzoic acid, 1,4-benzoquinone, 2,3,5,6-tetrachloro-1,4-benzoquinone, potassium peroxysulfate, 2,2,6,6-tetramethylpiperidine-1-oxyl free radicals, [bis(trifluoroacetoxy)iodo]benzene, or (diacetoxyiodo)benzene, and more preferred is hydrogen peroxide.

The content of the compound showing acidity in the mixed solution of the acidic solution and the oxidant is preferably 0.01% by weight or more, more preferably 0.1% by weight or more, even more preferably 1% by weight or more, in particular preferably 10% by weight or more. When the content of the compound showing acidity is in the ranges, the time necessary for removing the pattern of the polysiloxane-containing composition can be shortened.

The content of the oxidant in the mixed solution of the acidic solution and the oxidant is preferably from 0.1 to 30% by weight, more preferably from 0.5 to 25% by weight, even more preferably from 1 to 20% by weight. When the content of the oxidant is in the ranges, the time necessary for removing the pattern of the polysiloxane-containing composition can be shortened.

The immersion temperature at which the workpiece is immersed in the specific chemical liquid in the specific chemical liquid treatment step is from 10 to 180°C, more preferably from 20 to 160°C, even more preferably from 30 to 140°C, in particular preferably from 40 to 120°C. When the boiling point of a component in the specific chemical liquid is lower than 180°C, the immersion temperature is preferably a temperature lower than the boiling point of the component. When the immersion temperature is in the ranges, the time necessary for removing the pattern of the polysiloxane-containing composition in the specific chemical liquid treatment step can be shortened, and further the lifetime of the specific chemical liquid is improved.

The immersion time when the workpiece is immersed in the specific chemical liquid in the specific chemical liquid treatment step is preferably 10 seconds or longer, more preferably 30 seconds or longer, even more preferably 1 minute or longer, in particular preferably 3 minutes or longer, most preferably 5 minutes or or longer from the viewpoint of the removability of the pattern of the polysiloxane-containing composition. In the meantime, from the viewpoint of the tact time, the immersion time is preferably 30 minutes or shorter, more preferably 20 minutes or shorter, even more preferably 10 minutes or shorter, in particular preferably 5 minutes or shorter.

After the specific chemical liquid treatment step, it is preferred to wash the cleaned substrate with a rinsing liquid.

Examples of the rinsing liquid include water, methanol, ethanol, isopropyl alcohol, ethyl acetate, ethyl lactate, ethyl pyruvate, propylene glycol monomethyl ether, propylene glycol monomethyl ether acetate, methyl 3-methoxypropionate, ethyl 3-ethoxypropionate, and 2-heptanone. The rinsing liquid is preferably a liquid containing water.

### (Application of Ultrasonic Waves)

In the method for manufacturing a semiconductor device of the present invention, the specific chemical liquid treatment step is preferably a step (C') of applying ultrasonic waves to the specific chemical liquid while or after the workpiece is immersed, thereby cleaning the substrate. By the application of the ultrasonic waves, molecules of a component in the specific chemical liquid are accelerated to promote collision of the molecules with a component in the pattern of the polysiloxane-containing composition, so that the pattern can easily be dissolved in the specific chemical liquid. Consequently, the application of the ultrasonic waves makes it possible to shorten the time necessary for removing the pattern.

The frequency of the applied ultrasonic waves is preferably from 20 to 3000 kHz, more preferably from 25 to 500 Hz, even more preferably from 25 to 150 Hz, in particular preferably from 25 to 70 kHz. When the frequency is in the ranges, the time necessary for removing the pattern of the polysiloxane-containing composition can be shortened.

In the method for manufacturing a semiconductor device of the present invention, the step of cleaning the substrate may further have, after the specific chemical liquid treatment step, a step (D) of immersing the workpiece into a chemical liquid that is a specific chemical liquid but is different from the chemical liquid used in the step (C) (hereinafter referred to as "different specific chemical liquid").

When the method has the step (D), the immersion time in the step (C) can be shortened so that the process time can be shortened as a whole. Moreover, contamination with organic substances, metals and/or particles remaining on the substrate can be removed.

As the different specific chemical liquid used in the step (D), it is preferable to select a chemical liquid that is different from the chemical liquid used in the step (C) and is a liquid which can dissolve a component in the polysiloxane-containing composition pattern to be removed. The use of the chemical liquid different from the chemical liquid used in the step (C) makes it possible to remove easily a pattern of a composition composed of various and complicated components such as a hybrid of an organic substance and an inorganic substance, without leaving any residual. Thus, the time necessary for removing the polysiloxane-containing composition pattern can be shortened.

### <Pattern Shape and Pattern Dimension>

In the method for manufacturing a semiconductor device of the present invention, examples of the pattern of the polysiloxane-containing composition include a line pattern and/or a dot pattern, and at least one of the dimension width of the line and the dimension width of the dot is preferably from 0.01 to 5 µm.

The line pattern denotes a pattern of a polygon having the longest line (hereinafter referred to as "long axis") and a line parallel to a direction identical with the longest line (hereinafter referred to as "long axis direction"), or a pattern of a closed polygon partially containing a circle. Examples of the line pattern include a rectangle, a hexagon, an octagon, and a rectangle partially containing a circle. The dot pattern denotes a polygon, or a closed polygon partially or wholly containing a circle. Examples of the dot pattern include a circle, a square, a regular hexagon, a regular octagon, and a rectangle partially containing a circle.

The dimension width of the line denotes the length between the long axis and the line parallel to the long axis direction, in particular, the length in a direction orthogonal to the long axis direction (hereinafter, the orthogonal direction is referred to as "short axis"). The dimension width of the dot denotes the following: when the pattern is in the form of a circle, the dimension width is referred to as the diameter of the circle; when the pattern is in the form of a polygon, the dimension width is referred to as the length of the longest diagonal line drawn between any apex thereof and another apex thereof; when the pattern is in the form of a closed polygon partially containing a circle, the dimension width is referred to as the largest length out of the largest length between any apex thereof and another apex thereof or the largest length between any apex thereof and the circle. The dimension width of the line and the dimension width of the dot denote the average of the length from a bottom of the pattern that contacts the substrate to another bottom thereof, and the length from a top of the pattern to another top thereof.

The dimension width of the line or the dimension width of the dot can be obtained by measurement using SEM. The magnifying power of SEM is set to the range of 10,000 to 150,000 to measure the dimension width of the line or the dimension width of the dot directly. The dimension width of the line or the dimension width of the dot denotes the average of values obtained by measuring five out of upper, lower, right, left and central points of the substrate, and other points thereof.

In the manufacture of a semiconductor device, the shape of the pattern used in the step of forming ion impurity regions or the step of patternwise processing the substrate is preferably a shape of a line pattern and/or a shape of a dot pattern from the viewpoint of the device design of the semiconductor device.

In the manufacture of a semiconductor device, the pattern dimension width used in the step of forming ion impurity regions or the step of patternwise processing the substrate is preferably from 0.01 to 5 µm, more preferably from 0.01 to 3 µm, even more preferably from 0.01 to 1 µm, in particular preferably from 0.01 to 0.5 µm in at least one of the dimension width of the line and the dimension width of the dot from the viewpoint of heightening the integration degree of elements of the semiconductor device and decreasing a leakage current between the elements.

### <Method for Manufacturing Semiconductor Device>

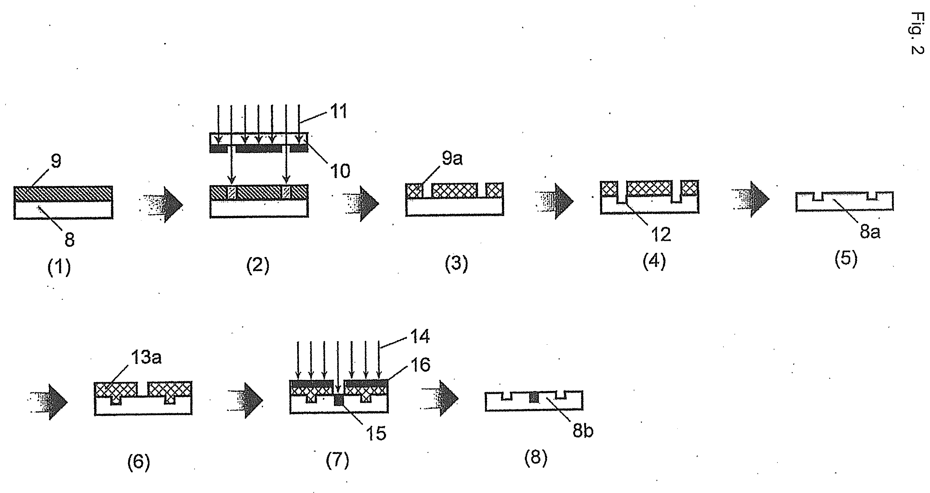

Regarding the method for manufacturing a semiconductor device of the present invention, the following will describe a method for forming impurity regions in a silicon semiconductor substrate using the pattern of the polysiloxane-containing composition, with reference to Fig. 2. Fig. 2 illustrates one example to which the present invention is applicable. Thus, the method for manufacturing a semiconductor device of the present invention is not limited to this example.

Initially, (1) a polysiloxane-containing composition is applied onto a silicon semiconductor substrate 8, and then prebaked to form a polysiloxane film 9.

Next, (2) the workpiece is irradiated with an active chemical ray 11 through a mask 10 having a desired pattern.

Thereafter, (3) the workpiece is developed to be patternwise processed. Thereafter, if necessary, the workpiece is subjected to bleaching light-exposure and then middle-baking to be thermally cured. In this manner, a polysiloxane pattern 9a is formed which has a desired pattern.

Next, (4) the polysiloxane pattern 9a is used as an etching mask to dry-etch the silicon semiconductor substrate 8 to be patternwise processed. In this manner, a pattern 12 is formed in the silicon semiconductor substrate 8.

Thereafter, (5) in accordance with the method for manufacturing a semiconductor device of the present invention, the polysiloxane pattern 9a is removed to yield a silicon semiconductor substrate 8a in which the pattern 12 is formed.

Next, (6) in the same manner as described above, a polysiloxane pattern 13a having a desired pattern is formed on the silicon semiconductor substrate 8a from the polysiloxane-containing composition.

Next, (7) the polysiloxane pattern 13a is used as an ion implantation mask to implant ions 14 into the silicon semiconductor substrate 8a to form impurity regions 15 in this substrate 8a and further produce a denatured layer 16 in the polysiloxane pattern.

Thereafter, (8) in accordance with the method for manufacturing a semiconductor device of the present invention, the polysiloxane pattern 13a, in which the denatured layer 16 is produced, is removed from above the silicon semiconductor substrate 8a to yield a silicon semiconductor substrate 8b having the impurity regions 15.

As described above, the method for manufacturing a semiconductor device of the present invention makes it possible to implant ions into fine pattern regions or dope the regions with ions at a high temperature to improve the yield of semiconductor devices, and the performances of the devices. Additionally, when compared with a method using a SiO₂ film as an ion implantation mask or an ion doping mask, the present method makes it possible to reduce the number of steps so that the productivity can be improved and the tact time can be shortened. Furthermore, this method makes it possible to remove easily the cured film of the denatured polysiloxane-containing composition in the formation of ion impurity regions without leaving any residual, so that the yield of semiconductor devices can be improved and the tact time can be shortened.

Examples of a semiconductor device to which the method for manufacturing a semiconductor device of the present invention is applicable include, but are not limited to, semiconductor elements such as a Schottky diode, a Schottky barrier diode (SBD), a pn junction diode, a PIN diode, a thyristor, a gate turn-off thyristor (GTO), a bipolar transistor, a metal-oxide-semiconductor field-effect transistor (MOSFET) and an insulated gate bipolar transistor (IGBT) ; and a solar photoelectric generation power conditioner, a vehicle-mounted power control unit, a solar photoelectric generation inverter, a switching power source, an inverter and a converter each having at least one of the above-mentioned semiconductor elements.

### EXAMPLES

Hereinafter, the present invention will be more specifically described by way of examples and comparative examples. However, the invention is not limited to the scope of the examples. Regarding compounds used in the examples and represented by abbreviation, their names are described below.

AlCl₃: aluminum trichloride
BF₃: boron trifluoride
DAA: diacetone alcohol
EtOH: ethanol
FPD: flat panel display
HF: hydrofluoric acid
HMDS: hexamethyldisilazane
HNO₃: nitric acid
H₂O₂: hydrogen peroxide
H₂SO₄: sulfuric acid
IPA: isopropyl alcohol
KBM-04: tetramethoxysilane (produced by Shin-etsu Chemical Co, Ltd.)
KBM-903: 3-aminopropyltrimethoxysilane (manufactured by Shin-etsu Chemical Co, Ltd.)
MB: 3-methoxy-1-butanol
MeOH: methanol
NaOH: sodium hydroxide
NMP: N-methyl-2-pyrrolidone
NMR: nuclear magnetic resonance
N₂O: nitrous oxide, nitric monoxide
OXE-01: "IRGACURE" (registered trademark) OXE-01 (manufactured by BASF;
1-[4-(phenylthio)phenyl]octane-1,2-dione-2-(O-benzoyl)oxime )
O₃: ozone
PAI-101: α-(4-tolylsulfonyloxy)imino-4-methoxybenzyl cyanide (manufactured by Midori Kagaku Co., Ltd.)
PGMEA: propylene glycol monomethyl ether acetate
PH₃: phosphine
Ph-cc-AP: (1-(3,4-dihydroxyphenyl)-1-(4-hydroxyphenyl)-1-phenylethane (manufactured by Honshu Chemical Industry Co., Ltd.)
PL-2L-MA: "QUOTRON" (registered trademark) PL-2L-MA (manufactured by Fuso Chemical Co., Ltd.; silica particles having particle diameter of 15 to 20 nm in which methanol is used as dispersion medium)
RF: high frequency
THF: tetrahydrofuran
TMAH: tetramethyl ammonium hydroxide

### Synthesis Example 1: Synthesis of Polysiloxane Solution (A-1)

Into a three-necked flask were charged 54.49 g (40 mol%) of methyltrimethoxysilane, 99.15 g (50 mol%) of phenyltrimethoxysilane, 24.64 g (10 mol%) of 2- (3,4-epoxycyclohexyl)ethyltrimethoxysilane, and 179.48 g of DAA. Nitrogen was caused to flow into the flask at 0.05 L/minute, and the flask was heated to 40°C in an oil bath while the mixed solution was stirred. While the mixed solution was further stirred, an aqueous phosphoric acid solution in which 0.535 g of phosphoric acid was added to 55.86 g of water was added to the system over 10 minutes. After the end of the addition, the silane compounds were hydrolyzed while the reaction system was stirred at 40°C for 30 minutes. After the end of the hydrolysis, the bath temperature was set to 70°C and the system was stirred for one hour. Subsequently, the bath temperature was raised to 115°C. After about one hour from the start of the temperature raise, the internal temperature of the solution reached 100°C. From this time, the system was heated and stirred for 2 hours (internal temperature: 100 to 110°C). The resin solution obtained by the heating and stirring for 2 hours was cooled with an ice bath, and then each of an anion exchange resin and a cation exchange resin was added to the resin solution in a proportion of 2% by weight of the solution. The resultant was then stirred for 12 hours. After the stirring, the anion exchange resin and the cation exchange resin were filtrated off and removed to yield a polysiloxane solution (A-1). The solid concentration in the resultant polysiloxane solution (A-1) was 43% by weight, and the Mw of the polysiloxane was 4,200.

### Synthesis Example 2: Synthesis of Polysiloxane Solution (A-2)

Into a three-necked flask were charged 13.62 g (40 mol%) of methyltrimethoxysilane, 62.09 g (50 mol%) of 1-naphthyltrimethoxysilane (50% by weight solution in IPA), 6.16 g (10 mol%) of 2-(3,4-epoxycyclohexyl)ethyltrimethoxysilane, and 63.57 g of DAA. Air was caused to flow into the flask at 0.05 L/minute, and the flask was heated to 40°C in an oil bath while the mixed solution was stirred. While the mixed solution was further stirred, an aqueous phosphoric acid solution in which 0.102 g of phosphoric acid was added to 13.97 g of water was added to the system over 10 minutes. After the end of the addition, the silane compounds were hydrolyzed while the reaction system was stirred at 40°C for 30 minutes. After the end of the hydrolysis, the bath temperature was set to 70°C and the system was stirred for one hour. Subsequently, the bath temperature was raised to 120°C. After about one hour from the start of the temperature raise, the internal temperature of the solution reached 100°C. From this time, the system was heated and stirred for 2 hours (internal temperature: 105 to 115°C). The resin solution obtained by the heating and stirring for 2 hours was cooled with an ice bath, and then each of an anion exchange resin and a cation exchange resin was added to the resin solution in a proportion of 2% by weight of the solution. The resultant was then stirred for 12 hours. After the stirring, the anion exchange resin and the cation exchange resin were filtrated off and removed to yield a polysiloxane solution (A-2). The solid concentration in the resultant polysiloxane solution (A-2) was 36% by weight, and the Mw of the polysiloxane was 4,000.

### Synthesis Example 3: Synthesis of Polysiloxane Solution (A-3)

Into a three-necked flask were charged 8.17 g (40 mol%) of methyltrimethoxysilane, 37.25 g (50 mol%) of 1-naphthyltrimethoxysilane (50% by weight solution in IPA), 49.72 g of PL-2L-MA (22.5% by weight solution in MeOH), and 59.36 g of DAA. Air was caused to flow into the flask at 0.05 L/minute, and the flask was heated to 40°C in an oil bath while the mixed solution was stirred. While the mixed solution was further stirred, an aqueous phosphoric acid solution in which 0.154 g of phosphoric acid was added to 8.38 g of water was added to the system over 10 minutes. After the end of the addition, the silane compounds were hydrolyzed while the reaction system was stirred at 40°C for 30 minutes. After the end of the hydrolysis, to the system was added 3.93 g (10 mol%) of 3-trimethoxysilylpropylsuccinic anhydride. Thereafter, the bath temperature was set to 70°C and the system was stirred for one hour. Subsequently, the bath temperature was raised to 120°C. After about one hour from the start of the temperature raise, the internal temperature of the solution reached 100°C. From this time, the system was heated and stirred for 2 hours (internal temperature: 105 to 115°C). The resin solution obtained by the heating and stirring for 2 hours was cooled with an ice bath, and then each of an anion exchange resin and a cation exchange resin was added to the resin solution in a proportion of 2% by weight of the solution. The resultant was then stirred for 12 hours. After the stirring, the anion exchange resin and the cation exchange resin were filtrated off and removed to yield a polysiloxane solution (A-3). The solid concentration in the resultant polysiloxane solution (A-3) was 35% by weight, and the Mw of the polysiloxane was 1,300. This polysiloxane is inorganic particle-containing polysiloxane, and PL-2L-MA is contained in a proportion of 35% by weight of the inorganic particle-containing polysiloxane.

### Synthesis Example 4: Synthesis of Polysiloxane Solution (A-4)

Into a three-necked flask were charged 9.02 g (30 mol%) of dimethyldimethoxysilane, 5.71 g (15 mol%) of tetramethoxysilane, 24.79 g (50 mol%) of phenyltrimethoxysilane, 63.94 g of PL-2L-MA (22.5% by weight solution in MeOH), and 55.49 g of DAA. Air was caused to flow into the flask at 0.05 L/minute, and the flask was heated to 40°C in an oil bath while the mixed solution was stirred. While the mixed solution was further stirred, an aqueous phosphoric acid solution in which 0.214 g of phosphoric acid was added to 13.06 g of water was added to the system over 10 minutes. After the end of the addition, the silane compounds were hydrolyzed while the reaction system was stirred at 40°C for 30 minutes. After the end of the hydrolysis, to the system was added a solution in which 3.28 g (5 mol%) of 3-trimethoxysilylpropylsuccinic anhydride was dissolved in 6.17 g of DAA. Thereafter, the bath temperature was set to 70°C and the system was stirred for one hour. Subsequently, the bath temperature was raised to 110°C. After about one hour from the start of the temperature raise, the internal temperature of the solution reached 100°C. From this time, the system was heated and stirred for 2 hours (internal temperature: 95 to 105°C). The resin solution obtained by the heating and stirring for 2 hours was cooled with an ice bath, and then each of an anion exchange resin and a cation exchange resin was added to the resin solution in a proportion of 2% by weight of the solution. The resultant was then stirred for 12 hours. After the stirring, the anion exchange resin and the cation exchange resin were filtrated off and removed to yield a polysiloxane solution (A-4) . The solid concentration in the resultant polysiloxane solution (A-4) was 39% by weight, and the Mw of the polysiloxane was 1,200. This polysiloxane is inorganic particle-containing polysiloxane, and PL-2L-MA is contained in a proportion of 35% by weight of the inorganic particle-containing polysiloxane.

### Synthesis Example 5: Synthesis of Polysiloxane Solution (A-5)

A polysiloxane solution (A-5) was yielded in the same manner as in Synthesis Example 4 by suing 3.41 g (10 mol%) of methyltrimethoxysilane, 4.51 g (15 mol%) of dimethyldimethoxysilane, 11.42 g (30 mol%) of tetramethoxysilane, 19.83 g (40 mol%) of phenyltrimethoxysilane, 58.97 g of PL-2L-MA (22.5% by weight solution in MeOH), 51.18 g of DAA, 14.42 g of water, 0.211 g of phosphoric acid, 5.69 g of DAA, and 3.28 g (5 mol%) of 3-trimethoxysilylpropylsuccinic anhydride. The solid concentration in the resultant polysiloxane solution (A-5) was 40% by weight, and the Mw of the polysiloxane was 1,200. This polysiloxane is an inorganic particle-containing polysiloxane, and PL-2L-MA is contained in a proportion of 35% by weight of the inorganic particle-containing polysiloxane.

### Synthesis Example 6: Synthesis of Polysiloxane Solution (A-6)

A polysiloxane solution (A-6) was yielded in the same manner as in Synthesis Example 4 by suing 3.41 g (10 mol%) of methyltrimethoxysilane, 4.51 g (15 mol%) of dimethyldimethoxysilane, 17.12 g (45 mol%) of tetramethoxysilane, 12.39 g (25 mol%) of phenyltrimethoxysilane, 52.77 g of PL-2L-MA (22.5% by weight solution in MeOH), 45.79 g of DAA, 15.09 g of water, 0.204 g of phosphoric acid, 5.09 g of DAA, and 3.28 g (5 mol%) of 3-trimethoxysilylpropylsuccinic anhydride. The solid concentration in the resultant polysiloxane solution (A-6) was 41% by weight, and the Mw of the polysiloxane was 1,300. This polysiloxane is an inorganic particle-containing polysiloxane, and PL-2L-MA is contained in a proportion of 35% by weight of the inorganic particle-containing polysiloxane.

### Synthesis Example 7: Synthesis of Polysiloxane Solution (A-7)

Into a three-necked flask were charged 11.92 g (35 mol%) of methyltrimethoxysilane, 9.91 g (20 mol%) of phenyltrimethoxysilane, 20.50 g (35 mol%) of 3-acryloxypropyltrimethoxysilane, 77.29 g of PL-2L-MA (22.5% by weight solution in MeOH) and 67.08 g of DAA. Nitrogen was caused to flow into the flask at 0.05 L/minute, and the flask was heated to 40°C in an oil bath while the mixed solution was stirred. While the mixed solution was further stirred, an aqueous phosphoric acid solution in which 0.098 g of phosphoric acid was added to 13 . 97 g of water was added to the system over 10 minutes . After the end of the addition, the silane compounds were hydrolyzed while the reaction system was stirred at 40°C for 30 minutes. After the end of the hydrolysis, to the system was added a solution in which 6.56 g (10 mol%) of 3-trimethoxysilylpropylsuccinic anhydride was dissolved in 7.45 g of DAA. Thereafter, the bath temperature was set to 70°C and the system was stirred for one hour. Subsequently, the bath temperature was raised to 120°C. After about one hour from the start of the temperature raise, the internal temperature of the solution reached 100°C. From this time, the system was heated and stirred for 2 hours (internal temperature: 105 to 115°C) . The resin solution obtained by the heating and stirring for 2 hours was cooled with an ice bath, and then each of an anion exchange resin and a cation exchange resin was added to the resin solution in a proportion of 2% by weight of the solution. The resultant was then stirred for 12 hours. After the stirring, the anion exchange resin and the cation exchange resin were filtrated off and removed to yield a polysiloxane solution (A-7) . The solid concentration in the resultant polysiloxane solution (A-7) was 35% by weight, and the Mw of the polysiloxane was 2,400. The carboxylic acid equivalent of the polysiloxane was 780, and the double bond equivalent thereof was 440.

### Synthesis Example 8: Synthesis of Compound (QD-1) Having Naphthoquinonediazide Structure

Under dry nitrogen gas flow, into a flask were weighed 15.32 (0.05 mole) of Ph-cc-AP, and 37.62 g (0.14 mole) of 5-naphthoquinonediazide sulfonic chloride. Thereinto was dissolved 450 g of 1,4-dioxane, and the temperature of the reaction system was set to room temperature. Thereinto was dropwise added a mixed solution of 50 g of 1, 4-dioxane and 15.58 g (0.154 mole) of triethylamine while the system was stirred not to raise the inside temperature of the system to 35°C or higher. After the end of the dropwise addition, the mixed solution was stirred at 30°C for 2 hours. After the stirring, the deposited triethylamine salt was removed by filtration, and then the filtrate was poured into water. The resultant was stirred, and the deposited solid precipitation was obtained by filtration. The resultant solid was dried by reduced-pressure drying to yield a compound (QD-1) having a naphthoquinonediazide structure illustrated below.

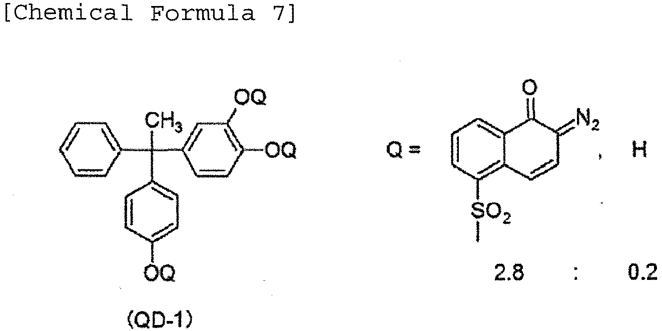

The respective compositions in Synthesis Examples 1 to 7 are together shown in Table 1.

**[Table 1]**

| | Polymer | Monomer [mol%] | | | | | Silica particles [content] |
|---|---|---|---|---|---|---|---|
| Synthesis Example 1 | Polysiloxane solution (A-1) | Methyltrimethoxysilane (40) | Phenyl trimethoxysilane (50) | 2-(3,4-Epoxycyclohexyl)ethyl trimethoxysilane (10) | - | - | - |
| Synthesis Example 2 | Polysiloxane solutlon (A-2) | | 1-Naphthyltrimethoxisilane (50) | | - | - | - |
| Synthesis Example 3 | Polysiloxane solution (A-3) | | | 3-Trimethoxysilylpropylsuccinic anhydride (10) | - | - | PL-2L-MA (35 wt%) |
| Synthesis Example 4 | Polysiloxane solution (A-4) | - | Phenyltrimethoxysilane (50) | 3-Trimethoxysilylpropylsuccinic anhydride (5) | Dimethyldimethoxysilane (30) | Tetramethoxysilane (15) | |
| Synthesis Example 5 | Polysiloxane solution (A-5) | Methyltrimethoxysilane (10) | Phenyltrimethoxysilane (40) | 3-Trimethoxysilylpropylsuccinic anhydride (5) | Dimethyldimethoxysilane (15) | Tetramethoxysilane (30) | |
| Synthesis Example 6 | Polysiloxane solution (A-6) | | Phenyltrimethoxysilane (25) | | | Tetramethoxysilane (45) | |
| Synthesis Example 7 | Polysiloxane solution (A-7) | Methyltrimethoxysilane (35) | Phenyltrimethoxysilane (20) | 3-Trimethoxysilylpropylsuccinic anhydride (10) | - | 3-Acryloxypropyl-trimethoxy silane-(35) | |

In each of the examples and the comparative examples, evaluation methods will be described below.

### (1) Solid Concentration in Resin Solution

One gram of a resin solution was weighed into an aluminum cup the weight of which has been measured. A hot plate (HP-1SA; manufactured by AS ONE Corp.) was used to heat the cup at 250°C for 30 minutes to evaporate and dry/solidify the resin. After the heating, the weight of the aluminum cup in which solid remains was measured. From the difference in weight between the cup before and after the heating, the weight of the remaining solid was calculated out. Thus, the solid concentration in the resin solution was gained.

### (2) Mw of Resin

A GPC analyzer (HLC-8220; manufactured by Toso Corp.) was used to make a GPC measurement of a resin, using THF or NMP as a flowing phase. The Mw of the resin was gained in terms of polystyrene.

### (3) Carboxylic Acid Equivalent

An automatic potential difference titrator (AT-510; manufactured by Kyoto Electronics Manufacturing Co., Ltd.) was used to measure the acid value of a resin by a potential difference titrating method based on "JIS K2501 (2003) ", using a 0.1 mol/L NaOH solution in EtOH as a titrating reagent.

### (4) Double Bond Equivalent

Based on "JIS K0070 (1992)", the iodine value of a resin was measured and calculated out.

### (5) Content by Percentage of Each Organosilane Unit in Polysiloxane

²⁹Si-NMR measurement was made to calculate out the proportion of the integrated value of Si originating from a specific organosilane unit to that of the whole of Si originating from the organosilane. The content by percentage of the organosilane unit was calculated out. A sample (liquid) was injected into a 10 mm-diameter NMR sample tube made of "Teflon" (registered trademark), and this was used for the measurement. Conditions for the ²⁹Si-NMR measurement are as follows:

Machine: nuclear magnetic resonance apparatus (JNM-GX270; manufactured by JEOL Ltd.)
Measuring method: gated decoupling method
Measuring nucleus frequency: 53.6693 MHz (²⁹Si nucleus)
Spectrum width: 20000 Hz
Pulse width: 12 µs (45° pulse)
Pulse repeating time: 30.0 seconds
Solvent: acetone-d6
Reference substance: tetramethylsilane
Measuring temperature: 23°C
Sample rotation number: 0.0 Hz.

### (6) Pretreatment of Each Substrate

A hot plate (HP-1SA; manufactured by AS One Corp.) was used to heat each Si wafer (manufactured by Electronics and Materials Corp.) at 130°C for 2 minutes to be subjected to dehydration baking treatment. Next, an HMDS treatment apparatus (manufactured by Kansai TEK Co., Ltd.) was used to subject the wafer to surface hydrophobicity treatment with HMDS at 100°C for 50 seconds. The resultant wafers were used.

### (7) Film Thickness Measurement

A light interference mode film thickness measuring instrument (LAMBDA ACE VM-1030; manufactured by Dainippon Screen Mfg. Co., Ltd.) was used to measure the thickness of a film in the state of setting the refractive index to 1.55.

### (8) Production of Each Prebaked Film

A spin coater (MS-A100; manufactured by Mikasa Co., Ltd.) was used to apply each of compositions 1 to 9 that will be detailed later onto one of the Si wafers as a substrate by spin coating at an arbitrarily-set rotation number. Thereafter, a hot plate (SCW-636; manufactured by Dainippon Screen Mfg. Co. , Ltd.) was used to prebake the Si wafer at 95°C for 195 seconds to produce a prebaked film.

### (9) Patterning

A double-sided alignment single-sided exposure apparatus (Mask Aligner PEM-6M, manufactured by Union Optical Co., Ltd.) was used to patternwise expose each of the prebaked films produced by the method of (8), through a gray scale mask (MDRM MODEL 4000-5-FS; manufactured by Opto-Line International) for sensitivity-measurement, to the i-line (wavelength: 365 nm), the h-line (wavelength: 405 nm), and the g-line (wavelength: 436 nm) of an ultrahigh pressure mercury lamp. Alternatively, a reduction projection aligner (i-line stepper NSR-2005i9C; manufactured by Nikon Corp.) was used to patternwise expose each of the produced prebaked films to light.

After the light-exposure, a small-sized developing machine for photolithography (AD-2000, manufactured by Takizawa Sangyo Co. Ltd.) was used to develop the film with a 2.38% by weight solution of TMAH in water (manufactured by Tama Chemicals Co., Ltd.) for 90 seconds, and then the resultant was rinsed with water for 30 seconds to produce a patterned film.

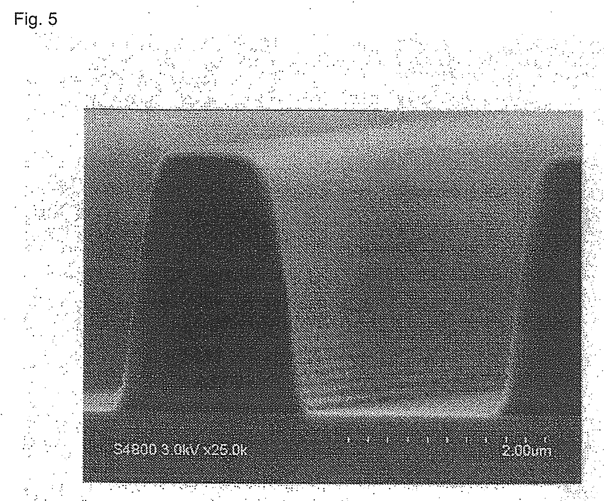

The pattern obtained from the composition 1, which will be detailed later, is shown in Fig. 5. A pattern having a line-and-space shape and having a dimension width of line of 2 µm was obtained.

### (10) Sensitivity

For each of the patterned films obtained by the method of (9), a resolved pattern of the film was observed through an FPD inspection microscope (MX-61L; manufactured by Olympus Corp.). The exposure amount (value according to an i-line illuminator) permitting the 30-µm line-and-space pattern to have a 1 : 1 width ratio was defined as the sensitivity of the patterned film.

### (11) Thermal Curing of Composition

Each of the patterned films obtained by the method of (9) was middle-baked at 120°C for 300 seconds using a hot plate (SCW-636 ; manufactured by Dainippon Screen Mfg. Co., Ltd.), and then thermally cured using a high-temperature inert gas oven (INH-9CD-S; manufactured by Koyo Thermo Systems Co., Ltd.) to produce a cured film of each of the compositions. For conditions for the thermal curing, the film was kept at 50°C for 30 minutes under nitrogen gas flow to purge the inside of the oven with nitrogen. Next, the temperature of the system was raised to an arbitrary set temperature at a temperature raising rate of 10°C/minute, and then the patterned film was thermally cured at the set temperature for an arbitrary time.

### (12) Resolution

For each of the cured films obtained by the method of (11), a resolved pattern of the film was observed through an FPD inspection microscope (MX-61L; manufactured by Olympus Corp.) and a field emission type scanning electron microscope (S-4800 ; manufactured by Hitachi Technologies, Ltd.). As described above, the cured films produced in the same manner as above were exposed to light, developed and thermally cured under conditions that the light-exposure time for these cured films was varied. The dimension of a minimum pattern obtained without leaving any residual was defined as the resolution.

### (13) Cracking Resistant Film Thickness at 450°C Thermal Curing Time

For each of the compositions 1 to 9, which will be detailed later, cured films of the compositions were produced on the above-mentioned Si wafers, respectively, by the method of (11) at a set temperature of 450°C. In this case, adjustments were made to give film thicknesses of several levels between 0.50 µm and 2.50 µm in each of the compositions. After the thermal curing, an FPD inspection microscope (MX-61L; manufactured by Olympus Corp.) was used to observe the presence or absence of cracks on the respective surfaces of the cured films. The maximum film thickness value of cured films not cracked was defined as the cracking resistant film thickness at the thermal curing time at 450°C (hereinafter referred to "450°C thermal curing cracking resistant film thickness"). The compositions are compared with one another for the 450°C thermal curing cracking resistant film thickness. As the compositions show a larger 450°C thermal curing cracking resistant film thickness, the compositions are better in cracking resistance at the 450°C thermal curing time. The composition having a 450°C thermal curing cracking resistant film thickness of 1.40 µm or more is excellent as a composition having heat resistance.

### (14) Ion Implantation

In the method of (11), the set temperature was set to 150°C, 250°C, 350°C and 450°C when ion implantation was performed at 100°C or lower, at 200°C, at 300°C, and at 400°C, respectively, to produce cured films of the respective compositions. Adjustments were made to give film thicknesses of 1.4 to 1.5 µm after the composition was cured. After the thermal curing, an ion implantation apparatus (MODEL 2100 Ion Implanter; manufactured by Veeco) was used to implant ions on each of the substrates having a cured film thereon under conditions using an arbitrary ion species, ion implantation temperature, accelerating energy and ion dose amount, and a vacuum degree of 2.0E - 6 Torr. In this manner, ion impurity regions were formed.

### (15) Ion Doping

In the method of (11), the set temperature was set to 350°C to produce a cured film of each of the compositions. An adjustment was made to set the film thickness to 1.0 µm after the composition was cured. After the thermal curing, a lateral diffusion furnace (MODEL 208; manufactured by Koyo Thermo Systems Co., Ltd.) was used to expose the substrate having a cured film thereon to an arbitrary doping substance under conditions using an arbitrary ion doping temperature and ion doping time. In this manner, ion doping was performed to form ion impurity regions.

### (16) Firing of Cured Film (Pattern)

After the ion implantation was performed by the method of (14) or the ion doping was performed by the method of (15) , a large-sized muffle furnace (FUW263PA; manufactured by Advantec Toyo Kaisha, Ltd.) was used to fire each of the resultant cured films. About conditions for the firing, under air flow, the temperature of the system was raised from 23°C to an arbitrary set temperature at a temperature raising rate of 10°C/minute, and then at this set temperature, the cured film was fired at the set temperature for an arbitrary time.

### (17) Removal of Cured Film (Pattern)

The cured film fired by the method of (16) was immersed in a hydrofluoric acid-based removing solution having an arbitrary composition at an arbitrary temperature for an arbitrary time, and then rinsed with water for 120 seconds.

### (18) Evaluation of Cured Film Removability

For the substrate from which the cured film had been removed by the method of (17), a front surface the substrate was observed through an FPD inspection microscope (MX-61L; manufactured by Olympus Corp.) and a field emission type scanning electron microscope (S-4800; manufactured by Hitachi Technologies, Ltd.) . It was checked whether or not a remaining film of the cured film or any residual was present.

### (19) Cleaning of Substrate by Ultraviolet Treatment

A desktop type optical surface treatment apparatus (PL16-110; manufactured by Sen Lights Co., Ltd.) was used to irradiate the substrate from which the cured film had been removed by the method of (17) with an arbitrary ultraviolet wavelength under an arbitrary gas atmosphere using an arbitrary treatment temperature and treatment time. A front surface of the substrate was observed through an FPD inspection microscope (MX-61L; manufactured by Olympus Corp.) and a field emission type scanning electron microscope (S-4800; manufactured by Hitachi Technologies, Ltd.). It was checked whether or not a remaining film of the cured film or any residual was present.

### (20) Cleaning of Substrate with Plasma Treatment

Under an arbitrary gas flow, a plasma cleaning apparatus (SPC-100B + H; manufactured by Hitachi High-Tech Instruments Co., Ltd.) was used to generate plasma under conditions using an arbitrary RF electric power, treating temperature and treating time, and a gas flow rate of 50 sccm and a treating pressure of 20 Pa, so that the substrate from which the cured film had been removed was treated by the method of (17). Thereafter, a front surface of the substrate was observed through an FPD inspection microscope (MX-61L; manufactured by Olympus Corp.) and a field emission type scanning electron microscope (S-4800; manufactured by Hitachi Technologies, Ltd.) . It was checked whether or not a remaining film of the cured film or any residual was present.

### (21) Cleaning of Substrate with Specific Chemical Liquid

The substrate from which the cured film had been removed by the method of (17) was immersed into a specific chemical liquid having arbitrary composition under conditions using an arbitrary temperature and time, and then rinsed with water for 120 seconds. Thereafter, a front surface of the substrate was observed through an FPD inspection microscope (MX-61L; manufactured by Olympus Corp.) and a field emission type scanning electron microscope (S-4800; manufactured by Hitachi Technologies, Ltd.) . It was checked whether or not a remaining film of the cured film or any residual was present.

### (22) Cleaning of Substrate with Specific Chemical Liquid and Ultrasonic Waves

The substrate from which the cured film had been removed by the method of (17) was treated with the following treatment (i) or treatment (ii).
(i) A desktop type ultrasonic cleaner (UT-104; manufactured by Sharp Corp.) was used to apply ultrasonic waves having a frequency of 39 kHz to the treated substrate. In this state, the substrate was immersed in a specific chemical liquid having arbitrary composition under at an arbitrary temperature for an arbitrary time, and then rinsed with water for 120 seconds.
(ii) The treated substrate was immersed in a specific chemical liquid having arbitrary composition at an arbitrary temperature, and then a desktop type ultrasonic cleaner (UT-104; manufactured by Sharp Corp.) was used to apply ultrasonic waves having a frequency of 39 kHz to the substrate for an arbitrary time. The substrate was then rinsed with water for 120 seconds .

Thereafter, a front surface of the substrate was observed through an FPD inspection microscope (MX-61L; manufactured by Olympus Corp.) and a field emission type scanning electron microscope (S-4800; manufactured by Hitachi Technologies, Ltd.) . It was checked whether or not a remaining film of the cured film or any residual was present.

### Example 1

Under a yellow lamp, 0.553 g of the compound (QD-1) obtained in Synthesis Example 8 and having a naphthoquinonediazide structure was weighed, and thereto were added 0.861 g of DAA and 7.772 g of PGMEA. This reaction system was stirred to dissolve the soluble components. Next, to the system were added 1.535 g of a 20% by weight solution of KBM-04 in PGMEA, and 14.280 g of the polysiloxane solution (A-1) obtained in Synthesis Example 1. The system was then stirred to prepare a homogenous solution. Thereafter, the resultant solution was filtrated through a 0.45-µm filter to prepare a composition 1.

By the methods of (8), (9) and (11), the composition 1 was used to produce a patterned cured film on a Si wafer. Based on the method of (14), the ion implantation machine (MODEL 2100 Ion Implanter, manufactured by the company Veeco) was used to implant ions into the wafer to form ion impurity regions therein.

Ion species: Al ions
Ion implantation temperature: 300°C
Accelerating energy: 180 keV
Ion dose amount: 1.0E + 14 cm⁻²
Vacuum degree: 2.0E - 6 Torr

After the formation of the ion impurity regions, the cured film was fired by the method of (16). Regarding conditions for the firing, under air flow, the temperature was raised from 23 to 500°C at a temperature raising rate of 10°C/minute to fire the cured film at 500°C for 30 minutes.

After the firing, based on the method of (17), the resultant cured film was immersed in a hydrofluoric acid-based removing solution (weight ratio of HF/H₂O = 30.0/70.0) at 23°C for 120 seconds, and then rinsed with water for 120 seconds. The removability of the cured film was then evaluated based on the method of (18).

### Examples 2 and 3

Compositions 2 and 3 were each produced in the same manner as in Example 1 except that the polysiloxane species was changed as described in Table 2-1, and then the compositions were subjected to the same operations and evaluations as in Example 1.

### Examples 4 to 8

In each of the examples, the same operations and evaluations as in Example 3 were made except that the firing temperature and the firing time in (16) were changed as described in Table 2-2, and the immersion time in (17) was changed as described in Table 2-3.

### Examples 9 to 15

In each of the examples, the same operations and evaluations as in Example 3 were made except that the ion implantation conditions in (14) were changed as described in Table 3-2, and the immersion time in (17) was changed as described in Table 3-3.

### Examples 16 to 19

In each of the examples, the same operations and evaluations as in Example 3 were made except that instead of the ion implantation step, the ion doping step described in (15) was performed under the conditions described in Table 3-2.

### Examples 20 to 22

In each of the examples, the same operations and evaluations as in Example 3 were made except that the ion implantation conditions described in (14) were changed as described in Table 4-2.

### Examples 23 to 28

In the same manner as in Example 1, compositions 4 to 9 were produced to have respective compositions as described in Table 4-1. The same operations and evaluations as in Example 1 were made except that the thermally curing conditions in (11) and the ion implantation conditions in (14) were changed as described in Table 4-2.

### Examples 29 to 39

In each of the examples, the same operations and evaluations as in Example 3 were made except that the composition of the hydrofluoric acid-based removing solution used in (17) was changed as described in Table 5-3.

### Examples 40 to 50

In each of the examples, the same operations and evaluations as in Example 3 were made except that after the step of (17), any one of the steps of (19) to (22) was performed as described in Table 6-3.

### Comparative Examples 1 to 10

In each of the examples, a composition described in Table 7-1 was used to perform the same operations and evaluations as in Example 3 except that the thermally curing conditions in (11), the ion implantation conditions in (14) and the firing conditions of the cured film in (16) were changed as described in Table 7-2, and further the immersion time in (17) was changed as described in Table 7-3.

**[Table 2-1]**

| | Composition | Composition [parts by weight] | | | | Inorganic particle content in entire solid [wt%] | Photosensitive properties Cured film properties | | |
|---|---|---|---|---|---|---|---|---|---|
| | | Polysiloxane | Compound having naphthoquinone -diazide structure | Adhesiveness improver | Solvent | | Sensitivity [mJ/cm²] | Resolution [µm] | 450°C Thermal curing cracking resistant film thickness [µm] |
| Example 1 | 1 | A-1 (100) | QD-1 (9) | KBM-04 (5) | DAA PGMEA | - | 30 | 2.0 | 1.35 |
| Example 2 | 2 | A-2 (100) | | | | - | 30 | 2.0 | 1.35 |
| Example 3 | 3 | A-3 (100) | | | | 30.7 | 40 | 2.0 | 1.45 |
| Example 4 | | | | | | | | | |
| Example 5 | | | | | | | | | |
| Example 6 | | | | | | | | | |
| Example 7 | | | | | | | | | |
| Example 8 | | | | | | | | | |

**[Table 2-2]**

| | Composition | Step of thermally curing pattern | | Step of forming ion impurity regions | | | | Step of firing pattern | |
|---|---|---|---|---|---|---|---|---|---|
| | | | | Ion implantation step | | | | | |
| | | Thermally curing temperature [°C] | Thermally curing time [min] | Ion species | Ion implantation temperature [°C] | Accelerating energy [keV] | Ion dose amount [cm⁻²] | Firing temperature [°C] | Firing time [min] |
| Example 1 | 1 | 350 | 30 | Al ion | 300 | 180 | 1.0E+14 | 500 | 30 |
| Example 2 | 2 | 350 | 30 | Al ion | 300 | 180 | 1.0E+14 | 500 | 30 |
| Example 3 | 3 | 350 | 30 | Al ion | 300 | 180 | 1.0E+14 | 500 | 30 |
| Example 4 | | 350 | 30 | Al ion | 300 | 180 | 1.0E+14 | 400 | 120 |
| Example 5 | | 350 | 30 | Al ion | 300 | 180 | 1.0E+14 | 550 | 30 |
| Example 6 | | 350 | 30 | Al ion | 300 | 180 | 1.0E+14 | 600 | 30 |
| Example 7 | | 350 | 30 | Al ion | 300 | 180 | 1.0E+14 | 800 | 30 |
| Example 8 | | 350 | 30 | Al ion | 300 | 180 | 1.0E+14 | 1000 | 30 |

**[Table 2-3]**

| | Composition | Step of removing pattern | | | | Pattern removability |
|---|---|---|---|---|---|---|
| | | Composition of hydrofluoric acid-based removing solution [wt%] | | Immersion temperature [°C] | Immersion time [s] | |
| | | HF | H₂O | | | |
| Example 1 | 1 | 30.0 | 70.0 | 23 | 300 | No remaining film |
| Example 2 | 2 | 30.0 | 70.0 | 23 | 300 | No remaining film |
| Example 3 | 3 | 30.0 | 70.0 | 23 | 300 | No remaining film |
| Example 4 | | 30.0 | 70.0 | 23 | 300 | No remaining film |
| Example 5 | | 30.0 | 70.0 | 23 | 270 | No remaining film |
| Example 6 | | 30.0 | 70.0 | 23 | 240 | No remaining film |
| Example 7 | | 30.0 | 70.0 | 23 | 210 | No remaining film |
| Example 8 | | 30.0 | 70.0 | 23 | 180 | No remaining film |

**[Table 3-1]**

| | Composition | Composition [parts by weight] | | | | Inorganic particle content in entire solid [wt%] | Photosensitive properties Cured film properties | | |
|---|---|---|---|---|---|---|---|---|---|
| | | Polysiloxane | Compound having naphthoquinone -diazide structure | Adhesiveness improver | Solvent | | Sensitivity [mJ/cm²] | Resolution [µm] | 450°C Thermal curing cracking resistant film thickness [µm] |
| Example 9 | 3 | A-3 (100) | QD-1 (9) | KBM-04 (5) | DAA PGMEA | 30.7 | 40 | 2.0 | 1.45 |
| Example 10 | | | | | | | | | |
| Example 11 | | | | | | | | | |
| Example 12 | | | | | | | | | |
| Example 13 | | | | | | | | | |
| Example 14 | | | | | | | | | |
| Example 15 | | | | | | | | | |
| Example 16 | | | | | | | | | |
| Example 17 | | | | | | | | | |
| Example 18 | | | | | | | | | |
| Example 19 | | | | | | | | | |

**[Table 3-2]**

| | Composition | Step of thermally curing pattern | | Step of forming ion impurity regions | | | | | | | Step of firing pattern | |
|---|---|---|---|---|---|---|---|---|---|---|---|---|
| | | | | Ion implantation step | | | | Ion doping step | | | | |
| | | Thermally curing temperature [°C] | Thermally curing time [min] | Ion species | Ion implantation temperature [°C] | Accelerating energy [keV] | Ion dose amount [cm⁻²] | Dopant substance | Ion doping temperature [°C] | Ion doping time [mm] | Firing temperature [°C] | Firing time [min] |
| Example 9 | 3 | 350 | 30 | P ion | 300 | 180 | 1.0E+14 | - | - | - | 500 | 30 |
| Example 10 | | 350 | 30 | B ion | 300 | 180 | 1.0E+14 | - | - | - | 500 | 30 |
| Example 11 | | 350 | 30 | N ion | 300 | 180 | 1.0E+14 | - | - | - | 500 | 30 |
| Example 12 | | 350 | 30 | Ga ion | 300 | 180 | 1.0E+14 | - | - | - | 1000 | 30 |
| Example 13 | | 350 | 30 | As ion | 300 | 180 | 1.0E+14 | - | - | - | 500 | 30 |
| Example 14 | | 350 | 30 | In ion | 300 | 180 | 1.0E+14 | - | - | - | 500 | 30 |
| Example 15 | | 350 | 30 | Sb ion | 300 | 180 | 1.0E+14 | - | - | - | 500 | 30 |
| Example 16 | | 350 | 30 | - | - | - | - | BF₃ | 600 | 30 | 500 | 30 |
| Example 17 | | 350 | 30 | - | - | - | - | PH₃ | 600 | 30 | 500 | 30 |
| Example 18 | | 350 | 30 | - | - | - | - | AlCl₃ | 600 | 30 | 500 | 30 |
| Example 19 | | 350 | 30 | - | - | - | - | N₂O | 600 | 30 | 500 | 30 |

**[Table 3-3]**

| | Composition | Step of removing pattern | | | | Pattern removability |
|---|---|---|---|---|---|---|
| | | Composition of hydrofluoric acid-based removing solution [wt%] | | Immersion temperature [°C] | Immersion time [s] | |
| | | HF | H₂O | | | |
| Example 9 | 3 | 30.0 | 70.0 | 23 | 300 | No remaining film |
| Example 10 | | 30.0 | 70.0 | 23 | 300 | No remaining film |
| Example 11 | | 30.0 | 70.0 | 23 | 300 | No remaining film |
| Example 12 | | 30.0 | 70.0 | 23 | 180 | No remaining film |
| Example 13 | | 30.0 | 70.0 | 23 | 300 | No remaining film |
| Example 14 | | 30.0 | 70.0 | 23 | 300 | No remaining film |
| Example 15 | | 30.0 | 70.0 | 23 | 300 | No remaining film |
| Example 16 | | 30.0 | 70.0 | 23 | 300 | No remaining film |
| Example 17 | | 30.0 | 70.0 | 23 | 300 | No remaining film |
| Example 18 | | 30.0 | 70.0 | 23 | 300 | No remaining film |
| Example 19 | | 30.0 | 70.0 | 23 | 300 | No remaining film |

**[Table 4-1]**

| | Composition | Composition [parts by weight] | | | | | | Inorganic particle content in entire solid [wt%] | Photosensitive properties Cured film properties | | |
|---|---|---|---|---|---|---|---|---|---|---|---|
| | | Polysiloxane | Compound having naphthoquinone -diazide structure | Photopolymerization initiator | Photoacid generator | Adhesiveness improver | Solvent | | Sensitivity [mJ/cm²] | Resolution [µm] | 450°C Thermal curing cracking resistant film thickness [µm] |
| Example 20 | 3 | A-3 (100) | QD-1 (9) | - | - | KBM-04 (5) | DAA PGMEA | 30.7 | 40 | 2.0 | 1.45 |
| Example 21 | | | | - | - | | | | | | |
| Example 22 | | | | - | - | | | | | | |
| Example 23 | 4 | A-4 (100) | | - | - | | | 30.7 | 40 | 3.0 | 1.80 |
| Example 24 | 5 | A-3 (100) | - | - | - | | | 33.3 | - | - | 1.45 |
| Example 25 | 6 | A-5 (100) | QD-1 (9) | - | - | | | 30.7 | 40 | 3.0 | 1.00 |
| Example 26 | 7 | A-6 (100) | | - | - | | | 30.7 | 40 | 3.0 | 0.80 |
| Example 27 | 8 | A-7 (100) | - | OXE-01 (5) | - | KBM-903 (2) | DAA PGMEA MB | 32.7 | 80 | 10.0 | 1.35 |
| Example 28 | 9 | | - | - | PAI-101 (5) | | | 32.7 | 80 | 10.0 | 1.35 |

**[Table 4-2]**

| | Composition | Step of thermally curing pattern | | Step of forming ion impurity regions | | | | Step of firing pattern | |
|---|---|---|---|---|---|---|---|---|---|
| | | | | Ion implantation step | | | | | |
| | | Thermally curing temperature [°C] | Thermally curing time [min] | Ion species | Ion implantation temperature [°C] | Accelerating energy [keV] | Ion dose amount [cm⁻²] | Firing temperature [°C] | Firing time [min] |
| Example 20 | 3 | 350 | 30 | Al ion | 23 | 180 | 1.0E+14 | 500 | 30 |
| Example 21 | | 350 | 30 | Al ion | 100 | 180 | 1.0E+14 | 500 | 30 |
| Example 22 | | 350 | 30 | Al ion | 200 | 180 | 1.0E+14 | 500 | 30 |
| Example 23 | 4 | 450 | 30 | Al ion | 400 | 180 | 1.0E+14 | 500 | 30 |
| Example 24 | 5 | 350 | 30 | Al ion | 300 | 180 | 1.0E+14 | 500 | 30 |
| Example 25 | 6 | 350 | 30 | Al ion | 300 | 180 | 1.0E+14 | 500 | 30 |
| Example 26 | 7 | 350 | 30 | Al ion | 300 | 180 | 1.0E+14 | 500 | 30 |
| Example 27 | 8 | 250 | 30 | Al ion | 200 | 180 | 1.0E+14 | 500 | 30 |
| Example 28 | 9 | 250 | 30 | Al ion | 200 | 180 | 1.0E+14 | 500 | 30 |

**[Table 4-3]**

| | Composition | Step of removing pattern | | | | Pattern removability |
|---|---|---|---|---|---|---|
| | | Composition of hydrofluoric acid-based removing solution [wt%] | | Immersion temperature [°C] | Immersion time [s] | |
| | | HF | H₂O | | | |
| Example 20 | 3 | 30.0 | 70.0 | 23 | 300 | No remaining film |
| Example 21 | | 30.0 | 70.0 | 23 | 300 | No remaining film |
| Example 22 | | 30.0 | 70.0 | 23 | 300 | No remaining film |
| Example 23 | 4 | 30.0 | 70.0 | 23 | 300 | No remaining film |
| Example 24 | 5 | 30.0 | 70.0 | 23 | 300 | No remaining film |
| Example 25 | 6 | 30.0 | 70.0 | 23 | 300 | No remaining film |
| Example 26 | 7 | 30.0 | 70.0 | 23 | 300 | No remaining film |
| Example 27 | 8 | 30.0 | 70.0 | 23 | 300 | No remaining film |
| Example 28 | 9 | 30.0 | 70.0 | 23 | 300 | No remaining film |

**[Table 5-1]**

| | Composition | Composition [parts by weight] | | | | Inorganic particle content in entire solid [wt%] | Photosensitive properties Cured film properties | | |
|---|---|---|---|---|---|---|---|---|---|
| | | Polysiloxane | Compound having naphthoquinone -diazide structure | Adhesiveness improver | Solvent | | Sensitivity [mJ/cm²] | Resolution [µm] | 450°C Thermal curing cracking resistant film thickness [µm] |
| Example 29 | 3 | A-3 (100) | QD-1 (9) | KBM-04 (5) | DAA PGMEA | 30.7 | 40 | 2.0 | 1.45 |
| Example 30 | | | | | | | | | |
| Example 31 | | | | | | | | | |
| Example 32 | | | | | | | | | |
| Example 33 | | | | | | | | | |
| Example 34 | | | | | | | | | |
| Example 35 | | | | | | | | | |
| Example 36 | | | | | | | | | |
| Example 37 | | | | | | | | | |
| Example 38 | | | | | | | | | |
| Example 39 | | | | | | | | | |

**[Table 5-2]**

| | Composition | Step of thermally curing pattern | | Step of forming ion impurity regions | | | | Step of firing pattern | |
|---|---|---|---|---|---|---|---|---|---|
| | | | | Ion implantation step | | | | | |
| | | Thermally curing temperature [°C] | Thermally curing time [min] | Ion species | Ion implantating temperature [°C] | Accelerating energy [keV] | Ion dose amount [cm⁻²] | Firing temperature [°C] | Firing time [min] |
| Example 29 | 3 | 350 | 30 | Al ion | 300 | 180 | 1.0E+14 | 500 | 30 |
| Example 30 | | 350 | 30 | Al ion | 300 | 180 | 1.0E+14 | 500 | 30 |
| Example 31 | | 350 | 30 | Al ion | 300 | 180 | 1.0E+14 | 500 | 30 |
| Example 32 | | 350 | 30 | Al ion | 300 | 180 | 1.0E+14 | 500 | 30 |
| Example 33 | | 350 | 30 | Al ion | 300 | 180 | 1.0E+14 | 500 | 30 |
| Example 34 | | 350 | 30 | Al ion | 300 | 180 | 1.0E+14 | 500 | 30 |
| Example 35 | | 350 | 30 | Al ion | 300 | 180 | 1.0E+14 | 500 | 30 |
| Example 36 | | 350 | 30 | Al ion | 300 | 180 | 1.0E+14 | 500 | 30 |
| Example 37 | | 350 | 30 | Al ion | 300 | 180 | 1.0E+14 | 500 | 30 |
| Example 38 | | 350 | 30 | Al ion | 300 | 180 | 1.0E+14 | 500 | 30 |
| Example 39 | | 350 | 30 | Al ion | 300 | 180 | 1.0E+14 | 500 | 30 |

**[Table 5-3]**

| | Composition | Step of removing pattern | | | | | | Pattern removability |
|---|---|---|---|---|---|---|---|---|
| | | Composition of hydrofluoric acid-based removing solution [wt%] | | | | Immersion temperature [°C] | Immersion time [s] | |
| | | HF | HNO₃ | H₂SO₄ | H₂O | | | |
| Example 29 | 3 | 50.0 | - | - | 50.0 | 23 | 180 | No remaining film |
| Example 30 | | 20.0 | - | - | 80.0 | 23 | 480 | No remaining film |
| Example 31 | | 15.0 | - | - | 85.0 | 23 | 540 | No remaining film |
| Example 32 | | 10.0 | - | - | 90.0 | 23 | 600 | No remaining film |
| Example 33 | | 4.0 | - | - | 90.0 | 23 | 1500 | No remaining film |
| Example 34 | | 22.6 | 38.4 | - | 39.0 | 23 | 180 | No remaining film |
| Example 35 | | 13.2 | 11.3 | - | 75.5 | 23 | 360 | No remaining film |
| Example 36 | | 32.6 | - | 33.4 | 34.0 | 23 | 180 | No remaining film |
| Example 37 | | 11.3 | - | 11.5 | 77.2 | 23 | 360 | No remaining film |
| Example 38 | | 21.3 | 24.2 | 21.9 | 32.6 | 23 | 120 | No remaining film |
| Example 39 | | 12.3 | 13.9 | 12.5 | 61.3 | 23 | 300 | No remaining film |

**[Table 6-1]**

| | Composition | Composition [parts by weight] | | | | Inorganic particle content in entire solid [wt%] | Photosensitive properties Cured film properties | | |
|---|---|---|---|---|---|---|---|---|---|
| | | Polysiloxane | Compound having naphthoquinone -diazide structure | Adhesiveness improver | Solvent | | Sensitivity [mJ/cm²] | Resolution [µm] | 450°C Thermal curing cracking resistant film thickness [µm] |
| Example 40 | 3 | A-3 (100) | QD-1 (9) | KBM-04 (5) | DAA PGMEA | 30.7 | 40 | 2.0 | 1.45 |
| Example 41 | | | | | | | | | |
| Example 42 | | | | | | | | | |
| Example 43 | | | | | | | | | |
| Example 44 | | | | | | | | | |
| Example 45 | | | | | | | | | |
| Example 46 | | | | | | | | | |
| Example 47 | | | | | | | | | |
| Example 48 | | | | | | | | | |
| Example 49 | | | | | | | | | |
| Example 50 | | | | | | | | | |

**[Table 6-2]**

| | Composition | Step of thermally curing pattern | | Step of forming ion impurity regions | | | | Step of firing pattern | |
|---|---|---|---|---|---|---|---|---|---|
| | | | | Ion implantation step | | | | | |
| | | Thermally curing temperature [°C] | Thermally curing time [min] | Ion species | Ion implantation temperature [°C] | Accelerating energy [keV] | Ion dose amount [cm⁻²] | Firing temperature [°C] | Firing time [min] |
| Example 40 | 3 | 350 | 30 | Al ion | 300 | 180 | 1.0E+14 | 500 | 30 |
| Example 41 | | 350 | 30 | Al ion | 300 | 180 | 1.0E+14 | 500 | 30 |
| Example 42 | | 350 | 30 | Al ion | 300 | 180 | 1.0E+14 | 500 | 30 |
| Example 43 | | 350 | 30 | Al ion | 300 | 180 | 1.0E+14 | 500 | 30 |
| Example 44 | | 350 | 30 | Al ion | 300 | 180 | 1.0E+14 | 500 | 30 |
| Example 45 | | 350 | 30 | Al ion | 300 | 180 | 1.0E+14 | 500 | 30 |
| Example 46 | | 350 | 30 | Al ion | 300 | 180 | 1.0E+14 | 500 | 30 |
| Example 47 | | 350 | 30 | Al ion | 300 | 180 | 1.0E+14 | 500 | 30 |
| Example 48 | | 350 | 30 | Al ion | 300 | 180 | 1.0E+14 | 500 | 30 |
| Example 49 | | 350 | 30 | Al ion | 300 | 180 | 1.0E+14 | 500 | 30 |
| Example 50 | | 350 | 30 | Al ion | 300 | 180 | 1.0E+14 | 500 | 30 |

**[Table 6-3]**

| | Composition | Step of removing pattern | | | | Step of cleaning substrate | | | | | | | | | | | | Pattern removaiblity |
|---|---|---|---|---|---|---|---|---|---|---|---|---|---|---|---|---|---|---|
| | | Composition of hydrofluoric acid-based removing solution [wt%] | | Immersion temperature [°C] | Immersion time [s] | (A) Ultraviolet treatment step | | | | (B) Plasma treatment step | | | | (C) Specific chemical liquid treatment step | | | | |
| | | HF | H₂O | | | Gas | Ultraviolet-ray wavelength [nm] | Treatment temperature [°C] | Treatment time [s] | Gas | RF electric power [W] | Treatment temperature [°C] | Treatment time [s] | Specific chemical liquid | Immersion temperature [°C] | Immersion time [s] | Ultrasonic wave frequency [kHz] | |
| Example 40 | | 30.0 | 70.0 | 23 | 90 | O₂ | 185 | 23 | 120 | - | - | - | - | - | - | - | - | No remaining film |
| | | | | | | | 254 | | | | | | | | | | | |
| Example 41 | | 30.0 | 70.0 | 23 | 90 | O₂ | 185 | 23 | 120 | - | - | - | - | - | - | - | - | No remaining film |
| | | | | | | | 254 | | | | | | | | | | | |
| Example 42 | | 30.0 | 70.0 | 23 | 90 | O₂ | 185 | 100 | 60 | - | - | - | - | - | - | - | - | No remaining film |
| | | | | | | | 254 | | | | | | | | | | | |
| Example 43 | | 30.0 | 70.0 | 23 | 90 | - | - | - | - | CF₄ | 1200 | 23 | 120 | - | - | - | - | No remaining film |
| Example 44 | | 30.0 | 70.0 | 23 | 90 | - | - | - | - | O₂ | 1200 | 23 | 120 | - | - | - | - | No remaining film |
| Example 45 | 3 | 30.0 | 70.0 | 23 | 90 | - | - | - | - | O₇ | 1200 | 100 | 60 | - | - | - | - | No remaining film |
| Example 46 | | 30.0 | 70.0 | 23 | 90 | - | - | - | - | - | - | - | - | 2.38 wt% TMAH | 23 | 120 | - | No remaining film |
| Example 47 | | 30.0 | 70.0 | 23 | so | - | - | - | - | - | - | - | - | NMP | 23 | 120 | - | No remaining film |
| Example 48 | | 30.0 | 70.0 | 23 | 90 | - | - | - | - | - | - | - | - | 96 wt% H₂SO₄ | 23 | 120 | - | No remaining film |
| Example 49 | | 30.0 | 70.0 | 23 | 90 | - | - | - | - | - | - | - | - | 96 wt% H₂SO₄ /30 wt% H₂O₂ =4/1 (v/v) | 120 | 60 | - | No remaining film |
| Example 50 | | 30.0 | 70.0 | 23 | 90 | - | - | - | - | - | - | - | - | NMP | 23 | 60 | 39 | No remaining film |

**[Table 7-1]**

| | Composition | Composition [parts by weight] | | | | | | | Inorganic particle content in entire solid [wt%] | Photosensitive properties Cured film properties | | |
|---|---|---|---|---|---|---|---|---|---|---|---|---|
| | | Polysiloxane | Compound having naphthoquinone diazide structure | Photopolymerization initiator | Photoacid generator | Radical polymerizable compound | Adhesiveness improver | Solvent | | Sensitivity [mJ/cm²] | Resolution [µm] | 450°C Thermal curing cracking resistant film thickness [µm] |
| Comparative Example 1 | 1 | A-1 (100) | QD-1 (9) | - | - | - | KBM-04 (5) | DAA PGMEA | - | 30 | 2.0 | 1.35 |
| Comparative Example 2 | 2 | A-2 (100) | | - | - | - | | | - | 30 | 2.0 | 1.35 |
| Comparative Example 3 | 3 | A-3 (100) | | - | - | - | | | 30.7 | 40 | 2.0 | 1.45 |
| Comparative Example 4 | 4 | A-4 (100) | | - | - | - | | | 30.7 | 40 | 3.0 | 1.80 |
| Comparative Example 5 | 5 | A-3 (100) | - | - | - | - | | | 33.3 | - | - | 1.45 |
| Comparative Example 6 | 6 | A-5 (100) | QD-1 (9) | - | - | - | | | 30.7 | 40 | 3.0 | 1.00 |
| Comparative Example 7 | 7 | A-6 (100) | | - | - | | | | 30.7 | 40 | 3.0 | 0.80 |
| Comparative Example 8 | 8 | A-7 (65) | - | OXE-01 (5) | - | DPHA (20) | KBM-903 (2) | DAA PGMEA MB | 32.7 | 80 | 10.0 | 1.35 |
| Comparative Example 9 | 9 | | - | - | PAI-101 (5) | | | | 32.7 | 80 | 10.0 | 1.35 |
| Comparative Example 10 | 3 | A-3 (100) | QD-1 (9) | - | - | - | KBM-04 (5) | DAA PGMEA | 30.7 | 40 | 2.0 | 1.45 |

**[Table 7-2]**

| | Composition | Step of thermally curing pattern | | Step of forming ion impurity regions | | | | Step of firing pattern | |
|---|---|---|---|---|---|---|---|---|---|
| | | | | Ion implantation step | | | | | |
| | | Thermally curing temperature [°C] | Thermally curing time [min] | ion species | Ion implantation temperature [°C] | Accelerating energy [keV] | Ion dose amount [cm⁻²] | Firing temperature [°C] | Firing time [min] |
| Comparative Example 1 | 1 | 350 | 30 | Al ion | 300 | 180 | 1.0E+14 | - | - |
| Comparative Example 2 | 2 | 350 | 30 | Al ion | 300 | 180 | 1.0E+14 | - | - |
| Comparative Example 3 | 3 | 350 | 30 | Al ion | 300 | 180 | 1.0E+14 | - | - |
| Comparative Example 4 | 4 | 450 | 30 | Al ion | 400 | 180 | 1.0E+14 | - | - |
| Comparative Example 5 | 5 | 350 | 30 | Al ion | 300 | 180 | 1.0E+14 | - | - |
| Comparative Example 6 | 6 | 350 | 30 | Al ion | 300 | 180 | 1.0E+14 | - | - |
| Comparative Example 7 | 7 | 350 | 30 | Al ion | 300 | 180 | 1.0E+14 | - | - |
| Comparative Example 8 | 8 | 250 | 30 | Al ion | 200 | 180 | 1.0E+14 | - | - |
| Comparative Example 9 | 9 | 250 | 30 | Al ion | 200 | 180 | 1.0E+14 | - | - |
| Comparative Example 10 | 3 | 350 | 30 | Al ion | 300 | 180 | 1.0E+14 | 250 | 120 |

**[Table 7-3]**

| | Composition | Step of removing pattern | | | | Pattern removaiblity |
|---|---|---|---|---|---|---|
| | | Composition of hydrofluoric acid-based removing solution [wt%] | | Immersion temperature [°C] | Immersion time [s] | |
| | | HF | H₂O | | | |
| Comparative Example 1 | 1 | 30.0 | 70.0 | 23 | 600 | With remaining film |
| Comparative Example 2 | 2 | 30.0 | 70.0 | 23 | 600 | With remaining film |
| Comparative Example 3 | 3 | 30.0 | 70.0 | 23 | 600 | With remaining film |
| Comparative Example 4 | 4 | 30.0 | 70.0 | 23 | 600 | With remaining film |
| Comparative Example 5 | 5 | 30.0 | 70.0 | 23 | 600 | With remaining film |
| Comparative Example 6 | 6 | 30.0 | 70.0 | 23 | 600 | With remaining film |
| Comparative Example 7 | 7 | 30.0 | 70.0 | 23 | 600 | With remaining film |
| Comparative Example 8 | 8 | 30.0 | 70.0 | 23 | 600 | With remaining film |
| Comparative Example 9 | 9 | 30.0 | 70.0 | 23 | 600 | With remaining film |
| Comparative Example 10 | 3 | 30.0 | 70.0 | 23 | 600 | With remaining film |

### DESCRIPTION OF REFERENCE SIGNS

1: Silicon semiconductor substrate
2: Polysiloxane film
2a: Polysiloxane pattern
3: Mask
4: Active chemical ray
5: Ions
6: Impurity region
7: Denatured layer
8: Silicon semiconductor substrate
8a: Silicon semiconductor substrate
8b: Silicon semiconductor substrate
9: Polysiloxane film
9a: Polysiloxane pattern
10: Mask
11: Active chemical ray
12: Pattern
13a: Polysiloxane pattern
14: Ions
15: Impurity region
16: Denatured layer

## Claims

1. A method for manufacturing a semiconductor device, comprising:
a step of yielding a pattern of a polysiloxane-containing composition over a substrate; and
a step of forming an ion impurity region in the substrate, wherein
after the step of forming a ion impurity region, the method further comprises a step of firing the pattern at a temperature of 300 to 1,500°C and wherein
after the step of firing the pattern, the method further comprises a step of removing the pattern.

2. The method for manufacturing a semiconductor device according to claim 1, wherein the step of removing the pattern is a step of removing the pattern with a solution containing 10 to 99% by weight of hydrofluoric acid.

3. The method for manufacturing a semiconductor device according to claim 1 or 2, further comprising, after the step of removing the pattern, at least one of:
(A) a step of cleaning the substrate by ultraviolet treatment;
(B) a step of cleaning the substrate by plasma treatment; and
(C) a step of cleaning the substrate with a chemical liquid containing at least one selected from the group consisting of an alkaline solution, an organic solvent, an acidic solution and an oxidant.

4. The method for manufacturing a semiconductor device according to any one of claims 1 to 3, wherein the pattern includes a line pattern and/or a dot pattern, and at least one of a dimension width of the line and a dimension width of the dot is from 0.01 to 5 µm.

5. The method for manufacturing a semiconductor device according to any one of claims 1 to 4, wherein an element included in the ion impurity region is at least one selected from the group consisting of boron, aluminum, gallium, indium, nitrogen, phosphorus, arsenic, and antimony.

6. The method for manufacturing a semiconductor device according to any one of claims 1 to 5, wherein a temperature for the step of forming the ion impurity region is from 200 to 1,500°C.

7. The method for manufacturing a semiconductor device according to any one of claims 1 to 6, wherein the polysiloxane contains an organosilane unit represented by the general formula (1), (2) or (3) : 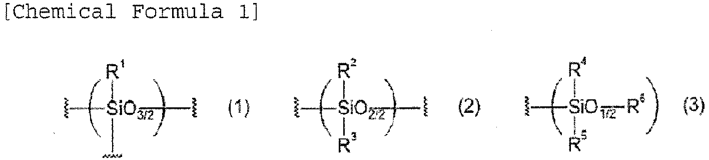 wherein in the general formula (1), R¹ each independently represents hydrogen, or an alkyl, cycloalkyl, alkenyl or aryl group; in the general formula (2), R² and R³ each independently represent hydrogen, or an alkyl, cycloalkyl, alkenyl or aryl group; and in the general formula (3), R⁴ to R⁶ each independently represent hydrogen, or an alkyl, cycloalkyl, alkenyl or aryl group.

8. The method for manufacturing a semiconductor device according to claim 7, wherein a content by percentage of the organosilane unit represented by the general formula (1), (2) or (3) in the polysiloxane is from 60 to 100 mol% in terms of a content by mole of Si atoms.

## Patentansprüche

1. Verfahren zum Herstellen einer Halbleitervorrichtung umfassend:
einen Schritt des Erzeugens eines Musters einer Polysiloxan-haltigen Zusammensetzung auf einem Substrat; und
einen Schritt des Bildens eines ionenverunreinigten Bereiches in dem Substrat, wobei nach dem Schritt des Bildens eines ionenverunreinigten Bereiches, das Verfahren ferner einen Schritt des Brennens des Musters bei einer Temperatur von 300 bis 1500 °C umfasst und wobei
nach dem Schritt des Brennens des Musters, das Verfahren fermer einen Schritt des Entfernens des Musters umfasst.

2. Verfahren zum Herstellen einer Halbleitervorrichtung nach Anspruch 1, wobei der Schritt des Entfernens des Musters ein Schritt zum Entfernen des Musters mit einer Lösung umfassend 10 bis 99 Gew.-% einer Flusssäure ist.

3. Verfahren zum Herstellen einer Halbleitervorrichtung nach Anspruch 1 oder 2 ferner umfassend, nach dem Schritt des Entfernens des Musters, mindestens einen eines:
(A) Schrittes des Reinigens des Substrates durch eine Ultraviolettbehandlung;
(B) Schrittes des Reinigens des Substrates durch eine Plasmabehandlung; und
(C) Schrittes des Reinigens des Substrates mit einer chemischen Flüssigkeit umfassend mindestens eine ausgewählt aus der Gruppe bestehend aus einer alkalischen Lösung, einem organischen Lösungsmittel und einer sauren Lösung und eines Oxidationsmittels.

4. Verfahren zum Herstellen einer Halbleitervorrichtung nach einem der Ansprüche 1 bis 3, wobei das Muster ein Linienmuster und/oder ein Punktemuster umfasst, und mindestens eine einer Dimensionsbereite der Linie und einer Dimensionsbreite des Punktes 0,01 bis 5 µm beträgt.

5. Verfahren zum Herstellen einer Halbleitervorrichtung nach einem der Ansprüche 1 bis 4, wobei ein Element, welches in dem ionenverunreinigten Bereich enthalten ist, ist mindestens eines Ausgewählt aus der Gruppe bestehend aus Bor, Aluminium, Gallium, Indium, Stickstoff, Phosphor, Arsen und Antimon.

6. Verfahren zum Herstellen einer Halbleitervorrichtung nach einem der Ansprüche 1 bis 5, wobei eine Temperatur des Schrittes des Bildens des ionenverunreinigten Bereiches 200 bis 1500 °C beträgt.

7. Verfahren zum Herstellen einer Halbleitervorrichtung nach einem der Ansprüche 1 bis 6, wobei das Polysiloxan eine Organosilaneinheit, welche durch die allgemeine Formel (1), (2) oder (3) dargestellt ist, enthält: 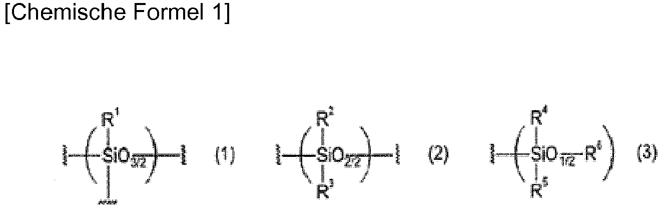 wobei in der allgemeinen Formel (1), R¹ jeweils unabhängig Wasserstoff, oder ein Alkyl, ein Cycloalkyl, ein Alkenyl oder eine Arylgruppe darstellt; in der allgemeinen Formel (2), R² und R³ jeweils unabhängig Wasserstoff, oder ein Alkyl, ein Cycloalkyl, ein Alkenyl oder eine Arylgruppe darstellen; und, in der allgemeinen Formel (3), R⁴ bis R⁶ jeweils unabhängig Wasserstoff, oder ein Alkyl, ein Cycloalkyl, ein Alkenyl oder eine Arylgruppe darstellen.

8. Verfahren zum Herstellen einer Halbleitervorrichtung nach Anspruch 7, wobei ein prozentualer Gehalt der Organosilaneinheit, welche durch die allgemeine Formel (1), (2) oder (3) dargestellt ist, in dem Polysiloxan 60 bis 100 mol% im Hinblick auf einen molaren Gehalt der Silicumatome beträgt.

## Revendications

1. Procédé de fabrication d'un dispositif à semi-conducteur, comprenant :
une étape de production d'un motif d'une composition contenant du polysiloxane sur un substrat ; et
une étape de formation d'une région d'impureté ionique dans le substrat, dans lequel
après l'étape de formation d'une région d'impureté ionique, le procédé comprend en outre une étape de chauffage du motif à une température allant de 300 à 1500°C et où
après l'étape de chauffage du motif, le procédé comprend en outre une étape d'élimination du motif.

2. Procédé de fabrication d'un dispositif à semi-conducteur selon la revendication 1, dans lequel l'étape d'élimination du motif est une étape consistant à éliminer le motif avec une solution contenant 10 à 99% en poids d'acide fluorhydrique.

3. Procédé de fabrication d'un dispositif à semi-conducteur selon la revendication 1 ou 2, comprenant en outre, après l'étape d'élimination du motif, au moins l'une parmi :
(A) une étape de nettoyage du substrat par un traitement aux ultraviolets ;
(B) une étape de nettoyage du substrat par un traitement au plasma ; et
(C) une étape de nettoyage du substrat avec un liquide chimique contenant au moins un élément choisi dans le groupe constitué d'une solution alcaline, d'un solvant organique, d'une solution acide et d'un oxydant.

4. Procédé de fabrication d'un dispositif à semi-conducteur selon l'une quelconque des revendications 1 à 3, dans lequel le motif comporte un motif de ligne et/ou un motif de points, et au moins l'une d'une dimension en largeur de la ligne et d'une dimension en largeur du point varie de 0,01 à 5 µm.

5. Procédé de fabrication d'un dispositif à semi-conducteur selon l'une quelconque des revendications 1 à 4, dans lequel un élément inclus dans la région d'impureté ionique est au moins un élément choisi dans le groupe constitué de bore, d'aluminium, de gallium, d'indium, d'azote, de phosphore, d'arsenic, et d'antimoine.

6. Procédé de fabrication d'un dispositif à semi-conducteur selon l'une quelconque des revendications 1 à 5, dans lequel une température de l'étape de formation de la région d'impureté ionique est comprise entre 200 et 1500°C.

7. Procédé de fabrication d'un dispositif à semi-conducteur selon l'une quelconque des revendications 1 à 6, dans lequel le polysiloxane contient une unité organosilane représentée par la formule générale (1), (2) ou (3) : 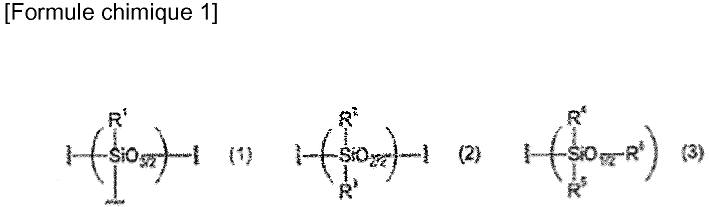 où dans la formule générale (1), R¹ représente chacun indépendamment un atome d'hydrogène, ou un groupe alkyle, cycloalkyle, alcényle ou aryle ; dans la formule générale (2), R² et R³ représentent chacun indépendamment un atome d'hydrogène, ou un groupe alkyle, cycloalkyle, alcényle ou aryle ; et dans la formule générale (3), R⁴ à R⁶ représentent chacun indépendamment un atome d'hydrogène, ou un groupe alkyle, cycloalkyle, alcényle ou aryle.

8. Procédé de fabrication d'un dispositif à semi-conducteur selon la revendication 7, dans lequel une teneur par pourcentage de l'unité organosilane représentée par la formule générale (1), (2) ou (3) dans le polysiloxane est comprise entre 60 et 100% en mole en termes de teneur par mole d'atomes de Si.
